# EUROPÄISCHE PATENTANMELDUNG

(11) **EP 4 621 465 A2**
(43) Veröffentlichungstag der Anmeldung: **24.09.2025**
(21) Anmeldenummer: 25194795.8
(22) Anmeldetag: 13.12.2022
(51) Int. Cl.: G02B 7/195

(54) **VERFAHREN ZUM ERZEUGEN MINDESTENS EINER HOHLSTRUKTUR, SPIEGEL UND EUV-LITHOGRAPHIESYSTEM**

(30) Priorität: 14.12.2021 DE 102021214310; 14.12.2021 DE 102021214318; 08.04.2022 DE 102022203593
(62) Teilanmeldung aus: 22835015.3
(71) Anmelder: Carl Zeiss SMT GmbH, 73447 Oberkochen (DE)
(72) Erfinder: ULLSPERGER, Tobias, 99085 Erfurt (DE); NOLTE, Stefan, 07751 Jena (DE); GLEASON, Cristian, 70197 Stuttgart (DE); KNORR, Soeren, 73430 Aalen (DE); MONZ, Thomas, 73278 Schlierbach (DE); XALTER, Stefan, 73447 Oberkochen (DE); KLASNA, Michael, 83043 Bad Aibling (DE); ZACZEK, Christoph, 73540 Heubach (DE)
(74) Vertreter: Kohler Schmid Möbus Patentanwälte

(57) **Zusammenfassung**

Die Erfindung betrifft ein Verfahren zum Erzeugen einer Hohlstruktur (28) in einem Werkstück (25) in Form eines Substrats für einen Spiegel, insbesondere für einen EUV-Spiegel (M4), durch materialabtragende Bearbeitung mittels gepulster Laserstrahlung (35), umfassend: Einstrahlen der gepulsten Laserstrahlung (35) von einer Strahlungseintrittsseite (27) in das Werkstück (25), das aus einem für die gepulste Laserstrahlung (35) transparenten Material gebildet ist, Fokussieren der gepulsten Laserstrahlung (35) in einem Fokusbereich (39), Bilden einer Abtragsfront (46) zum flächigen Abtrag von Material des Werkstücks (25) durch Bewegen des Fokusbereichs (39) entlang eines Bewegungsmusters (41), sowie Erzeugen der Hohlstruktur (28) durch Bewegen der Abtragsfront (46) innerhalb des Werkstücks (25), wobei beim Erzeugen der Hohlstruktur (28) zumindest zeitweise eine Abtragsfront (46) gebildet wird, die nicht senkrecht zu einer Einstrahlungsrichtung (Z) der gepulsten Laserstrahlung (35) auf die Strahlungseintrittsseite (27) des Werkstücks (25) ausgerichtet ist, und wobei die Hohlstruktur in Form eines mit einem Fluid durchströmbaren Kanals erzeugt wird. Die Erfindung betrifft auch einen Spiegel, insbesondere einen EUV-Spiegel, und ein EUV-Lithographiesystem.

## Beschreibung

### Hintergrund der Erfindung

Die Erfindung betrifft ein Verfahren zum Erzeugen mindestens einer Hohlstruktur in einem Werkstück, bevorzugt in Form eines Substrats für einen Spiegel, insbesondere für einen EUV-Spiegel, durch materialabtragende Bearbeitung mittels gepulster Laserstrahlung, umfassend: Einstrahlen der gepulsten Laserstrahlung von einer Strahlungseintrittsseite in das Werkstück, das aus einem für die gepulste Laserstrahlung transparenten Material gebildet ist, Fokussieren der gepulsten Laserstrahlung in einem Fokusbereich, Bilden einer Abtragsfront zum flächigen Abtrag von Material des Werkstücks durch Bewegen des Fokusbereichs entlang eines Bewegungsmusters, sowie Erzeugen der Hohlstruktur durch Bewegen der Abtragsfront innerhalb des Werkstücks. Die Erfindung betrifft auch ein Verfahren zum Erzeugen einer Hohlstruktur in Form eines Kanals in einem Werkstück, bevorzugt in Form eines Substrats für einen Spiegel, insbesondere für einen EUV-Spiegel. Die Erfindung betrifft auch einen Spiegel, insbesondere einen EUV-Spiegel, sowie ein EUV-Lithographiesystem mit mindestens einem solchen EUV-Spiegel.

Die Erfindung betrifft zudem eine Vorrichtung zum Erzeugen mindestens einer Hohlstruktur, insbesondere mindestens eines Kanals, in einem Werkstück, bevorzugt in Form eines Substrats für einen Spiegel, insbesondere für einen EUV-Spiegel, umfassend: eine Laserquelle zur Erzeugung von gepulster Laserstrahlung, eine Halterung zur Aufnahme des Werkstücks, eine Fokussiereinrichtung zur Fokussierung der Laserstrahlung in einem Fokusbereich, eine Scanneroptik, die zur Einstrahlung der gepulsten Laserstrahlung auf eine Strahleintrittsseite des von der Halterung aufgenommenen Werkstücks und zum Bewegen des Fokusbereichs ausgebildet ist.

Die Erfindung betrifft auch eine Fluidzuführungsvorrichtung zum Zuführen eines Fluids zu mindestens einer Abtragsfront beim Abtragen von Material durch Laserablation, insbesondere durch Multi-Photonen-Laserablation, von einem Werkstück, bevorzugt von einem insbesondere monolithischen Substrat für einen EUV-Spiegel. Die Erfindung betrifft auch ein Verfahren zum Zuführen eines Fluids zu mindestens einer Abtragsfront.

Unter einem EUV-Lithographiesystem wird im Sinne dieser Anmeldung ein optisches System verstanden, das auf dem Gebiet der EUV-Lithographie eingesetzt werden kann. Neben einer Projektionsbelichtungsanlage für die EUV-Lithographie, die zur Herstellung von Halbleiterbauelementen dient, kann es sich bei dem Lithographiesystem beispielsweise um ein Inspektionssystem zur Inspektion einer in einer solchen Projektionsbelichtungsanlage verwendeten Photomaske, im Folgenden auch Retikel genannt, zur Inspektion eines zu strukturierenden Halbleitersubstrats, im Folgenden auch Wafer genannt, oder um ein Metrologiesystem handeln, das zur Vermessung einer Projektionsbelichtungsanlage für die EUV-Lithographie oder von Teilen davon, beispielsweise zur Vermessung einer Projektionsoptik, eingesetzt wird.

Um für die herzustellenden Halbleiterbauelemente eine möglichst kleine Strukturbreite zu erzielen, sind neuere Projektionsbelichtungsanlagen, so genannte EUV-Lithographieanlagen, für eine Arbeitswellenlänge im extrem ultravioletten Wellenlängenbereich, auch EUV-Wellenlängenbereich genannt, d.h. in einem Bereich von ca. 5 nm bis ca. 30 nm, ausgelegt. Aufgrund der kurzwelligen Strahlung kommen zur Strahlführung und Fokussierung beschichtete Spiegel, sogenannte EUV-Spiegel, zum Einsatz, die ein Substrat aus einem Material mit einem sehr geringen Wärmeausdehnungskoeffizienten aufweisen. Bei dem Material des Substrats kann es sich beispielsweise um titandotiertes Quarzglas mit einem sehr geringen Wärmeausdehnungskoeffizienten handeln. Die Produktivität bei der Herstellung der belichteten Wafer hängt stark von der Leistung der EUV-Lichtquelle ab, die zur Erzeugung der EUV-Strahlung dient. Eine hohe Leistung der auf die EUV-Spiegel auftreffenden Strahlung führt jedoch zu einer erhöhten thermischen Belastung der EUV-Spiegel. Trotz des extrem geringen Wärmeausdehnungskoeffizienten führt die in das Substrat eingebrachte Wärmeleistung zu Formabweichungen der hochpräzisen Spiegel-Oberflächen. Um dem Bedarf der wachsenden Produktivität und dadurch immer leistungsstärkeren EUV-Lichtquellen gerecht zu werden, kann eine aktive Kühlung der EUV-Spiegel vorgesehen werden.

Eine effiziente Methode ist eine volumetrische Kühlung in Form von internen Kanälen, die mit einer Flüssigkeit, z.B. mit Wasser, durchflossen werden, um die Kühlung des Substrats zu bewirken, weshalb diese Kanäle nachfolgend auch als Kühlkanäle bezeichnet werden. Ein Kanal, der mit einer Flüssigkeit durchströmbar ist, bildet einen langgestreckten, in Umfangsrichtung geschlossenen Hohlraum, der keine Verzweigungen aufweist und der sich zwischen einem ersten Ende des Kanals und einem zweiten Ende des Kanals erstreckt. Der Kanal kann an einem oder an beiden Enden in weitere Hohlstrukturen münden, die im Volumen des Substrats liegen. Es ist auch möglich, dass eine oder beide Enden des Kanals an der Außenseite des Substrats münden. Eine Herausforderung besteht hierbei in der Realisierung von Hohlstrukturen in Form von Kühlkanälen im Volumen des Substrats, die einen vergleichsweise großen Durchmesser von in der Regel mehr als ca. 1 mm aufweisen und die in einem geringen Abstand von typischerweise nicht mehr als ca. 10 mm unterhalb der Oberfläche des Substrats verlaufen, an der die reflektierende Beschichtung zur Reflexion der EUV-Strahlung aufgebracht ist.

Für die Zu- und Abführung der Kühlflüssigkeit ist es typischerweise erforderlich, den im Wesentlichen parallel zu der mit der EUV-Strahlung bestrahlten Oberfläche des Spiegels ausgerichteten Kühlkanal mit abgewinkelten Vor- und Rücklaufkanälen auszustatten, die beispielsweise mit der Rückseite des Substrats verbunden sein können.

Ein Ansatz zum Erzeugen von Hohlstrukturen besteht in der Materialbearbeitung durch Laserstrahlung. Hierbei wird das Werkstückmaterial durch entsprechend hohe Pulsintensitäten geschädigt. Für Laserstrahlung mit Wellenlängen im sichtbaren bis nahen Infrarotbereich sind herkömmliche Gläser wie Kieselglas, Borosilikatglas oder auch titandotiertes Quarzglas transparent.

### Aufgabe der Erfindung

Eine Aufgabe der Erfindung ist es, ein Verfahren und eine Vorrichtung bereitzustellen, welche die Erzeugung von Hohlstrukturen mit komplexer, insbesondere gekrümmter und/oder abgewinkelter Geometrie in einem Werkstück, bevorzugt in einem Substrat für einen Spiegel, insbesondere für einen EUV-Spiegel, ermöglichen. Eine weitere Aufgabe der Erfindung ist es, einen Spiegel, insbesondere einen EUV-Spiegel, und eine EUV-Lithographieanlage mit einer solchen Hohlstruktur bereitzustellen. Eine weitere Aufgabe der Erfindung ist es, einen Spiegel, insbesondere einen EUV-Spiegel, bereitzustellen, bei dem strömungsinduzierte Vibrationen beim Durchströmen der Hohlstruktur mit einem Fluid reduziert werden. Eine weitere Aufgabe der Erfindung ist es, eine Fluidzuführungsvorrichtung und ein Verfahren bereitzustellen, die es auch bei der Herstellung von komplexen Hohlstrukturen ermöglichen, mindestens einer Abtragsfront ein Fluid zuzuführen.

### Gegenstand der Erfindung

Die Aufgabe wird bei einem ersten Aspekt der Erfindung gelöst durch ein Verfahren der eingangs genannten Art, bei dem zum Erzeugen der Hohlstruktur zumindest zeitweise eine Abtragsfront gebildet wird, die nicht senkrecht zu einer Einstrahlungsrichtung der gepulsten Laserstrahlung auf eine Strahlungseintrittsseite des Werkstücks ausgerichtet ist, wobei die Hohlstruktur bevorzugt in Form eines mit einem Fluid, insbesondere mit einem Kühlfluid, durchströmbaren Kanals erzeugt wird. Bei dem Fluid kann es sich um ein Temperiermedium handeln, das zum Heizen oder zum Kühlen verwendet wird. In der Regel handelt es sich bei dem Fluid um eine Flüssigkeit, es kann sich aber auch um ein Gas handeln.

In der vorliegenden Anmeldung wird der Begriff "Abtragsfront" synonym mit dem Begriff "Ablationsfront" verwendet. An der Abtragsfront findet der Abtrag des Materials des Werkstücks statt. Die Abtragsfront bildet eine Grenzfläche zwischen dem Material des Werkstücks und dem bereits gebildeten Teil der Hohlstruktur. An die Abtragsfront, genauer gesagt an eine Randkontur der Abtragsfront, schließt sich die Mantelfläche des bereits gebildeten Teils der Hohlstruktur an.

Die Erfinder haben erkannt, dass es zur Erzeugung von Hohlstrukturen mit Hinterschneidungen, z.B. mit gekrümmter oder abgewinkelter Geometrie, günstig ist, zumindest zeitweise die Abtragsfront nicht senkrecht zur Einstrahlungsrichtung der gepulsten Laserstrahlung auf die Strahlungseintrittsseite des Werkstücks auszurichten, sondern vielmehr die Abtragsfront zu verkippen und unter einem von 90° verschiedenen Winkel, d.h. unter einem Winkel zwischen 0° und 89°, zur Einstrahlungsrichtung auszurichten.

Die verkippte Abtragsfront verläuft in der Regel in einer Ebene, die zur Einstrahlungsrichtung verkippt ist, grundsätzlich ist es aber auch möglich, dass die Abtragsfront nicht plan ist und von einer ebenen Geometrie abweicht. In diesem Fall wird unter dem Winkel, unter dem die Abtragsfront zur Einstrahlungsrichtung der gepulsten Laserstrahlung ausgerichtet ist, der Winkel zu einer äquivalenten Ebene der Abtragsfront verstanden. Bei der äquivalenten Ebene handelt es sich um diejenige Ebene, die einen möglichst geringen Abstand zu allen Punkten der Abtragsfront aufweist. Die äquivalente Ebene wird durch die gewöhnliche Methode der kleinsten Quadrate ("ordinary least squares", OLS) bestimmt. Die Abtragsfront kann insbesondere nur geringfügig von einer planen bzw. ebenen Geometrie abweichen und die ebene Geometrie z.B. in Form von kleinen, gestuften Abschnitten annähern.

Unter der Einstrahlungsrichtung wird die Richtung verstanden, mit der die gepulste Laserstrahlung auf die Strahlungseintrittsseite auftrifft. Bei der gepulsten Laserstrahlung, die an eine jeweilige Fokusposition fokussiert wird, handelt es sich typischerweise um einen Laserstrahl, dessen Propagationsrichtung der Einstrahlungsrichtung entspricht. Für den Fall, dass die gepulste Laserstrahlung nicht senkrecht auf die Strahlungseintrittsseite des Werkstücks eingestrahlt wird, unterscheidet sich aufgrund der Brechung die Propagationsrichtung der gepulsten Laserstrahlung im Material des Werkstücks von der Einstrahlungsrichtung auf das Werkstück.

Die Einstrahlungsrichtung der gepulsten Laserstrahlung auf die Strahlungseintrittsseite des Werkstücks ist bei der Bildung der Abtragsfront in der Regel konstant. Für den Fall, dass bei der Bildung der Abtragsfront die Einstrahlungsrichtung der gepulsten Laserstrahlung variiert, wird unter der Einstrahlungsrichtung der arithmetische Mittelwert der Einstrahlungsrichtungen auf die Strahlungseintrittsseite an allen Fokuspositionen entlang der Bewegungsbahnen des Bewegungsmusters verstanden.

In der Regel verläuft die Dickenrichtung des Werkstücks im Wesentlichen parallel zur Einstrahlungsrichtung der gepulsten Laserstrahlung auf das Werkstück. Die Dickenrichtung entspricht der Normalenrichtung der Strahlungseintrittsseite an der Position, an der die gepulste Laserstrahlung durch die Strahlungseintrittsseite hindurchtritt. Die Strahlungseintrittsseite, durch welche die gepulste Laserstrahlung in das Werkstück eintritt, kann eine annähernd plane Fläche sein, die im Wesentlichen senkrecht zur Einstrahlungsrichtung ausgerichtet ist. Es ist aber auch möglich, dass die Strahlungseintrittsseite eine gekrümmte Fläche bildet, beispielsweise eine sphärisch gekrümmte Fläche, eine asphärisch gekrümmte Fläche oder eine Freiformfläche. Zur Bildung einer gekrümmten Spiegelfläche kann die beispielsweise plane Strahlungseintrittsseite aber auch nach dem Erzeugen der Hohlstruktur bzw. der Hohlstrukturen mechanisch oder auf andere Weise bearbeitet werden. Es ist auch möglich, dass die gepulste Laserstrahlung nicht senkrecht auf die Strahlungseintrittsseite auftrifft.

Für den Fall, dass eine Hohlstruktur mit einer Hinterschneidung gebildet werden soll, kann zumindest während des Herstellens der Hinterschneidung die Abtragsfront unter einem von 90° verschiedenen Winkel, d.h. unter einem Winkel zwischen 0° und 89°, zur Einstrahlungsrichtung ausgerichtet werden. Beispielsweise ist eine solche Ausrichtung günstig, wenn ein Abschnitt der Hohlstruktur gebildet werden soll, dessen Längsachse im Wesentlichen parallel zur Strahleintrittsseite verläuft. Es ist selbstverständlich auch möglich, während der Herstellung der gesamten Hohlstruktur die Abtragsfront unter einem von 90° verschiedenen, konstanten oder ggf. in Abhängigkeit von der Position der Abtragsfront innerhalb des Werkstücks variierenden Winkel zur Einstrahlungsrichtung auszurichten. Die Variation des Winkels der Abtragsfront sollte kontinuierlich und langsam erfolgen, d.h. der Differenzwinkel von zwei unmittelbar aufeinanderfolgend gebildeten Abtragsfronten sollte sich nur geringfügig voneinander unterscheiden.

Der Abtrag von Material des Werkstücks wird typischerweise durch Multi-Photonen-Absorption der eingestrahlten Laserstrahlung hervorgerufen, weshalb der Abtragsprozess auch als Multi-Photonen-Laserablation bezeichnet wird. Die Multi-Photonen-Absorption kann im Material des Werkstücks erfolgen und/oder in einem Fluid, typischerweise einer Flüssigkeit, die bei Abtragen von Material mit der Abtragsfront in Kontakt gebracht wird, wie dies weiter unten näher beschrieben ist. Auch andere chemische und/oder physikalische Prozesse können einen Materialabtrag bewirken. Die Parameter der eingestrahlten Laserstrahlung können an den jeweiligen Prozess angepasst bzw. für den jeweiligen Prozess optimiert werden, der den Abtrag des Materials bewirken soll.

Bevorzugt wird die Hohlstruktur in Form eines mit einem Fluid, insbesondere mit einem Kühlfluid, durchströmbaren gekrümmten Kanals erzeugt. Wie weiter oben beschrieben wurde, können mittels des weiter oben beschriebenen Verfahrens insbesondere mit Hinterschneidungen versehene Hohlstrukturen, beispielsweise in Form von gekrümmten Kanälen erzeugt werden, die mit einem Fluid durchströmbar sind.

Bei einer Variante tritt die gepulste Laserstrahlung im Bereich der Abtragsfront erstmalig aus dem Material des Werkstücks aus. Bei dieser Variante propagiert die gepulste Laserstrahlung zwischen der Strahlungseintrittsseite des Werkstücks und der Abtragsfront innerhalb des Materials des Werkstücks, d.h. zwischen der Strahlungseintrittsseite und der Abtragsfront befindet sich kein Hohlraum.

Bei einer Weiterbildung dieser Variante tritt die gepulste Laserstrahlung nach dem Austritt aus dem Material des Werkstücks erneut in das Material des Werkstücks ein. Dies ist typischerweise der Fall, wenn ein Abschnitt der Hohlstruktur gebildet werden soll, der nicht parallel zur Einstrahlungsrichtung verläuft. In diesem Fall ist an einer der Strahlungseintrittsfläche in Einstrahlungsrichtung der gepulsten Laserstrahlung abgewandten Seite der Abtragsfront Material des Werkstücks vorhanden, auf das ein Anteil der gepulsten Laserstrahlung trifft, der in dem jeweiligen Fokusbereich nicht vollständig vom Material des Werkstücks absorbiert wurde.

Bei einer weiteren Variante wird die Abtragsfront innerhalb des Werkstücks zumindest zeitweise in Richtung auf die Strahlungseintrittsseite des Werkstücks bewegt. Die Bewegung der Abtragsfront in Richtung auf die Strahlungseintrittsseite des Werkstücks kann parallel zur Einstrahlungsrichtung erfolgen, wenn ein Abschnitt der Hohlstruktur gebildet wird, der parallel zur Einstrahlungsrichtung verläuft. Es ist aber auch möglich, dass der Bewegung der Abtragsfront in Richtung auf die Strahlungseintrittsseite eine Bewegung in einer dazu senkrechten Richtung überlagert ist, beispielsweise wenn ein schräger oder gekrümmter Abschnitt der Hohlstruktur gebildet wird.

Bei einer weiteren Variante grenzt beim Bewegen der Abtragsfront innerhalb des Werkstücks zumindest zeitweise an einer der Strahlungseintrittsseite des Werkstücks abgewandten Seite eines der Strahlungseintrittsseite des Werkstücks abgewandten Randes der Abtragsfront Material des Werkstücks an. Wie weiter oben beschrieben wurde, ist dies typischerweise der Fall, wenn ein Abschnitt der Hohlstruktur gebildet werden soll, der nicht parallel zur Einstrahlungsrichtung verläuft.

Bei einer weiteren Variante wird die Abtragsfront ausgehend von einer der Strahlungseintrittsseite gegenüberliegenden Seite des Werkstücks bewegt. Bei der Seite des Werkstücks, die der Strahlungseintrittsseite gegenüberliegt und von der die Abtragsfront ausgeht, kann es sich um die Rückseite des Werkstücks handeln, die in der Regel im Wesentlichen parallel zur Strahleintrittsseite ausgerichtet ist. Bei der Seite des Werkstücks, von der die Abtragsfront ausgeht, kann es sich aber auch um eine Fläche handeln, die sich innerhalb des Volumens des Werkstücks befindet. Dies kann beispielsweise der Fall sein, wenn bereits eine Hohlstruktur in dem Werkstück vorhanden ist und die mit dem Verfahren erzeugte Hohlstruktur von der bereits erzeugten Hohlstruktur ausgeht. Die Hohlstruktur, die bereits in dem Volumen des Werkstücks vorhanden ist, kann mit dem hier beschriebenen Verfahren erzeugt werden, es ist aber grundsätzlich auch möglich, dass diese Hohlstruktur mit einem anderen materialabtragenden Verfahren erzeugt wird, z.B. durch ein mechanisch abrasives Verfahren.

Bei einer Variante wird zumindest zeitweise eine Abtragsfront gebildet, die unter einem Winkel zwischen 0° und 89°, bevorzugt zwischen 0° und 80°, besonders bevorzugt zwischen 20° und 70°, insbesondere zwischen 30° und 60° zur Einstrahlungsrichtung ausgerichtet ist. Wie weiter oben beschrieben wurde, verhindert oder verringert eine solche Ausrichtung der Abtragsfront das Einbringen von Materialmodifikationen in einen Volumenbereich des Werkstücks, der sich unterhalb der Abtragsfront befindet und reduziert daher die beim Erzeugen der Hohlstruktur in das Werkstückmaterial eingebrachten Verspannungen deutlich.

Bei einer weiteren Variante erfolgt das Bewegen des Fokusbereichs entlang von zueinander versetzten Bewegungsbahnen des Bewegungsmusters. Bei dem hier beschriebenen Verfahren sind die Bewegungsbahnen des Bewegungsmusters bevorzugt parallel zueinander ausgerichtet und verlaufen geradlinig. Der Abstand zwischen benachbarten Bewegungsbahnen kann beispielsweise zwischen ca. 0,01 mm und 0,5 mm liegen. Eine solche Ausrichtung ist aber nicht zwingend erforderlich, d.h. die Bewegungsbahnen des Bewegungsmusters können ggf. auch in Form von konzentrischen Konturen, z.B. in Form von konzentrischen Kreisen, oder auf andere Weise ausgerichtet sein. Die Querschnittsgeometrie des Bewegungsmusters bzw. dessen Projektion in eine Ebene senkreicht zur Bewegungsrichtung der Abtragsfront entspricht der Querschnittsgeometrie der Hohlstruktur. Die Querschnittsgeometrie der Hohlstruktur ist grundsätzlich beliebig und kann z.B. kreisförmig, elliptisch, polygonal, etc. sein. Auch der Durchmesser des Querschnitts der Hohlstruktur kann bei der Bewegung der Abtragsfront in gewissen Grenzen verändert werden, indem die räumliche Ausdehnung des Bewegungsmusters abhängig von der Position der Abtragsfront innerhalb des Werkstücks verändert wird.

Bei einer Variante werden zum Bilden der nicht senkrecht zur Einstrahlungsrichtung ausgerichteten Abtragsfront die Bewegungsbahnen des Bewegungsmusters in bzw. entlang der Einstrahlungsrichtung zueinander versetzt, indem der Fokusbereich in positiver oder negativer Einstrahlungsrichtung bzw. entlang der Einstrahlungsrichtung versetzt wird. Bei dieser Variante verlaufen die Bewegungsbahnen des Bewegungsmusters typischerweise geradlinig und sind parallel zueinander ausgerichtet. Die einzelnen Bewegungsbahnen des Bewegungsmusters werden bei der hier beschriebenen Variante entlang der Einstrahlungsrichtung zueinander versetzt, um eine in Bezug auf die Einstrahlungsrichtung schräge Abtragsfront zu erzeugen. Unter einer Bewegung in einer Richtung, z.B. in Z-Richtung, wird eine Bewegung entlang bzw. parallel zu der jeweiligen Richtung verstanden, wobei das Vorzeichen der Richtung (+Z, -Z) nicht berücksichtigt wird.

Im einfachsten Fall wird bei dieser Variante ausgehend von einer Bewegungsbahn an einem seitlichen Rand des Bewegungsmusters bei jeder weiteren, benachbarten Bewegungsbahn der Fokusbereich um einen konstanten Betrag in Einstrahlungsrichtung versetzt. Für das Versetzen des Fokusbereichs in Einstrahlungsrichtung kann beispielsweise ein dynamisches Zoom-Objektiv verwendet werden.

Bei dieser Variante wird die verkippte Abtragsfront durch ein schnelles Abrastern bzw. Scannen des Bewegungsmusters in Kombination mit einem Versatz des Fokusbereichs in Einstrahlungsrichtung mittels einer Scanneroptik mit dynamischem Zoom-Objektiv gebildet. Zur Bewegung der Abtragsfront innerhalb des Werkstücks wird der Scanbewegung typischerweise eine im Vergleich zur Scanbewegung langsame Bewegung des Werkstücks überlagert.

Alternativ kann die Abtragsfront bewegt werden, indem bei ortsfestem Werkstück die Lage des Bewegungsmusters innerhalb des Scanfeldes der Scanneroptik verändert wird. Es ist möglich, zur Erzeugung eines ersten Abschnitts einer Hohlstruktur die Lage der Abtragsfront durch eine Bewegung des Werkstücks zu verändern und zur Erzeugung eines zweiten Abschnitts der Hohlstruktur die Abtragsfront in dem Werkstück zu bewegen, indem die Position des Bewegungsmusters innerhalb des Scanfeldes verändert wird.

Bei einer weiteren Variante wird zum Bilden der nicht senkrecht zur Einstrahlungsrichtung ausgerichteten Abtragsfront die Pulsenergie der gepulsten Laserstrahlung bei den zueinander versetzten Bewegungsbahnen des Bewegungsmusters verändert, wobei bevorzugt der Fokusbereich in einer Ebene senkrecht zur Einstrahlungsrichtung bewegt wird. Alternativ oder zusätzlich zur Erzeugung eines Versatzes des Fokusbereichs in Einstrahlungsrichtung kann auch die Pulsenergie der gepulsten Laserstrahlung bei den zueinander versetzten Bewegungsbahnen verändert werden. Typischerweise wird die Pulsenergie hierbei ausgehend von einer Bewegungsbahn an einem ersten seitlichen Rand des Bewegungsmusters zu einer Bewegungsbahn an einem zweiten, gegenüberliegenden Rand des Bewegungsmusters sukzessive erhöht oder reduziert. Eine schnelle Anpassung der Pulsenergie kann z.B. mit Hilfe von akusto-optischen oder elektro-optischen Modulatoren erreicht werden, die auf eine Laserquelle zur Erzeugung der gepulsten Laserstrahlung einwirken und Ansprechzeiten in der Größenordnung von weniger als 1 µs aufweisen.

In der Regel wird die hier beschriebene Variante des Verfahrens nicht mit dem Versatz des Fokusbereichs in Einstrahlungsrichtung kombiniert, sodass auf eine Einrichtung zur dynamischen Anpassung der Fokuslage verzichtet werden kann. Die gepulste Laserstrahlung bzw. der Fokusbereich wird bei der Erzeugung des Ablationsmusters daher in einer Fokusebene fokussiert und in der Fokusebene bewegt. Um beim Abrastern der Bewegungsbahnen mit Hilfe der Scanneroptik die Fokussierung in der gepulsten Laserstrahlung in einer Fokusebene zu realisieren, kann ein F-Theta-Objektiv oder ein telezentrisches Objektiv verwendet werden. Zu Beginn des Ablationsprozesses kann die gepulste Laserstrahlung in diesem Fall beispielsweise auf eine Fokusebene fokussiert werden, die sich an der Rückseite des Werkstücks befindet.

Auch wenn die Fokussierung der gepulsten Laserstrahlung in eine Fokusebene senkrecht zur Einstrahlungsrichtung erfolgt, kann durch die Veränderung der Pulsenergie zwischen den einzelnen Bewegungsbahnen eine schräge Abtragsfront gebildet werden, weil der Einflussbereich der Laserpulse sich verändert: In Abhängigkeit von der Wellenlänge und der Pulsdauer der Laserpulse wird eine bestimmte Schwell-Energiedichte oder alternativ eine bestimmte Schwell-Intensität benötigt, um den Abtrag des Werkstückmaterials zu erzeugen. Je größer die Pulsenergie ist, desto größer ist auch die Ausdehnung des Bereichs in Einstrahlungsrichtung, in dem ausgehend von dem Fokusbereich bzw. der Fokusebene ein Abtrag von Material stattfindet. Durch eine schnelle Anpassung der Pulsenergie kann daher ausgehend von der der Strahleintrittsseite abgewandten Seite des Werkstücks eine Abtragsfront gebildet werden, die unter einem von 0° verschiedenen Winkel zur Fokusebene ausgerichtet ist, in welcher der Fokusbereich bewegt wird. Durch eine Bewegung des Werkstücks kann auch in diesem Fall die Abtragsfront innerhalb des Werkstücks bewegt werden, um die Hohlstruktur zu erzeugen. Auf diese Weise kann eine schräge Abtragsfront erzeugt werden, ohne dass zu diesem Zweck zusätzliche bewegliche Elemente wie z.B. Stellmotoren in einer Zoom-Optik benötigt werden.

Bei einer Variante wird beim Erzeugen der Hohlstruktur die Abtragsfront zumindest zeitweise in einer Bewegungsrichtung quer zur Einstrahlungsrichtung innerhalb des Werkstücks bewegt, um einen Abschnitt der Hohlstruktur zu bilden, der bevorzugt im Wesentlichen parallel zur Strahlungseintrittsseite verläuft, wobei die Abtragsfront bei der Bewegung quer zur Einstrahlungsrichtung bevorzugt an ihrem der Strahlungseintrittsseite zugewandten Seite unter einem Winkel von weniger als 90°, bevorzugt von weniger als 70°, zur Bewegungsrichtung ausgerichtet ist. Unter dem Begriff "im Wesentlichen parallel" wird im Sinne dieser Anmeldung eine parallele Ausrichtung oder eine Ausrichtung unter einem Winkel von +/-10° zu einer parallelen Ausrichtung verstanden.

Das weiter oben beschriebene Verfahren kann insbesondere dazu verwendet werden, um einen "horizontalen" Abschnitt einer Hohlstruktur zu bilden, d.h. einen Abschnitt, der im Wesentlichen parallel zur Strahlungseintrittsseite des Werkstücks verläuft. Bei einem Werkstück in Form eines Substrats für einen EUV-Spiegel ist ein solcher Abschnitt in der Regel in einem geringen Abstand von der Strahlungseintrittsseite angeordnet, die in diesem Fall der optischen Oberfläche entspricht, auf welche nach dem Erzeugen der Hohlstruktur die reflektierende Beschichtung aufgebracht wird. Durch den "horizontalen" Abschnitt kann eine effiziente Temperierung der optischen Oberfläche des EUV-Spiegels realisiert werden.

Bei einer weiteren Variante wird die Abtragsfront beim Erzeugen der Hohlstruktur zumindest zeitweise im Wesentlichen parallel zur Einstrahlungsrichtung bewegt, um ausgehend von der der Strahlungseintrittsseite gegenüberliegenden Seite des Werkstücks einen Abschnitt der Hohlstruktur zu erzeugen, der im Wesentlichen parallel zur Einstrahlungsrichtung verläuft, sowie bevorzugt um einen weiteren Abschnitt der Hohlstruktur zu erzeugen, der im Wesentlichen parallel zur Einstrahlungsrichtung verläuft. Für die Ausbildung einer durchgehenden Hohlstruktur, beispielsweise in Form eines Durchgangskanals, der nach der Herstellung der Hohlstruktur mit einem Fluid zur Temperierung, insbesondere zur Kühlung, des Werkstücks bzw. des Substrats durchströmbar ist, ist es in der Regel erforderlich, den weiter oben beschriebenen "horizontalen" Abschnitt der Hohlstruktur mit der der Strahlungseintrittsseite abgewandten Seite des Werkstücks oder mit einer anderen Seite des Werkstücks zu verbinden. Zu diesem Zweck kann ausgehend von dem der Strahlungseintrittsseite abgewandten Seite des Werkstücks ein "vertikaler" Kanal-Abschnitt der Hohlstruktur erzeugt werden, der in den "horizontalen" Kanal-Abschnitt der Hohlstruktur übergeht.

Bei der Erzeugung der durchgehenden Hohlstruktur kann in einem ersten Prozessschritt ein erster "vertikaler" Abschnitt und nur ein Teil des "horizontalen" Abschnitts der Holstruktur erzeugt werden, d.h. es wird eine Hohlstruktur erzeugt, die an einer Abtragsfront innerhalb des "horizontalen" Abschnitts endet. Für die Erzeugung der durchgehenden Hohlstruktur wird in einem zweiten Prozessschritt ein zweiter "vertikaler" Kanal-Abschnitt der Hohlstruktur erzeugt, der von einer anderen Position an der der Strahlungseintrittsseite abgewandten Seite des Werkstücks ausgeht, die um die Länge des "horizontalen" Abschnitts zu der Position versetzt ist, von der der bereits hergestellte erste "vertikale" Abschnitt der Hohlstruktur ausgeht.

Die Abtragsfront beim zweiten Prozessschritt entspricht der an der Einstrahlungsrichtung gespiegelten Abtragsfront beim ersten Prozessschritt. Der zweite "vertikale" Abschnitt wird in einen weiteren Teil des "horizontalen" Abschnitts der Hohlstruktur überführt, der auf derselben Höhe in Einstrahlungsrichtung wie der bereits gebildete Teil des "horizontalen" Abschnitts verläuft. Die beiden Enden der "horizontalen" Abschnitte der Hohlstruktur werden durch fortlaufende Prozessierung in einem Überlappungsbereich miteinander verbunden. Auf diese Weise wird die Hohlstruktur durchgängig geöffnet und bildet einen durchgehenden Kanal, dem über einen Fluideinlass an einem Ersten Ende ein Kühlfluid zugeführt werden kann, das an einem Fluidauslass am anderen Ende wieder aus der Hohlstruktur abgeführt werden kann. In dem Überlappungsbereich wird ein Nahtbereich gebildet. Innerhalb des Nahtbereichs unterscheidet sich die Beschaffenheit des Kanals, insbesondere der Wand des Kanals, von der Beschaffenheit des Kanals, insbesondere der Wand des Kanals, außerhalb des Nahtbereichs, wie weiter unten näher beschrieben wird.

Bei einer weiteren Variante werden ein erster Abschnitt der Hohlstruktur und ein zweiter, angrenzender Abschnitt der Hohlstruktur erzeugt, deren Längsrichtungen unter einem Winkel zwischen 70° und 100°, bevorzugt unter einem Winkel von 90°, zueinander ausgerichtet sind. Wie weiter oben beschreiben wurde, ist bei dem hier beschriebenen Verfahren die Erzeugung von Hohlstrukturen mit Hinterschneidungen möglich. Beispielsweise kann mit Hilfe des hier beschriebenen Verfahrens eine Hohlstruktur in Form eines gekrümmten Kühlkanals erzeugt werden. Insbesondere ist es möglich, eine Hohlstruktur zu erzeugen, die eine 90°-Krümmung aufweist, d.h. die eine Richtungsänderung von ca. 90° zwischen benachbarten Abschnitten. Dies ist beispielsweise günstig, um den weiter oben beschriebenen Übergang zwischen dem "vertikalen" Abschnitt der Hohlstruktur und dem "horizontalen" Abschnitt der Hohlstruktur zu bilden. Es versteht sich aber, dass der hier beschriebene Übergang in der Art einer Krümmung um ca. 90° nicht zwingend zwischen einem "horizontalen" und einem "vertikalen" Abschnitt der Hohlstruktur erfolgen muss.

Bei einer Variante wird beim Erzeugen der Hohlstruktur ein abgerundeter Abschnitt gebildet, an dem der erste Abschnitt und der zweite Abschnitt ineinander übergehen. Es hat sich als günstig erwiesen, wenn bei der Krümmung von ca. 90° zwischen den beiden aneinander angrenzenden Abschnitten kein diskontinuierlicher Übergang in Form eines Knicks erzeugt wird, sondern wenn der Übergang kontinuierlich entlang eines abgerundeten Abschnitts der Hohlstruktur erfolgt. Der abgerundete Abschnitt weist in der Regel einen konstanten Krümmungsradius auf, dies ist aber nicht zwingend erforderlich, d.h. der Krümmungsradius kann variieren. Der abgerundete Abschnitt vereinfacht das Nachführen eines flexiblen Schlauchs, um der Abtragsfront bzw. der Hohlstruktur ein Flussmittel zuzuführen, welches Abtragsprodukte effektiv aus dem Bereich der Abtragsfront entfernt, wie weiter unten näher beschrieben wird.

Bei einer weiteren Variante wird die Abtragsfront beim Erzeugen der Hohlstruktur in Kontakt mit einem Fluid gebracht, wobei bei der Bewegung der Abtragsfront das Fluid der Abtragsfront mittels einer Fluidzuführung nachgeführt wird, die zumindest teilweise in die Hohlstruktur eingeführt wird. Es ist typischerweise erforderlich, den Fokusbereich mit einer insbesondere für die gepulste Laserstrahlung transparenten Flüssigkeit zu spülen, um die Ablationsprodukte abzutransportieren sowie um das Werkstück zu kühlen. Die Flüssigkeit kann in Form eines freien Flüssigkeitsstrahls mit Hilfe einer Düse auf die Rückseite des Werkstücks geführt werden oder das Werkstück kann teilweise in ein Flüssigkeitsbad eingetaucht werden. Anstelle einer Flüssigkeit kann aber auch ein Gas, beispielsweise Druckluft, mit der Abtragsfront in Kontakt gebracht werden, um die Ablationsprodukte abzutransportieren.

Für den Fall, dass die Hohlstruktur, z.B. in Form eines Kanals, eine große Länge aufweist, ist es erforderlich, dass die Fluidzuführung zumindest teilweise in die Hohlstruktur eingeführt wird, um eine lokale Spülung im Bereich der Abtragsfront zu ermöglichen. Zu diesem Zweck kann die Fluidzuführung bzw. ein Teil der Fluidzuführung, z.B. eine Düse, zumindest teilweise in die Hohlstruktur eingeführt werden. Die Fluidzuführung kann beispielsweise in Form eines starren Rohrs ausgebildet sein bzw. ein starres Rohr aufweisen, an dessen freiem Ende eine Düse angebracht ist, wobei das Rohr bzw. die Düse zumindest teilweise in die Hohlstruktur eingeführt wird. Es ist aber auch möglich, dass die Fluidzuführung keine Düse aufweist. Die Fluidzuführung, beispielsweise in Form des Rohrs, weist einen Außendurchmesser auf, der etwas geringer ist als der Durchmesser der Hohlstruktur, damit das aus der Düse austretende Fluid in einem Zwischenraum zwischen dem Rohr und der Wandung der Hohlstruktur abtransportiert werden kann.

Bei einer Weiterbildung dieser Variante weist die Fluidzuführung mindestens einen flexiblen Schlauch auf bzw. die Fluidzuführung bildet mindestens einen flexiblen Schlauch und das Fluid wird der Abtragsfront mittels des mindestens einen flexiblen Schlauchs insbesondere ausgehend von einer der Strahlungseintrittsseite abgewandten Seite des Werkstücks nachgeführt.

Bei der Herstellung einer gekrümmten Hohlstruktur, die ggf. eine 90°-Krümmung bzw. eine 90°-Abbiegung aufweist, ist es zur effektiven Abführung der Abtragsprodukte erforderlich, wenn ein flexibler Schlauch in den bereits erzeugten Teil der Hohlstruktur eingeführt wird. Das freie Ende des Schlauchs, an dem typischerweise eine Düse angebracht ist, wird hierbei in einem vergleichsweise geringen Abstand zur Abtragsfront positioniert. Der Schlauch weist einen Durchmesser auf, der etwas geringer ist als der Durchmesser der Hohlstruktur, um zu gewährleisten, dass das aus der Düse austretende Fluid in einem Zwischenraum zwischen dem Schlauch und der Wandung der Hohlstruktur typischerweise in Richtung auf die Rückseite des Werkstücks abtransportiert werden kann.. Auch andere flexible Elemente, die ein freies Ende bzw. ein Endstück zum Austritt eines Fluids aufweisen, können der Abtragsfront nachgeführt werden.

Bei einer weiteren Variante wird zum Bewegen der Abtragsfront das Werkstück bewegt, insbesondere verschoben. Die Bewegung des Werkstücks kann z.B. in Form einer Verschiebung in einer, in zwei oder in drei Raumrichtungen erfolgen. Insbesondere wenn ein Übergang zwischen zwei unter ca. 90° zueinander ausgerichteten Abschnitten der Hohlstruktur erfolgen soll, ist es günstig, wenn das Werkstück in einer überlagerten Bewegung in zwei Raumrichtungen verschoben bzw. bewegt wird. Für die Erzeugung von Hohlstrukturen, deren Größe das Bearbeitungsfeld der Scanneroptik nicht überschreitet, kann die Bewegung der Abtragsfront innerhalb des Werkstücks auch durch eine Bewegung des Scanmusters innerhalb des Bearbeitungsfeldes realisiert werden, ohne dass hierbei das Werkstück bewegt wird. Auch in diesem Fall kann die Ausrichtung der Abtragsfront relativ zur Einstrahlungsrichtung bei der Erzeugung der Hohlstruktur verändert werden.

Bei einer weiteren Variante wird zum Bilden der Abtragsfront der Fokusbereich mittels einer Scanneroptik entlang von zueinander versetzten Bewegungsbahnen des Bewegungsmusters bewegt. Die Bewegung des Fokusbereichs zur Bildung der Abtragsfront erfolgt in diesem Fall durch eine schnelle Ablenkung der gepulsten Laserstrahlung mit Hilfe der Scanneroptik, die zu diesem Zweck beispielsweise einen oder mehrere Scanner-Spiegel z.B. in Form von Galvanometer-Spiegeln aufweisen kann. Für die Erzeugung der Hohlstruktur wird typischerweise die Scanbewegung zum Bilden der Abtragsfront mit der vergleichsweise langsamen Bewegung des Werkstücks überlagert. Um den Fokusbereich bei der Scanbewegung in einer Fokusebene zu fokussieren, ist es typischerweise erforderlich, dass die gepulste Laserstrahlung ein F-Theta-Objektiv oder ein telezentrisches Objektiv durchläuft. Bei der Erzeugung eines Versatzes des Fokusbereichs in Einstrahlungsrichtung zur Bildung der schrägen Abtragsfront wird in der Regel ebenfalls ein solches Objektiv in Kombination mit einem dynamischen Zoom-Objektiv verwendet. Ein F-Theta-Objektiv oder ein telezentrisches Objektiv wird in der Regel auch bei der Erzeugung einer schrägen Abtragsfront durch Veränderung der Pulsenergie der gepulsten Laserstrahlung verwendet.

Bei einer weiteren Variante weist die Hohlstruktur einen runden Querschnitt mit einem Durchmesser zwischen 1 mm und 20 mm, bevorzugt zwischen 1 mm und 5 mm, auf. Wie weiter oben beschrieben wurde, kann der Kanal einen Querschnitt aufweisen, der von einem runden Querschnitt abweicht. In diesem Fall wird unter dem Durchmesser des Kanals der sogenannte äquivalente Durchmesser verstanden, d.h. der Durchmesser eines Kreises, dessen Fläche dem in diesem Fall nicht kreisförmigen Strömungs-Querschnitt des Kanals entspricht. Für die Durchströmung mit einem Fluid haben sich Kanäle mit einem Durchmesser als günstig erwiesen, die in dem oben angegebenen Wertebereich liegen.

Bei einer weiteren Variante weist die Hohlstruktur eine Länge von mindestens 10 cm, bevorzugt von mindestens 15 cm, besonders bevorzugt von mindestens 20 cm, insbesondere von mindestens 70 cm auf. Wie weiter oben beschrieben wurde, können mit Hilfe des hier beschriebenen Verfahrens Hohlstrukturen in Form von insbesondere gekrümmten Kanälen mit erheblicher Länge hergestellt werden.

Die Erfindung betrifft auch ein Verfahren der eingangs genannten Art, das insbesondere auch eine oder mehrere der Varianten des weiter oben beschriebenen Verfahrens umfassen kann. Bei dem Verfahren wird die Hohlstruktur außerhalb der Abtragsfront durch eine Mantelfläche begrenzt, wobei die Abtragsfront beim Erzeugen der Hohlstruktur unter einem Abtragsfront-Winkel zu einem an die Abtragsfront angrenzenden Bereich der Mantelfläche der Hohlstruktur ausgerichtet ist, und wobei der Abtragsfront-Winkel wenigstens zeitweise größer als ein Abtragsfront-Mindestwinkel von 1° und wenigstens zeitweise kleiner als ein Abtragsfront-Maximalwinkel von 89° ist. Bevorzugt liegt der Abtragsfront-Mindestwinkel bei 5°, bei 10°, bei 20° oder bei 30°. Bevorzugt liegt der Abtragsfront-Maximalwinkel bei 85°, bei 80° bei 70° oder bei 60°. Der Abtragsfront-Winkel beim Erzeugen der Hohlstruktur kann permanent größer als der Abtragsfront-Mindestwinkel und/oder permanent kleiner als der Abtragsfront-Maximalwinkel sein, dies ist aber nicht zwingend erforderlich. Bei der Mantelfläche kann es sich beispielsweise um eine zylinderförmige Mantelfläche handeln, dies ist aber nicht zwingend erforderlich. Bei der Hohlstruktur kann es sich beispielsweise um einen bevorzugt mit einem Fluid durchströmbaren Kanal handeln.

Die Erfindung betrifft auch ein Verfahren zum Erzeugen eines insbesondere mit einem Fluid durchströmbaren Kanals in einem Werkstück in Form eines Substrats für einen Spiegel, insbesondere für einen EUV-Spiegel, wobei der Kanal durch materialabtragende Bearbeitung mittels gepulster Laserstrahlung erzeugt wird und wobei beim Erzeugen des Kanals eine Fluidzuführung zumindest teilweise in den Kanal eingeführt wird. Wie weiter oben beschrieben wurde, ist es bei der Herstellung eines Kanals, der eine vergleichsweise große Länge aufweist, erforderlich, eine Fluidzuführung zu verwenden, die zumindest teilweise in den Kanal eingeführt wird.

Bei einer Variante des Verfahrens wird in einem Bereich, in dem die materialabtragende Bearbeitung durchgeführt wird, insbesondere einer beim materialabtragenden Bearbeiten gebildeten Abtragsfront, mit Hilfe der Fluidzuführung ein Fluid zugeführt, wobei bevorzugt beim Bewegen der Abtragsfront in dem Werkstück die Fluidzuführung der Abtragsfront insbesondere automatisiert nachgeführt wird. Bei der materialabtragenden Bearbeitung mittels gepulster Laserstrahlung, die beispielsweise mittels des weiter oben beschriebenen Verfahrens durchgeführt werden kann, ist es für die Erzeugung langer Kanäle erforderlich, die Fluidzuführung der Abtragsfront nachzuführen, um die Abtragsfront zu kühlen sowie um die Ablationsprodukte abzutransportieren. Bei der Fluidzuführung kann es sich beispielsweise um ein Rohr oder dergleichen handeln, dessen freies Ende, an dem eine Düse angebracht sein kann, typischerweise in einem geringen Abstand zur Abtragsfront angeordnet wird. Die Nachführung des Fluid zu der Abtragsfront ist auch für den Fall erforderlich, dass ein geradliniger Kanal mit einer erheblichen Länge erzeugt wird. In diesem Fall kann auf die weiter oben beschriebene schräge Ausrichtung der Abtragsfront ggf. verzichtet werden. Die automatisierte Nachführung kann beispielsweise mit Hilfe der weiter unten beschriebenen Nachführungseinrichtung erfolgen.

Bei einer weiteren Variante weist die Fluidzuführung ein flexibles Element auf, das zumindest teilweise in den bevorzugt gekrümmten Kanal eingeführt wird, wobei das flexible Element bevorzugt einen flexiblen Schlauch bildet. Wie weiter oben beschrieben wurde, ermöglicht das Einführen eines flexiblen Elements, beispielsweise in Form einer flexiblen Fluidleitung in Form eines flexiblen Schlauchs, der Abtragsfront das Fluid auch dann nachzuführen, wenn der Kanal gekrümmt ist und Hinterschneidungen aufweist, beispielsweise in Form einer 90°-Umlenkung oder dergleichen.

Bei einer weiteren Variante wird der Kanal mit einer Länge von mindestens 10 cm, bevorzugt von mindestens 15 cm, besonders bevorzugt von mindestens 20 cm, insbesondere von mindestens 70 cm erzeugt. Wie weiter oben beschrieben wurde, ist das Nachführen der erforderlich, wenn ein Kanal mit einer vergleichsweise großen Länge erzeugt wird. Wie weiter oben beschrieben wurde, wird der Kanal durch materialabtragende Bearbeitung mittels gepulster Laserstrahlung erzeugt. Es ist möglich, dass an den Kanal Abschnitte angrenzen, die auf andere Weise erzeugt wurden, beispielsweise durch mechanische Bearbeitung, z.B. durch Bohren. Die Längen dieser Abschnitte bleiben bei der Bestimmung der Länge des Kanals unberücksichtigt.

Bei einer weiteren Variante ist das Substrat monolithisch. Um Verspannungen in dem Substratmaterial möglichst zu vermeiden, die beim Zusammenfügen von zwei oder mehr Teilkörpern zu einem Substrat auftreten, ist es günstig, wenn das Substrat des Spiegels, beispielsweise des EUV-Spiegels, monolithisch, d.h. einstückig, ausgebildet ist. Mit Hilfe des weiter oben beschriebenen Verfahrens können in einem solchen monolithischen Substrat Hohlstrukturen mit nahezu beliebiger Geometrie erzeugt werden. Bei der bzw. bei den Hohlstrukturen kann es sich insbesondere um Kühlkanäle handeln, d.h. um Hohlstrukturen, die den Durchfluss einer Kühlflüssigkeit, z.B. von Wasser, ermöglichen. Bei der Hohlstruktur kann es sich um einen durchgehenden Kühlkanal handeln, es ist aber auch möglich, dass die Hohlstruktur eine oder mehrere Verzweigungen aufweist. Ein Kühlmitteleinlass und ein Kühlmittelauslass für die Hohlstruktur können an der Rückseite des Substrats angeordnet sein, dies ist aber nicht zwingend erforderlich, insbesondere, wenn zur Erzeugung der gesamten Hohlstruktur bzw. von mehreren Hohlstrukturen zusätzlich andere materialabtragende Verfahren eingesetzt werden.

Bei einer Variante besteht das Substrat aus titandotiertem Quarzglas oder aus einer Glaskeramik. Wie weiter oben beschrieben wurde, besteht ein Substrat für einen EUV-Spiegel typischerweise aus einem sogenannten Nullausdehnungsmaterial, das einen extrem geringen Wärmeausdehnungskoeffizienten aufweist.

Grundsätzlich können auch in Werkstück-Materialien, die sich nicht für die Verwendung als Substrat für einen EUV-Spiegel eignen, auf die weiter oben beschriebene Weise Hohlstrukturen eingebracht werden. Bei den für das Verfahren geeigneten Werkstück-Klassen handelt es sich um Gläser, um Kristalle sowie um Halbleiter. Voraussetzung ist, dass das jeweilige Material für die eingestrahlte Laserstrahlung transparent ist. Bei Silizium ist dies beispielsweise bei Wellenlängen im nahen Infrarot-Wellenlängenbereich von mehr als ca. 1060 nm der Fall.

Bei einer weiteren Variante weist das Material des Substrats eine Nulldurchgangstemperatur auf, die zwischen 0°C und 100°C, bevorzugt zwischen 19°C und 40°C, besonders bevorzugt zwischen 19 °C und 32°C liegt. Nullausdehnungsmaterialien, z.B. in Form von dotiertem Quarzglas, insbesondere in Form von titandotiertem Quarzglas, oder in Form von bestimmten Glaskeramiken spielen Komponenten bzw. Phasen mit positivem und negativem Wärmeausdehnungskoeffizienten gegeneinander aus. Das Ergebnis ist ein effektiv nichtlinearer Zusammenhang zwischen Wärmeausdehnung und Temperatur, wobei es genau einen Temperaturwert gibt, bei dem die Wärmeausdehnung verschwindet bzw. am unempfindlichsten gegen Temperaturänderungen ist, und zwar die sogenannte Nulldurchgangstemperatur, die auch als "zero crossing temperature", ZCT, bezeichnet wird.

Bei einer Variante weist das Material des Substrats eine räumliche Variation der Nulldurchgangstemperatur auf, die bei weniger als 3 K, bevorzugt bei weniger als 2 K, besonders bevorzugt bei weniger als 1 K, insbesondere bei weniger als 0,1 K 0,1 K liegt. Es ist günstig, wenn die Nulldurchgangstemperatur im gesamten Volumen des Substrats möglichst konstant ist, d.h. eine möglichst geringe Variation aufweist. Unter der räumlichen Variation wird die Differenz zwischen der maximalen Nulldurchgangstemperatur und der minimalen Nulldurchgangstemperatur im Volumen des Substrats verstanden. Die räumliche Variation der Nulldurchgangstemperatur bezieht sich auf das Substrat, nachdem die Hohlstruktur in dem Substrat erzeugt wurde, d.h. das beim Erzeugen der Hohlstruktur ablatierte Material bleibt bei der Bestimmung der räumlichen Variation der Nulldurchgangstemperatur unberücksichtigt.

Die Erfindung betrifft auch einen Spiegel, insbesondere einen EUV-Spiegel, umfassend: ein Substrat sowie eine auf das Substrat aufgebrachte Beschichtung zur Reflexion von Strahlung, insbesondere von EUV-Strahlung, wobei das Substrat mindestens eine Hohlstruktur, bevorzugt in Form eines Kanals, besonders bevorzugt in Form eines mit einem Fluid durchströmbaren Kanals, insbesondere in Form eines mit einem Kühlfluid durchströmbaren Kühlkanals aufweist, die mit dem weiter oben beschriebenen Verfahren hergestellt ist. In der Regel dient die Hohlstruktur zur Temperierung des EUV-Spiegels und wird zu diesem Zweck mit einem Fluid durchströmt. Es ist aber auch möglich, dass die Hohlstruktur zu einem anderen Zweck in das Substrat eingebracht ist, beispielsweise um eines oder mehrere Bauteile, z.B. in Form von Sensoren, Aktuatoren, etc. in das Substrat zu integrieren. Bei der Herstellung der Hohlstruktur weist das Substrat typischerweise noch keine reflektierende Beschichtung auf, um zu vermeiden, dass es zu einer Wechselwirkung zwischen der gepulsten Laserstrahlung und den Materialien der reflektierenden Beschichtung kommt. Die reflektierende Beschichtung wir daher typischerweise erst nach der Herstellung der Hohlstruktur auf das Substrat aufgebracht.

Die Erfindung betrifft auch einen Spiegel, insbesondere einen EUV-Spiegel, umfassend: ein Substrat, das mindestens einen bevorzugt mit einem Fluid durchströmbaren Kanal aufweist, der durch materialabtragende Bearbeitung mittels gepulster Laserstrahlung ausgebildet ist, wobei der Kanal gekrümmt ausgebildet ist und wobei der Kanal einen Durchmesser zwischen 1 mm und 20 mm, bevorzugt zwischen 1 mm und 5 mm, und/oder eine Länge von mindestens 10 cm, bevorzugt von mindestens 15 cm, insbesondere von mindestens 20 cm aufweist. Der Kanal kann bei der materialabtragenden Bearbeitung mittels gepulster Laserstrahlung insbesondere auf die weiter oben beschriebene Weise, d.h. mittels des oben beschriebenen Verfahrens, ausgebildet werden, indem mittels der gepulsten Laserstrahlung eine Abtragsfront gebildet wird, die durch das Substrat bewegt wird. Insbesondere kann die Abtragsfront hierbei zumindest zeitweist nicht senkrecht zur Einstrahlungsrichtung der gepulsten Laserstrahlung auf die Strahlungseintrittsseite des Werkstücks ausgerichtet sein. Der gekrümmte Kanal kann insbesondere zur Durchströmung mit einem Fluid, z.B. mit einem Kühlfluid, ausgebildet sein.

Bei einer Ausführungsform ist das Substrat monolithisch. Wie weiter oben beschrieben wurde, können bei einem monolithischen Substrat Verspannungen im Substratmaterial vermieden werden, die beim Zusammenfügen von zwei oder mehr Teilkörpern zu einem mehrteiligen Substrat auftreten.

Bei einer weiteren Ausführungsform weist der Kanal einen ersten Abschnitt und einen zweiten, angrenzenden Abschnitt auf, deren Längsrichtungen unter einem Winkel zwischen 70° und 100°, bevorzugt unter einem Winkel von 90°, zueinander ausgerichtet sind. Umlenkungen unter einem vergleichsweise großen Winkel von ca. 90° können bei der Führung eines Fluids durch den Kanal günstig sein, um das Substrat effektiv zu temperieren.

Bei einer Ausführungsform gehen der erste Abschnitt und der zweite Abschnitt an einem abgerundeten Abschnitt ineinander über. Ein kontinuierlicher Übergang zwischen den beiden Abschnitten entlang eines abgerundeten Abschnitts hat sich gegenüber einem Übergang in Form eines Knicks als günstig erwiesen, wie nachfolgend näher beschrieben wird.

Ein weiterer Aspekt der Erfindung betrifft ein optisches Element zur Reflexion von Strahlung in Form eines Spiegels, insbesondere eines EUV-Spiegels, umfassend: ein bevorzugt monolithisches Substrat, eine reflektierende Beschichtung zur Reflexion von Strahlung, insbesondere von EUV-Strahlung, die auf eine Oberfläche des bevorzugt monolithischen Substrats aufgebracht ist, sowie mindestens eine Hohlstruktur, die in dem bevorzugt monolithischen Substrat verläuft und die zur Durchströmung mit einem Fluid ausgebildet ist, wobei die Hohlstruktur einen ersten Abschnitt und einen zweiten, benachbarten Abschnitt aufweist, die unter einem Winkel zwischen 60° und 120°, bevorzugt unter einem Winkel zwischen 80° und 100°, insbesondere unter einem Winkel von 90°, zueinander ausgerichtet sind, und wobei die Hohlstruktur einen abgerundeten Abschnitt aufweist, an dem der erste Abschnitt und der zweite Abschnitt ineinander übergehen. Bei den beiden Abschnitten handelt es sich typischerweise um Kanalabschnitte, die unmittelbar angrenzend zu dem abgerundeten Abschnitt typischerweise im Wesentlichen geradlinig verlaufen. Die beiden Abschnitte weisen unmittelbar angrenzend zu dem abgerundeten Abschnitt Längsachsen auf, die unter dem oben beschriebenen Winkel zueinander ausgerichtet sind. Insbesondere können der erste Abschnitt und der zweite Abschnitt unter einem Winkel von mehr als 90°, beispielsweise von mehr als 100° zueinander ausgerichtet sein.

An einem Übergang zwischen zwei Abschnitten der Hohlstruktur des Substrats in Form eines Ecks bzw. einer scharfen Kante, insbesondere wenn die beiden Abschnitte annähernd senkrecht, d.h. unter einem Winkel zwischen 60° und 120°, zueinander ausgerichtet sind, kann es zu einer Strömungsablösung an der Wand der Hohlstruktur kommen, die zu Turbulenzen führt und strömungsinduzierte Vibrationen hervorruft. Aus diesem Grund wird vorgeschlagen, dass die beiden Abschnitte der Hohlstruktur an einem abgerundeten Abschnitt ineinander übergehen, der einen möglichst stromlinienförmigen Verlauf aufweist.

Unter einem abgerundeten Abschnitt wird ein Abschnitt verstanden, der keine Ecken aufweist. An dem abgerundeten Abschnitt geht der erste Abschnitt somit kontinuierlich in den zweiten Abschnitt über. Der Querschnitt bzw. der Durchmesser der Hohlstruktur innerhalb des abgerundeten Abschnitts ist typischerweise konstant, kann ggf. aber auch variieren. Der Querschnitt bzw. der Durchmesser des abgerundeten Abschnitts stimmt in der Regel mit dem Querschnitt beider Abschnitte überein, dies ist aber nicht zwingend der Fall, wenn der abgerundete Abschnitt an einer Verzweigung angeordnet ist, s.u.

Das Substrat ist bevorzugt monolithisch, d.h. dieses ist einteilig ausgebildet und weist keine Fügefläche auf, an der zwei oder mehr Teilkörper des Substrats miteinander verbunden sind.

Der abgerundete Abschnitt kann durch materialabtragende Bearbeitung mittels gepulster Laserstrahlung erzeugt werden, wie dies weiter oben in Zusammenhang mit dem Verfahren zum Erzeugen einer Hohlstruktur bzw. zum Erzeugen eines Kanals beschrieben ist, bei denen die schräg zur Einstrahlungsrichtung ausgerichtete Abtragsfront gebildet wird. Wie weiter oben beschrieben wurde, können durch die schräge Ausrichtung der Bearbeitungsebene bzw. der Abtragsfront Hohlstrukturen gebildet werden, die von einer geradlinigen Geometrie abweichen und die insbesondere nicht parallel zur Dickenrichtung des Substrats verlaufen. Der abgerundete Abschnitt der Hohlstruktur kann beispielsweise hergestellt werden, indem die schräg gestellte Abtragsfront gleichzeitig in zwei zueinander senkrechte Richtungen verschoben wird.

Bei einer Ausführungsform weisen ein Krümmungsradius R des abgerundeten Abschnitts und ein Durchmesser D des abgerundeten Abschnitts ein Verhältnis R / D auf, das zwischen 2 und 6, bevorzugt zwischen 2,5 und 5, insbesondere zwischen 2,5 und 3,5 liegt. Bei einem Verhältnis R / D von mehr als 2 können bereits signifikante Verbesserungen hinsichtlich der strömungsinduzierten Vibrationen, z.B. > 50 %, erreicht werden. Idealerweise liegt das Verhältnis R / D zwischen ca. 2,5 und 3,5, z.B. bei 3,0, da dort typischerweise die größten Verbesserungen in Bezug auf die strömungsinduzierten Vibrationen erreicht werden. Ein Wert des Verhältnisses R / D von mehr als 6 sollte nicht überschritten werden. Bei dieser Ausführungsform weist der abgerundete Abschnitt einen konstanten Krümmungsradius auf.

Der Strömungs-Querschnitt des abgerundeten Abschnitts ist typischerweise kreisförmig, kann aber ggf. von einer kreisförmigen Geometrie abweichen und z.B. eine elliptische Geometrie aufweisen. In diesem Fall wird unter dem Durchmesser des abgerundeten Abschnitts der sogenannte äquivalente Durchmesser verstanden, d.h. der Durchmesser eines Kreises, dessen Fläche dem in diesem Fall nicht kreisförmigen Strömungs-Querschnitt des abgerundeten Abschnitts entspricht, wie dies weiter oben beschrieben wurde.

Es hat sich herausgestellt, dass das Verhältnis zwischen dem Durchmesser des abgerundeten Abschnitts und dem Krümmungsradius des abgerundeten Abschnitts einen wesentlichen Parameter für eine stromlinienförmige Strömungsführung ohne Turbulenzen und somit für die Vermeidung von strömungsinduzierten Vibrationen darstellt.

Bei einer weiteren Ausführungsform liegt der Durchmesser D des abgerundeten Abschnitts zwischen 2 mm und 20 mm, bevorzugt zwischen 2 mm und 12 mm. Ein Durchmesser des abgerundeten Abschnitts bzw. der Kanalstrukturen der Hohlstruktur, die in der angegebenen Größenordnung liegen, ermöglichen es bei den gegebenen Randbedingungen einen ausreichenden Volumenstrom für eine effiziente Temperierung des optischen Elements zu erzeugen. Die Strömungsgeschwindigkeit des Fluids in der Hohlstruktur liegt in der Regel in der Größenordnung von Metern / Sekunde.

Bei einer Ausführungsform weist die Hohlstruktur eine Mehrzahl von Temperierkanälen, insbesondere in Form von Kühlkanälen, auf, die unterhalb der Oberfläche verlaufen, auf welche die reflektierende Beschichtung aufgebracht ist, und die Hohlstruktur weist einen über Verteilerkanäle mit den Temperierkanälen, insbesondere mit den Kühlkanälen, verbunden Fluidverteiler sowie einen über Sammlerkanäle mit den Temperierkanälen, insbesondere mit den Kühlkanälen, verbundenen Fluidsammler auf. Die Temperierkanäle, die üblicherweise zur Kühlung des Substrats dienen und daher nachfolgend auch als Kühlkanäle bezeichnet werden, verlaufen in der Regel in einem oberflächennahen Bereich unterhalb der Oberfläche. Unter einem oberflächennahen Bereich wird ein Abstand von der Oberfläche des Substrats verstanden, der bei 10 mm oder weniger liegt. Der Abstand von der Oberfläche wird in Dickenrichtung des Substrats gemessen, die in der Regel senkrecht zur in der Regel planen Unterseite des Substrats ausgerichtet ist. Durch den geringen Abstand der Kühlkanäle von der Oberfläche kann eine effektive Kühlung der Oberfläche des Spiegels erfolgen. Unter dem Abstand wird die minimale Distanz zwischen dem jeweiligen Temperierkanal und der Oberfläche mit der reflektierenden Beschichtung verstanden.

Der Fluidverteiler und der Fluidsammler weisen in der Regel jeweils einen größeren Strömungs-Querschnitt auf als ein einzelner Kühlkanal. Das ermöglicht die Einstellung günstiger Strömungsverhältnisse. Der Fluidverteiler und/oder der Fluidsammler sind bevorzugt in einem größeren Abstand von der Oberfläche angeordnet, auf der die reflektierende Beschichtung aufgebracht ist, als die Kühlkanäle. Durch diese Anordnung kann die Verformung der Oberfläche durch den Fluiddruck im Fluidverteiler und/oder im Fluidsammler, die in der Regel großflächigere Hohlräume aufweisen als die Kühlkanäle, in vertretbaren Grenzen gehalten werden. Der Fluidverteiler steht typischerweise mit einem Fluideinlass in Verbindung und der Fluidsammler steht typischerweise mit einem Fluidauslass in Verbindung. Ein jeweiliger Kühlkanal kann jeweils mit genau einem Verteilerkanal und mit genau einem Sammlerkanal verbunden sein, es ist aber grundsätzlich auch möglich, dass eine Gruppe von zwei oder ggf. mehr als zwei Kühlkanälen mit einem gemeinsamen Verteilerkanal und mit einem gemeinsamen Sammlerkanal verbunden sind.

Bei einer weiteren Ausführungsform bildet der erste Abschnitt einen an einen Verteilerkanal angrenzenden Endabschnitt des Temperierkanals, insbesondere des Kühlkanals, und der zweite Abschnitt bildet einen an den Endabschnitt angrenzenden Verteilerkanalabschnitt und/oder der erste Abschnitt bildet einen an einen Sammlerkanal angrenzenden Endabschnitt des Temperierkanals, insbesondere des Kühlkanals, und der zweite Abschnitt bildet einen an den Endabschnitt angrenzenden Sammlerkanalabschnitt.

Die Kühlkanäle verlaufen typischerweise im Wesentlichen parallel zu der Oberfläche, auf der die reflektierende Beschichtung aufgebracht ist. Da der Bauraum innerhalb des Substrats begrenzt ist, wird ein Verteilerkanal bzw. ein Sammlerkanal, der mit einem jeweiligen Kühlkanal verbunden ist, in der Regel unter einem annähernd rechten Winkel von der Oberfläche mit der reflektierenden Beschichtung weggeführt, d.h. der Sammler- bzw. der Verteilerkanalabschnitt und ein benachbarter Endabschnitt des Kühlkanals verlaufen in der Regel annähernd unter einem rechten Winkel zueinander, d.h. es findet annähernd eine 90°-Umlenkung des Fluids statt, welches die Hohlstruktur durchströmt.

Durch den weiter oben beschriebenen abgerundeten Abschnitt, insbesondere bei der Wahl eines geeigneten Verhältnisses von Krümmungsradius zu Durchmesser können strömungsinduzierte Vibrationen vermieden oder zumindest deutlich reduziert werden.

Grundsätzlich können der Fluidverteiler und der Fluidsammler auf unterschiedliche Weise ausgebildet sein. Beispielsweise kann der Strömungsquerschnitt des Fluidverteilers bzw. des Fluidsammler sich ausgehend von den Verteilerkanälen bzw. von den Sammlerkanälen verjüngen, z.B. in der Art eines Trichters, sodass die Hohlräume, die der Fluidverteiler und der Fluidsammler in dem Substrat bilden, nicht unnötig groß ausfallen.

Bei einer weiteren Ausführungsform bildet der Fluidverteiler einen Einlasskanal, von dem die Verteilerkanäle abzweigen und/oder bei dem der Fluidsammler bildet einen Auslasskanal, von dem die Sammlerkanäle abzweigen. Bei dieser Ausführungsform verlaufen der Fluidsammler und der Fluidverteiler in der Regel im Wesentlichen quer zur Längsrichtung der Verteilerkanäle bzw. quer zur Längsrichtung der Sammlerkanäle. Die Verteilerkanäle bzw. die Sammlerkanäle zweigen von dem Einlasskanal bzw. dem Auslasskanal in der Regel im Wesentlichen rechtwinklig ab. Der Fluidverteiler und der Fluidsammler können in diesem Fall beispielsweise in Form von zylindrischen Kanälen ausgebildet sein, die sich ausgehend von einer Einlassöffnung bzw. von einer Auslassöffnung an einer Außenseite des Substrats in das Substrat hinein erstrecken. Der Einlasskanal und der Auslasskanal können in diesem Fall z.B. in Form von Bohrungen ausgebildet sein, es ist aber auch möglich, dass diese durch das weiter oben beschriebene Ablationsverfahren hergestellt werden.

Bei einer Weiterbildung dieser Ausführungsform bildet der erste Abschnitt einen dem Einlasskanal benachbarten Mündungsabschnitt des Verteilerkanals und der zweite Abschnitt bildet einen dem Mündungsabschnitt benachbarten Verzweigungsabschnitt des Einlasskanals und/oder der erste Abschnitt bildet einen dem Auslasskanal benachbarten Mündungsabschnitt des Sammlerkanals und der zweite Abschnitt bildet einen dem Mündungsabschnitt des Sammlerkanals benachbarten Verzweigungsabschnitt des Auslasskanals.

Wie weiter oben beschrieben wurde, verläuft die Längsrichtung des Einlasskanals bzw. des Auslasskanals im Wesentlichen senkrecht zur Längsrichtung eines jeweiligen Sammlerkanals bzw. Verteilerkanals. Auch an einer jeweiligen Abzweigung eines Verteiler- bzw. Sammlerkanals ist eine stromlinienförmige Geometrie günstig, die durch das Vorsehen eines abgerundeten Abschnitts an einer Verzweigung des Einlasskanals bzw. des Auslasskanals hergestellt werden kann. Auf diese Weise können Stufen vermieden und Kanten abgerundet werden, wodurch die Geometrie der Hohlstruktur stromlinienförmiger gestaltet werden und die Ablösung des Fluids im Einlasskanal und im Auslasskanal vermieden oder zumindest stark reduziert werden kann.

Das Verhältnis von Durchmesser zum Radius des abgerundeten Abschnitts liegt bevorzugt innerhalb des weiter oben beschriebenen Wertebereichs. Es ist aber auch möglich, dass der abgerundete Abschnitt an der Verzweigung keinen konstanten Krümmungsradius aufweist. Auch der Strömungs-Durchmesser des abgerundeten Abschnitts an der Verzweigung ist nicht zwingend konstant. Beispielsweise kann sich der Querschnitt des abgerundeten Abschnitts ausgehend von dem Einasskanal bzw. ausgehend von dem Auslasskanal verjüngen.

Bei einer weiteren Ausführungsform ist der Winkel zwischen dem Verzweigungsabschnitt des Einlasskanals und dem Mündungsabschnitt des Verteilerkanals größer als 90°, bevorzugt größer als 100° und/oder der Winkel zwischen dem Verzweigungsabschnitt des Auslasskanals und dem Mündungsabschnitt des Sammlerkanals größer als 90°, bevorzugt größer als 100°. Es hat sich herausgestellt, dass es für die Strömungsführung günstig ist, wenn der Verzweigungsabschnitt des Einlasskanals bzw. des Auslasskanals und der Mündungsabschnitt des Verteilerkanals bzw. des Sammlerkanals unter einem stumpfen Winkel zueinander ausgerichtet sind.

Bei einer weiteren Ausführungsform ist das Material des Substrats ausgewählt ist aus der Gruppe umfassend: Quarzglas, insbesondere titandotiertes Quarzglas, und Glaskeramik. Um auf eine ggf. inhomogene Erwärmung des Substrat-Materials zurückzuführende Deformationen der Oberfläche, auf welche die reflektierende Beschichtung aufgebracht ist, zu vermeiden, werden die Substrate von Spiegeln für die EUV-Lithographie typischerweise aus so genanntem Null-Ausdehnungsmaterial hergestellt, das einen sehr geringen thermischen Ausdehnungskoeffizienten aufweist, s.o. Wie weiter oben beschrieben wurde, sind diese Materialien hart und brüchig und lassen sich daher nur schwer mechanisch bearbeiten. Durch die weiter oben beschriebenen Verfahren zur Laserablation können aber auch in derartigen Materialien praktisch beliebig geformte Hohlstrukturen hergestellt werden.

Bei einer weiteren Ausführungsform weist das Material des Substrats eine Nulldurchgangstemperatur auf, die zwischen 0°C und 100°C, bevorzugt zwischen 19°C und 40°C, besonders bevorzugt zwischen 19°C und 32°C liegt. Wie weiter oben beschrieben wurde, wird die Nulldurchgangstemperatur u.a. in Abhängigkeit von der mittleren auftreffenden Strahlungsleistung im Betrieb des EUV-Spiegels festgelegt.

Bei einer Ausführungsform weist das Material des Substrats eine räumliche Variation der Nulldurchgangstemperatur auf, die bei weniger als 3 K, bevorzugt bei weniger als 2 K, besonders bevorzugt bei weniger als 1 K, insbesondere bei weniger als 0,1 K liegt. Wie weiter oben beschrieben wurde, ist typischerweise eine hohe räumliche Homogenität der Nulldurchgangstemperatur erforderlich, um den Spiegel effizient betreiben zu können.

Bei einer weiteren Ausführungsform weist die Hohlstruktur, bevorzugt der insbesondere mit einem Fluid durchströmbare Kanal einen Nahtbereich auf. Wie dies weiter oben beschrieben wurde, wird bei der Herstellung einer Hohlstruktur in Form eines Kanals typischerweise ein Nahtbereich gebildet, in dem zwei durch Laserablation gebildete Teile des Kanals zur Ausbildung eines durchgehenden Kanals zusammengeführt werden. In dem Nahtbereich unterscheidet sich die Beschaffenheit des Kanals, insbesondere der Wand des Kanals, in mindestens einer Eigenschaft von der Beschaffenheit des Kanals, insbesondere der Wand des Kanals, außerhalb des Nahtbereichs. Beispielsweise kann sich die Oberfläche bzw. eine Oberflächenstruktur an der Wand des Kanals in dem Nahtbereich von der Oberfläche bzw. von einer Oberflächenstruktur an der Wand des Kanals außerhalb des Nahtbereichs unterscheiden.

Bei einer Weiterbildung dieser Ausführungsform weist die Hohlstruktur, bevorzugt der insbesondere mit einem Fluid durchströmbare Kanal, in dem Nahtbereich eine Randkontur einer Abtragsfront, mindestens eine Ausstülpung, einen lateralen Versatz oder eine andere strukturelle Veränderung auf.

In dem Nahtbereich kann an der Oberflächenstruktur der Hohlstruktur in Form des Kanals der Umriss bzw. die Randkontur der Abtragsfront oder ggf. der beiden Abtragsfronten erkennbar bzw. eingeschrieben sein, an denen die Laserablation eines jeweiligen Teils des Kanals beendet wurde. Die Randkontur der Abtragsfront, die in der Oberflächenstruktur des Kanals zu erkennen ist, kann insbesondere einen Winkel, z.B. einen Winkel von 45°, zu einem an die Abtragsfront angrenzenden Bereich der Mantelfläche des Kanals aufweisen. Der Winkel ist typischerweise auf die Tatsache zurückzuführen, dass die Abtragsfront bei der Herstellung des Kanals nicht senkrecht zur Einstrahlungsrichtung ausgerichtet war. Die Randkontur der Abtragsfront kann vollständig umlaufend oder ggf. nur abschnittsweise in der Oberflächenstruktur des Kanals erkennbar sein.

In dem Nahtbereich können an der Wand des Kanals eine oder mehrere Ausstülpungen auftreten, die jeweils eine in Längsrichtung lokal begrenzte Vergrößerung oder Verkleinerung des Querschnitts des Kanals bilden. Auch kann die Wand des Kanals in dem Nahtbereich einen geringfügigen seitlichen Versatz in der Art einer Stufe aufweisen, die bei der Zusammenführung der beiden Teile des Kanals und/oder aufgrund von geringfügig unterschiedlichen Querschnitten der beiden Teile des Kanals entsteht. Es versteht sich, dass die Beschaffenheit des Kanals bzw. der Wand des Kanals in dem Nahtbereich auch andere strukturelle Veränderungen aufweisen kann, welche die Oberflächenstruktur des Kanals in dem Nahtbereich von der Oberflächenstruktur des Kanals außerhalb des Nahtbereichs unterscheiden.

Ein weiterer Aspekt der Erfindung betrifft einen Spiegel, insbesondere einen EUV-Spiegel, umfassend: ein Substrat, das mindestens einen bevorzugt mit einem Fluid durchströmbaren, insbesondere gekrümmten Kanal umfasst, der einen Nahtbereich aufweist. Wie weiter oben beschrieben wurde, entsteht der Nahtbereich, wenn zwei durch Laserablation gebildete Teile des Kanals zur Ausbildung eines durchgehenden Kanals zusammengeführt werden. Der Nahtbereich ist typischerweise von beiden Enden des Kanals beabstandet. Der Nahtbereich kann ungefähr den gleichen Abstand zu den beiden Enden des Kanals aufweisen, dies ist aber nicht zwingend erforderlich. Wie weiter oben beschrieben wurde, unterscheidet sich in dem Nahtbereich die Beschaffenheit des Kanals, insbesondere der Wand des Kanals, in mindestens einer Eigenschaft von der Beschaffenheit des Kanals, insbesondere der Wand des Kanals, außerhalb des Nahtbereichs.

Bei einer Ausführungsform weist der Kanal in dem Nahtbereich eine Randkontur einer Abtragsfront, mindestens eine Ausstülpung, einen lateralen Versatz oder eine andere strukturelle Veränderung auf.

Der Spiegel gemäß dem vorliegenden Aspekt der Erfindung kann insbesondere die Merkmale der Spiegel gemäß der weiter oben beschriebenen Aspekte der Erfindung aufweisen. Bei dem Material des Substrats kann es sich insbesondere um titandotiertes Quarzglas oder um eine Glaskeramik handeln. Das Substrat kann monolithisch ausgebildet sein, dies ist aber nicht zwingend erforderlich.

Ein weiterer Aspekt der Erfindung betrifft ein EUV-Lithographiesystem, umfassend: mindestens einen EUV-Spiegel, der wie oben beschrieben ausgebildet ist, sowie eine Temperiereinrichtung, insbesondere eine Kühleinrichtung, die zum Durchströmen der mindestens einen Hohlstruktur, insbesondere in Form eines Kanals, mit einem Temperierfluid, insbesondere mit einem Kühlfluid, ausgebildet ist. Bei dem EUV-Lithographiesystem kann es sich um eine EUV-Lithographieanlage zur Belichtung eines Wafers oder um eine andere optische Anordnung handeln, die EUV-Strahlung verwendet, beispielsweise um ein EUV-Inspektionssystem, z.B. zur Inspektion von in der EUV-Lithographie verwendeten Masken, Wafern oder dergleichen.

Die Temperiereinrichtung kann als Kühleinrichtung dienen und kann beispielsweise ausgebildet sein, ein Kühlmedium in Form eines Kühlfluids, beispielsweise einer Kühlflüssigkeit, z.B. in Form von Kühlwasser, durch die Hohlstruktur, insbesondere in Form des Kanals, strömen zu lassen. Die Temperier- bzw. die Kühleinrichtung kann zu diesem Zweck ggf. eine Pumpe sowie geeignete Zuführungs- und Abführungsleitungen aufweisen. Die Temperiereinrichtung kann auch als Heizeinrichtung zum Heizen des Substrats dienen. In diesem Fall wird der Hohlstruktur in Form des Kanals ein Temperierfluid in Form eines Heizfluids zugeführt, bei dem es sich in der Regel ebenfalls um eine Flüssigkeit handelt. Es ist auch möglich, dass die Temperiereinrichtung sowohl zum Heizen als auch zum Kühlen des Spiegels ausgebildet ist. Als Temperierfluid zum Durchströmen der Hohlstruktur in Form des Kanals wird - sowohl beim Kühlen als auch beim Heizen - bevorzugt Wasser verwendet.

Die Hohlstruktur des Substrats weist eine Einlassöffnung für den Eintritt des Fluids und eine Auslassöffnung für den Austritt des Fluids auf. Die Einlassöffnung und die Auslassöffnung können mit einem Anschluss einer Fluidzuführungsleitung bzw. einer Fluidabführungsleitung verbunden sein, um den Kanal mit der Temperiereinrichtung zu verbinden. Für den Fall, dass mehrere fluidisch getrennte Hohlstrukturen bzw. Kanäle in dem Substrat verlaufen, sind diese über separate Einlass- und Auslassöffnungen mit der Temperiereinrichtung verbunden.

Ein weiterer Aspekt der Erfindung betrifft eine Vorrichtung der eingangs genannten Art, die eine Fluidzuführung aufweist, die zumindest teilweise in den Kanal einführbar ist. Die Vorrichtung ist zur Durchführung des weiter oben beschriebenen Verfahrens zum Erzeugen eines Kanals ausgebildet, bei dem eine materialabtragende Bearbeitung erfolgt und bei dem die Fluidzuführung zumindest teilweise in den Kanal eingeführt wird. Wie weiter oben beschrieben wurde, ist es bei längeren Kanälen erforderlich, das abgetragene Werkstückmaterial mit Hilfe einer geeigneten Fluidzuführung abzutransportieren und die Abtragsfront zu kühlen.

Bei einer Ausführungsform ist die Fluidzuführung ausgebildet, einem Bereich, in dem die materialabtragende Bearbeitung durchgeführt wird, insbesondere einer beim materialabtragenden Bearbeiten gebildeten Abtragsfront, mit Hilfe der Fluidzuführung ein Fluid zuzuführen, wobei die Fluidzuführung bevorzugt der Abtragsfront bei der Bewegung in dem Werkstück nachführbar ist. Die Fluidzuführung kann zu diesem Zweck ortsfest bleiben und das Werkstück kann relativ zur Fluidzuführung bewegt werden, es ist aber auch möglich, dass die Fluidzuführung selbst mit Hilfe von geeigneten Aktuatoren oder dergleichen bewegt wird. Die Fluidzuführung weist in diesem Fall typischerweise ein Element auf, das in den Kanal eingeführt werden kann, beispielsweise in Form eines Rohrs oder dergleichen.

Bei einer weiteren Ausführungsform ist die Fluidzuführung ausgebildet, ein flexibles Element, insbesondere einen flexiblen Schlauch, zumindest teilweise in den Kanal einzuführen. Um das abgetragene Material möglichst effektiv von der Abtragsfront abzuführen, ist es erforderlich, dass das Fluid mit Hilfe eines flexiblen Schlauchs oder dergleichen in die Nähe der Abtragsfront geführt wird, insbesondere wenn es sich um einen gekrümmten Kanal handelt. Am freien Ende kann der flexible Schlauch eine Düse zum Austritt des Fluids aufweisen, bei dem es sich beispielsweise um Wasser oder um Druckluft handeln kann. Bei nicht abgewinkelten Hohlräumen bzw. bei vergleichsweise kleinen Hohlraumlängen von z.B. weniger als 20 mm, typischerweise bei einem Abstand zwischen der Abtragsfront und dem Austritt des Fluids aus dem Schlauch bzw. der Düse, ist es möglich, dass der flexible Schlauch ortsfest angeordnet ist und aufgrund der Bewegung des Werkstücks automatisch in den Hohlraum eingeführt wird, ohne dass zu diesem Zweck von außen auf den Schlauch eingewirkt wird. Die hier beschriebene Vorrichtung kann eine Fluidbereitstellungseinrichtung sowie ggf. eine Nachführungseinrichtung zur automatisierten Nachführung des flexiblen Schlauchs zu der Abtragsfront aufweisen, wie dies in Zusammenhang mit der weiter unten beschriebenen Fluidzuführungsvorrichtung beschrieben ist.

Bei einer weiteren Ausführungsform ist die Scanneroptik zum Bewegen des Fokusbereichs entlang eines Bewegungsmusters ausgebildet, um eine Abtragsfront zum flächigen Abtrag von Material des Werkstücks zu bilden, wobei die Vorrichtung zum Bilden einer Abtragsfront ausgebildet ist, die nicht senkrecht zu einer Einstrahlungsrichtung der gepulsten Laserstrahlung auf das von der Halterung aufgenommene Werkstück ausgerichtet ist. Typischerweise entspricht die Einstrahlungsrichtung auf das Werkstück, genauer gesagt auf die Strahlungseintrittsseite des Werkstücks, der Schwerkraftrichtung. Das Werkstück ist bei der Anordnung in der Halterung so ausgerichtet, dass dessen Dickenrichtung, die typischerweise senkrecht zur Strahlungseintrittsseite verläuft, mit der Schwerkraftrichtung übereinstimmt. Die Laserquelle ist zur Erzeugung von gepulster Laserstrahlung in Form von ultrakurzen Laserpulsen ausgebildet, die es typischerweise ermöglichen, eine Multi-Photonen-Absorption zu erzeugen, um das Material des Werkstücks abzutragen.

Für die Ausgestaltung der Vorrichtung zur Ausrichtung der Abtragsfront in einer Richtung bzw. in einer Ebene, die nicht senkrecht zur Einstrahlungsrichtung ausgerichtet ist, bestehen verschiedene Möglichkeiten.

Bei einer Ausführungsform umfasst die Vorrichtung zusätzlich eine Fokusversatz-Einrichtung zum Versetzen des Fokusbereichs der gepulsten Laserstrahlung in bzw. entlang der Einstrahlungsrichtung der gepulsten Laserstrahlung, sowie eine Steuerungseinrichtung, die ausgebildet bzw. programmiert ist, die Fokusversatz-Einrichtung anzusteuern, Bewegungsbahnen des Bewegungsmusters in bzw. entlang der Einstrahlungsrichtung zueinander zu versetzen, um die nicht senkrecht zur Einstrahlungsrichtung ausgerichtete Abtragsfront zu bilden.

Bei dieser Ausführungsform weist die Vorrichtung eine Fokusversatz-Einrichtung zum dynamischen Versetzen des Fokusbereichs entlang der Einstrahlungsrichtung der gepulsten Laserstrahlung auf. Die Fokusversatz-Einrichtung kann beispielsweise in Form eines dynamischen Zoom-Objektivs ausgebildet sein. Die Steuerungseinrichtung kann in Form einer geeigneten Hard- und/oder Software implementiert sein.

Bei einer weiteren Ausführungsform umfasst die Vorrichtung eine Steuerungseinrichtung, die ausgebildet bzw. programmiert ist, die Laserquelle anzusteuern, eine Pulsenergie der gepulsten Laserstrahlung von zueinander versetzten Bewegungsbahnen des Bewegungsmusters zu verändern, um die nicht senkrecht zur Einstrahlungsrichtung ausgerichtete Abtragsfront zu bilden. Wie weiter oben in Zusammenhang mit dem Verfahren beschrieben wurde, wird ohne die Verwendung der Fokusversatz-Einrichtung die gepulste Laserstrahlung mit Hilfe der Fokussieroptik in einer Ebene fokussiert, die typischerweise senkrecht zur Einstrahlungsrichtung ausgerichtet ist. Um die gepulste Laserstrahlung an allen Positionen im Scanfeld der Scanneroptik in derselben Fokusebene zu fokussieren, kann die Vorrichtung ein F-Theta-Objektiv oder ein telezentrisches Objektiv aufweisen. Um die Abtragsfront unter einem Winkel zu der Fokusebene auszurichten, in welcher der Fokusbereich bewegt wird, wird in diesem Fall die Pulsenergie der gepulsten Laserstrahlung zwischen den zueinander versetzten Bewegungsbahnen verändert.

Für die Veränderung der Pulsenergie kann die Laserquelle einen oder mehrere akusto-optische oder elektro-optische Modulatoren aufweisen, auf welche die Steuerungseinrichtung einwirkt. Wie weiter oben in Zusammenhang mit dem Verfahren beschrieben wurde, nimmt die Pulsenergie von einem Rand des Ablationsmusters zum gegenüberliegenden Rand des Ablationsmusters in der Regel zu oder ab, wodurch eine Abtragsfront gebildet wird, die unter einem Winkel zur Fokusebene ausgerichtet ist.

Bei einer weiteren Ausführungsform umfasst die Vorrichtung eine Positioniereinrichtung zum Bewegen der Abtragsfront innerhalb des Werkstücks, bevorzugt ausgehend von einer der Strahlungseintrittsseite gegenüberliegenden Seite des Werkstücks zum Erzeugen des Kanals, wobei die Positioniereinrichtung zur Verschiebung des Werkstücks in bzw. entlang der Einstrahlungsrichtung und bevorzugt in bzw. entlang von mindestens einer Richtung quer zur Einstrahlungsrichtung ausgebildet ist. Die Positioniereinrichtung wirkt zu diesem Zweck typischerweise auf die Halterung des Werkstücks ein. Die Positioniereinrichtung kann einen oder mehrere Antriebe z.B. in Form von Linearmotoren oder dergleichen aufweisen, die insbesondere eine überlagerte Bewegung bzw. Verschiebung des Werkstücks in zwei oder in drei unterschiedlichen Raumrichtungen realisiert. Grundsätzlich ist es auch möglich, dass die Positioniereinrichtung zur Drehung des Werkstücks ausgebildet ist.

Ein weiterer Aspekt der Erfindung betrifft eine Fluidzuführungsvorrichtung der eingangs genannten Art, umfassend: mindestens eine flexible Fluidleitung, bevorzugt eine Mehrzahl von flexiblen Fluidleitungen, zum Zuführen des Fluids zu der mindestens einen Abtragsfront, bevorzugt zu einer Mehrzahl von Abtragsfronten, sowie ein Einlegebauteil zum Einlegen in einen Hohlraum des Werkstücks, wobei das Einlegebauteil mindestens einen Führungskanal aufweist, in dem die mindestens eine flexible Fluidleitung geführt ist bzw. in dem mindestens eine flexible Fluidleitung führbar ist, um das Fluid der mindestens einen Abtragsfront zuzuführen.

Die Fluidzuführungsvorrichtung gemäß diesem Aspekt der Erfindung weist für die Zuführung des Fluids zu der mindestens einen Abtragsfront, die beim Herstellen einer Hohlstruktur in dem Material des Werkstücks bewegt wird, mindestens eine flexible Fluidleitung auf, die der Abtragsfront bei deren Bewegung durch das Werkstück nachgeführt werden kann. Um die flexible Fluidleitung, genauer gesagt deren freies Ende, an dem das Fluid austritt, an einer vorgegebenen Stelle innerhalb des Substrats zu positionieren, wird die flexible Fluidleitung bei der erfindungsgemäßen Fluidzuführungsvorrichtung in einem Führungskanal eines Einlegebauteils geführt, das in einen Hohlraum in dem Werkstück eingelegt wird.

Dies ist insbesondere günstig, wenn von einer Wand des Hohlraums eine oder mehrere Strukturen abzweigen, die durch Laserablation, insbesondere durch Multi-Photonen-Laserablation, gebildet werden, da in diesem Fall das jeweilige Ende der Fluidleitung mit Hilfe des Einlegebauteils bzw. des Führungskanals an einer Stelle an der Wand des Hohlraums positioniert werden kann, von der die Struktur ausgeht, und beim Bilden der Struktur der Abtragsfront nachgeführt werden kann.

Es ist möglich, dass vor dem Einführen des Einlegebauteils in den Hohlraum bereits ein kurzer Abschnitt der jeweiligen von dem Hohlraum abzweigenden Struktur durch Laserablation hergestellt wird. Um der hierbei gebildeten Abtragsfront ein Fluid zuzuführen, kann das Werkstück zumindest teilweise in ein Flüssigkeitsbad eingetaucht werden. Sobald die Abtragsfront einen Abstand von typischerweise mehr als ca. 20-40 mm von der Wand des Hohlraums aufweist, ist das Eintauchen in das Flüssigkeitsbad in der Regel nicht mehr ausreichend, da das abgetragene Material nicht mehr in ausreichendem Maße abtransportiert werden kann und der Ablationsprozess zum Erliegen kommt. Für die Herstellung von Strukturen, die von dem Hohlraum abzweigen und eine größere Länge als ca. 20-40 mm haben, wird daher bei der Bewegung der Abtragsfront das Fluid mit Hilfe einer flexiblen Fluidleitung nachgeführt.

Eine flexible Fluidleitung kann auch ohne ein Einlegebauteil der Abtragsfront nachgeführt werden, sofern die Hohlstruktur, die durch die Laserablation erzeugt wird, sich nicht verzweigt oder eine anderweitig zu komplexe Geometrie aufweist. Wie weiter oben beschrieben wurde, kann mit Hilfe des Einlegebauteils jedoch die flexible Fluidleitung an derjenigen Stelle positioniert werden, an der eine Struktur von dem Hohlraum ausgehen bzw. abzweigen soll. Mit Hilfe des Einlegebauteils kann daher auch bei einer Hohlstruktur, die Verzweigungen aufweist, die Zuführung des Fluids zu der Abtragsfront sichergestellt werden, ohne dass ein manuelles Einfädeln der flexiblen Fluidleitung bzw. der flexiblen Fluidleitungen in die von dem Hohlraum abzweigende Struktur oder die von dem Hohlraum abzweigenden Strukturen erforderlich ist.

Die Laserablation kann insbesondere in Form einer Multi-Photonen-Laserablation erfolgen. Bei der Multi-Photonen-Laserablation wird zur Bildung einer Hohlstruktur die gepulste Laserstrahlung, in der Regel Ultrakurzpuls-Laserstrahlung, durch das Material des Substrats hindurch auf eine Stelle an der Rückseite des Werkstücks oder an einer Oberfläche innerhalb des Werkstücks, beispielsweise an einer Wand des oben beschriebenen Hohlraums, eingestrahlt, von welcher die zu bildende Struktur ausgehen soll. Bei der Multi-Photonen-Laserablation wird eine Abtragsfront erzeugt, die ausgehend von dieser Stelle durch das Material des Substrats bewegt wird, um die Hohlstruktur zu bilden. Für Details zum Abtragen von Material durch Multi-Photonen-Laserablation wird auf das weiter oben beschriebene Verfahren zum Erzeugen eine Hohlstruktur durch materialabtragende Bearbeitung mittels gepulster Laserstrahlung verwiesen. Wie dort beschrieben ist, kann für die Herstellung von Hohlstrukturen mit komplexen Geometrien die Abtragsfront bzw. die Bearbeitungsebene nicht senkrecht zur Einstrahlungsrichtung der gepulsten Laserstrahlung ausgerichtet werden, sondern in Bezug auf eine Ebene senkrecht zur Einstrahlungsrichtung verkippt werden. Auf diese Weise können auch nicht geradlinige Hohlstrukturen mit Hinterschneidungen durch Laserablation hergestellt werden.

Bei dem Fluid handelt es sich typischerweise um eine Flüssigkeit, beispielsweise um Wasser, das mit einem vergleichsweise großen Druck aus der flexiblen Fluidleitung austritt. Anstelle einer Flüssigkeit kann auch ein Gas, beispielsweise Druckluft, mit der Abtragsfront in Kontakt gebracht werden, um die Ablationsprodukte abzutransportieren. Am freien Ende der flexiblen Fluidleitung bzw. eines Schlauchs kann eine Düse für den Austritt des Fluids angebracht sein, dies ist aber nicht zwingend erforderlich.

Bei dem Werkstück handelt es sich bevorzugt um ein insbesondere monolithisches Substrat für einen EUV-Spiegel. Ein monolithisches Substrat ist einteilig ausgebildet und weist keine Fügefläche auf, an der zwei oder mehr Teilkörper des Substrats miteinander verbunden sind. Wie weiter oben beschrieben wurde, lassen sich Hohlstrukturen in einem solchen monolithischen Substrat nicht ohne weiteres durch mechanisches Bearbeiten, z.B. durch Bohren oder durch Schleifen, in dem harten und brüchigen Glas-Material herstellen, bei dem es sich beispielsweise um titandotiertes Quarzglas oder um eine Glaskeramik handeln kann. Der weiter oben beschriebene Hohlraum kann durch mechanisches Bearbeiten hergestellt werden, beispielsweise kann es sich bei dem Hohlraum um eine Bohrung handeln, die in das Substrat gefräst wird. Grundsätzlich ist es aber auch möglich, dass der Hohlraum durch Multi-Photonen-Laserablation erzeugt wird, auch wenn dieses Verfahren bei der Herstellung von Hohlräumen mit großen Durchmessern zeitaufwändig ist.

Bei einer Ausführungsform weist das Einlegebauteil eine Mehrzahl von Führungskanälen auf, in denen jeweils eine flexible Fluidleitung geführt ist. Bei einer Hohlstruktur, die eine ggf. erhebliche Anzahl von Kanälen oder von anderen Strukturen aufweist, die von dem Hohlraum ausgehen, ist es daher günstig, die mehreren Kanäle bzw. anderen Strukturen zeitgleich herzustellen. Zu diesem Zweck können gleichzeitig mehrere gepulste Laserstrahlen durch das Volumen des Werkstücks hindurch eingestrahlt werden, um gleichzeitig mehrere Abtragsfronten zu bilden, an denen das Material des Werkstücks abgetragen wird, wodurch mehrere von dem Hohlraum abzweigende Strukturen bzw. Kanäle gleichzeitig hergestellt werden können.

Die gleichzeitige Erzeugung mehrerer Abtragsfronten erfordert die gleichzeitige Zuführung des Fluids zu den Abtragsfronten mit Hilfe einer entsprechenden Anzahl von Führungskanälen bzw. von flexiblen Fluidleitungen, die den jeweiligen Abtragsfronten nachgeführt werden. Idealerweise können alle von dem Hohlraum abzweigenden Strukturen zeitparallel hergestellt werden. Ist die Anzahl der abzweigenden Strukturen zu groß, können diese in mehrere Gruppen aufgeteilt werden, die jeweils gemeinsam zeitparallel bearbeitet werden. Für die Herstellung einer jeweiligen Gruppe von Strukturen können unterschiedlich ausgebildete Einlegebauteile verwendet werden.

Bei einer weiteren Ausführungsform ist zwischen der Fluidleitung und einer Kanalwand des Führungskanals ein durchströmbarer Spalt, insbesondere ein Ringspalt, zur Rückführung des Fluids von der Abtragsfront gebildet. Die flexible Fluidleitung weist einen Durchmesser auf, der so gewählt ist, dass das in der Fluidleitung der Abtragsfront zugeführte Fluid über den durchströmbaren Spalt wieder abgeführt werden kann. Der Strömungsquerschnitt des Spalts sollte in der Regel zumindest dem Strömungsquerschnitt des Fluids in der flexiblen Fluidleitung entsprechen.

Bei einer weiteren Ausführungsform weist der Führungskanal mindestens einen abgerundeten Abschnitt zur Richtungsänderung der flexiblen Fluidleitung auf. In der Regel verlaufen die Strukturen, die von dem Hohlraum in dem Werkstück abzweigen, nicht parallel zu der Richtung, entlang derer das Einlegebauteil in das Werkstück eingelegt bzw. eingeführt wird. Geht der jeweilige Führungskanal von der Stirnseite des Einlegebauteils aus, ist es daher in der Regel erforderlich, die Richtung der flexiblen Fluidleitung innerhalb des Einlegebauteils zu ändern. Eine solche Richtungsänderung erfolgt idealerweise durch die Führung der Fluidleitung entlang eines abgerundeten bzw. gekrümmten Abschnitts des Führungskanals. An dem abgerundeten Abschnitt erfolgt bevorzugt eine Richtungsänderung der flexiblen Fluidleitung unter einem stumpfen Winkel, d.h. unter einem Winkel, der größer als 90° ist.

Bei einer weiteren Ausführungsform ist das Einlegebauteil stabförmig und der mindestens eine Führungskanal erstreckt sich von einer Stirnseite des Einlegebauteils zu einer Mantelfläche des Einlegebauteils. In diesem Fall handelt es sich bei dem Hohlraum in dem Werkstück typischerweise um einen geradlinigen Kanal, der bevorzugt einen konstanten Durchmesser aufweist und der sich ausgehend von einer Öffnung an einer Seite des Werkstücks in das Volumen des Werkstücks hinein erstreckt. Das Einlegebauteil wird in diesem Fall in den Hohlraum eingelegt, indem dieses durch die Öffnung des Werkstücks in den Hohlraum eingeschoben wird. Die Stirnseite des Einlegebauteils ist hierbei durch die Öffnung in dem Werkstück von außen zugänglich, sodass die flexiblen Fluidleitungen an der Stirnseite des Einlegebauteils von dem Werkstück weggeführt und mit einer Bereitstellungseinrichtung für das Fluid, die eine Pumpe oder dergleichen aufweist, verbunden werden können. Mit Hilfe des weiter oben beschriebenen abgerundeten Abschnitts des Führungskanals kann eine jeweilige flexible Fluidleitung von der Stirnseite des Einlegebauteils zur Mantelfläche des Einlegebauteils geführt werden.

Bei einer Weiterbildung dieser Ausführungsform münden die Führungskanäle an der Mantelseite des Einlegebauteils in Öffnungen, die bevorzugt in Längsrichtung des Einlegebauteils nebeneinander angeordnet sind und die insbesondere in Längsrichtung des Einlegebauteils in gleichen Abständen zueinander angeordnet sind. Unter einer Anordnung der Öffnungen in Längsrichtung des Einlegebauteils nebeneinander wird verstanden, dass die Öffnungen entlang einer gemeinsamen Geraden bzw. Linie verlaufen, die sich in Längsrichtung des Einlegebauteils erstreckt. Mit anderen Worten sind die Öffnungen nicht in Umfangsrichtung des Einlegebauteils zueinander versetzt. Dies ist günstig, wenn eine Mehrzahl von Strukturen, die entlang einer gemeinsamen Linie von dem Hohlraum abzweigen, durch Multi-Photonen-Laserablation hergestellt werden soll. Falls die zu bildenden Strukturen in gleichen Abständen voneinander angeordnet sind, sind auch die Öffnungen in Längsrichtung des Einlegebauteils äquidistant, d.h. in gleichen Abständen voneinander, angeordnet.

Bei einer Weiterbildung dieser Ausführungsform ist das stabförmige Einlegebauteil kreis-zylindrisch ausgebildet ist und weist bevorzugt einen Durchmesser zwischen 5 mm und 10 mm auf. Die Geometrie des Einlegebauteils ist an die Geometrie des Hohlraums angepasst, der in diesem Fall ebenfalls kreis-zylindrisch ausgebildet ist. Der Durchmesser des Hohlraums ist geringfügig größer als der Durchmesser des Einlegebauteils. Ein zylindrischer Hohlraum, der einen vergleichsweise großen Durchmesser aufweist, kann durch mechanische Bearbeitung, z.B. durch Schleifen, hergestellt werden und beispielsweise als Sackbohrung ausgebildet sein. Das Einlegebauteil wird in diesem Fall typischerweise in den zylindrischen Hohlraum eingeschoben, bis dieses an der Stirnseite des Hohlraums anliegt. Auf diese Weise wird die Position der Öffnungen in Längsrichtung des Einlegebauteils festgelegt. Das Einlegebauteil wird zusätzlich so ausgerichtet bzw. gedreht, dass die Öffnungen in der Mantelfläche des Einlegebauteils in Umfangsrichtung so positioniert sind, dass diese mit den Stellen übereinstimmen, von denen die Strukturen ausgehen sollen, die von dem Hohlraum abzweigen. Des Weiteren kann die Stirnfläche des Einlegebauteils einen überstehenden Abschnitt, d.h. eine Feder, aufweisen, der in eine Kerbe bzw. eine Nut im Werkstück einrastet, um die axiale Positionierung zu erleichtern, was dem Schlüssel-Schloss-Prinzip entspricht. Es ist möglich, vor dem Einlegen des Einlegebauteils einen Abstandshalter z.B. in Form eines Vollzylinders in den Hohlraum einzuführen, mit dessen Stirnseite das Einlegebauteil in Kontakt gebracht wird. Auf diese Weise kann die Länge des Einlegebauteils reduziert werden.

Bei einer weiteren Ausführungsform weist der mindestens eine Führungskanal einen Innen-Durchmesser zwischen 1 mm und 4 mm auf. Die Strukturen, die von dem Hohlraum ausgehen, weisen in der Regel einen deutlich geringeren Durchmesser auf als das Einlegebauteil. Dies ist günstig, da auf diese Weise in dem Einlegebauteil mehrere Führungskanäle untergebracht werden können, die innerhalb des Einlegebauteils verlaufen.

Bei einer weiteren Ausführungsform weist die mindestens eine Fluidleitung einen Außendurchmesser von 1 mm oder weniger auf. Wie weiter oben beschrieben wurde, ist es in der Regel erforderlich, dass zwischen der Fluidleitung und der Wand eines jeweiligen Führungskanals ein Spalt für die Rückführung des Fluids verbleibt. Der Außendurchmesser der Fluidleitung ist daher entsprechend geringer als der Innen-Durchmesser des Führungskanals.

Das Einlegebauteil kann auf unterschiedliche Weise ausgebildet sein. Beispielsweise können die Führungskanäle als Rohre, beispielsweise als Edelstahlrohre oder als Kunststoffrohre, ausgebildet sein, die gebogen werden bzw. gebogen sind, um den oder die abgerundeten Abschnitte zu bilden. Die Führungskanäle in Form der Rohre, z.B. der Edelstahlrohre oder der Kunststoffrohre, können gebündelt werden und z.B. in ein geeignetes Material eingegossen werden, um ein Einlegebauteil mit einer gewünschten Geometrie, z.B. in der Art eines Zylinders, herzustellen.

Alternativ kann das Einlegebauteil durch ein additives Fertigungsverfahren hergestellt werden. In diesem Fall besteht das Einlegebauteil typischerweise aus einem im 3D-Druckverfahren hergestellten Körper, bei dem die Führungskanäle in Form von Hohlstrukturen bei der additiven Fertigung gebildet werden. Für die Herstellung des Einlegebauteils können die bei 3D-Druck typischen Metalle, Kunststoffe oder sogar glasartige Materialien verwendet werden.

Bei einer weiteren Ausführungsform umfasst die Fluidzuführungsvorrichtung eine Fluidbereitstellungseinrichtung zur Zuführung des Fluids zu der mindestens einen flexiblen Fluidleitung. Die Fluidbereitstellungseinrichtung kann zur Bereitstellung des Fluids ein Fluidreservoir aufweisen. Wie weiter oben beschrieben wurde, ist es typischerweise günstig, das Fluid mit einem vergleichsweise großen Druck aus der Fluidleitung austreten zu lassen. Es ist daher günstig, der flexiblen Fluidleitung das Fluid mit Hilfe einer Pumpe zuzuführen, die einen entsprechend großen Druck erzeugt und die Teil der Fluidbereitstellungseinrichtung ist.

Bei einer weiteren Ausführungsform umfasst die Fluidzuführungsvorrichtung mindestens eine Nachführungseinrichtung zur automatisierten Nachführung der mindestens einen flexiblen Fluidleitung bei einer Bewegung der Abtragsfront im Material des Werkstücks. Die Abtragsfront bewegt sich bei der Multi-Photonen-Laserablation typischerweise mit einer konstanten BearbeitungsGeschwindigkeit innerhalb des Volumens des Werkstücks. Die automatisierte Nachführung der flexiblen Fluidleitung erfolgt ebenfalls mit der BearbeitungsGeschwindigkeit. Für die Nachführung wird die flexible Fluidleitung nachgeschoben, beispielsweise indem diese mit einer konstanten Geschwindigkeit von einer Spule oder dergleichen abgewickelt wird. Für das Nachführen der flexiblen Fluidleitung ist es in der Regel erforderlich, dass das Material der Fluidleitung eine ausreichende Schubsteifigkeit aufweist, was aber bei den für flexible Fluidleitungen verwendeten Materialien typischerweise der Fall ist. Für den Fall, dass die Abtragsfronten sich mit unterschiedlichen Bearbeitungs-Geschwindigkeiten in dem Material des Werkstücks bewegen, kann die Nachführungseinrichtung ausgebildet sein, die Fluidleitungen mit einer individuell angepassten Geschwindigkeit nachzuführen.

Ein weiterer Aspekt der Erfindung betrifft ein Verfahren zum Zuführen eines Fluids zu mindestens einer Abtragsfront beim Abtragen von Material von einem Werkstück durch Multi-Photonen-Laserablation, bevorzugt von einem insbesondere monolithischen Substrat für einen EUV-Spiegel, mittels einer Fluidzuführungsvorrichtung, die wie weiter oben beschrieben ausgebildet ist, wobei das Verfahren umfasst: Einlegen des Einlegebauteils in einen Hohlraum des Werkstücks, sowie Zuführen des Fluids zu der mindestens einen Abtragsfront durch die mindestens eine flexible Fluidleitung, die in dem mindestens einen Führungskanal des Einlegebauteils geführt ist. Wie weiter oben beschrieben wurde, kann mit Hilfe einer Fluidzuführungsvorrichtung, die wie weiter oben beschrieben ausgebildet ist, die flexible Fluidleitung automatisiert der Abtragsfront nachgeführt werden, wenn diese sich durch das Werkstück bewegt.

Bei einer Variante wird vor dem Einlegen des Einlegebauteils der Hohlraum mit einer Fluid gefüllt und ausgehend von dem mit dem Fluid gefüllten Hohlraum wird durch Multi-Photonen-Laserablation eine Mehrzahl von an den Hohlraum angrenzenden Kanalabschnitten gebildet. Für die Herstellung von vergleichsweise kurzen Abschnitten von Kanälen oder von anderen Strukturen, die von dem Hohlraum ausgehen bzw. abzweigen, wird typischerweise keine lokale Zuführung eine Fluids zu der Abtragsfront mit Hilfe einer flexiblen Fluidleitung benötigt: Bei einer Länge des Kanalabschnitts, die in der Regel in der Größenordnung von nicht mehr als ca. 20-40 mm liegt, ist es ausreichend, wenn der Hohlraum als Ganzes - und damit auch die bei der Multi-Photonen-Absorption gebildeten Kanalabschnitte - mit einem Fluid gefüllt werden. Typischerweise wird zu diesem Zweck mit dem Fluid das Werkstück teilweise in eine Flüssigkeit bzw. in ein Flüssigkeitsbad, üblicherweise in ein Wasserbad, eingetaucht.

Bei einer Weiterbildung dieser Variante werden nach dem Einlegen des Einlegebauteils in den Hohlraum ausgehend von den Stirnseiten der Kanalabschnitte eine Mehrzahl von Abtragsfronten erzeugt und im Material des Werkstücks bewegt, um eine Mehrzahl von Kanälen zu erzeugen, wobei die Mehrzahl der flexiblen Fluidleitungen bei der Bewegung der Abtragsfronten im Material des Werkstücks nachgeführt werden.

Für den Fall, dass es sich bei dem Werkstück um ein Substrat für einen EUV-Spiegel handelt, kann dieses beispielsweise zwei Hohlräume aufweisen, die als Fluidverteiler und als Fluidsammler dienen und in die jeweils ein Einlegebauteil eingelegt wird. Die beiden Hohlräume werden durch eine Mehrzahl von Kanälen, die von dem ersten Hohlraum abzweigen und in dem zweiten Hohlraum münden, fluidisch miteinander verbunden. Ausgehend von jeweils einem der beiden Hohlräume kann hierbei jeweils ein erster bzw. zweiter Kanalabschnitt, der etwa die Hälfte der Länge eines jeweiligen Kanals entspricht, durch Multi-Photonen-Laserablation hergestellt werden. Ungefähr in der Mitte der Länge des Kanals kommt es bei der Herstellung zu einer Überlappung der Abtragsfronten der beiden Kanalabschnitte, wodurch ein durchgehender Kanal entsteht, der den Fluidverteiler mit dem Fluidsammler verbindet.

Für den Fall, dass es sich bei den Kanälen um Kühlkanäle bzw. um Kühlstrukturen für einen EUV-Spiegel handelt, verlaufen diese typischerweise nicht geradlinig zwischen dem Fluidverteiler und dem Fluidsammler, sondern sind abgewinkelt und weisen in der Regel einen Verteilerkanal auf, in dem das Fluid ausgehend von dem Fluidverteiler, der einen vergleichsweise großen Abstand zur optischen Oberfläche des EUV-Spiegels aufweist, in die Nähe der Oberfläche transportiert wird. In einem Kanalabschnitt, der einen Kühlkanal bildet, wird das Fluid, typischerweise in Form von Kühlwasser, an der Oberfläche entlanggeführt, bevor das Fluid in einem Sammlerkanal von der Oberfläche weggeführt und dem Fluidsammler zugeführt wird.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

### Zeichnung

Ausführungsbeispiele sind in der schematischen Zeichnung dargestellt und werden in der nachfolgenden Beschreibung erläutert. Es zeigt
- Fig. 1: schematisch im Meridionalschnitt eine Projektionsbelichtungsanlage für die EUV-Projektionslithografie,
- Fig. 2a,b: schematische Darstellungen von EUV-Spiegeln mit einem Substrat, in das eine Hohlstruktur in Form eines Kühlkanals eingebracht ist,
- Fig. 3: eine schematische Darstellung einer Vorrichtung zur Erzeugung der Hohlstruktur von Fig. 2a durch materialabtragende Bearbeitung des Substrats mittels gepulster Laserstrahlung beim Bilden einer Hinterschneidung,
- Fig. 4a-c: eine schematische Darstellung einer Draufsicht und einer Seitenansicht eines Bewegungsmusters mit in Einstrahlungsrichtung der gepulsten Laserstrahlung auf das Substrat zueinander versetzten Bewegungsbahnen sowie die Erzeugung einer schräg ausgerichteten Abtragsfront mit Hilfe der Vorrichtung von Fig. 3,
- Fig. 5a: eine schematische Darstellung einer Draufsicht eines Bewegungsmusters mit zueinander versetzten Bewegungsbahnen, die bei der Fokussierung der gepulsten Laserstrahlung mit einer unterschiedlichen Pulsenergie erzeugt werden,
- Fig. 5b: eine schematische Schnittdarstellung des Substrats mit einer schrägen Abtragsfront, die bei der Fokussierung der gepulsten Laserstrahlung in einer Fokusebene mit dem in Fig. 5a gezeigten Ablationsmuster mit unterschiedlicher Pulsenergie erzeugt wird,
- Fig. 6a-c: schematische Darstellungen analog zu Fig. 3 bei drei unterschiedlichen Phasen der Erzeugung der Hohlstruktur sowie mit einer Fluidzuführung, die eine Düse bzw. einen flexiblen Schlauch aufweist,
- Fig. 7a-c: zwei Prozessschritte bei der Erzeugung einer Hohlstruktur in Form eines durchgehenden Kühlkanals sowie eines hierbei gebildeten Nahtbereichs,
- Fig. 8a,b: schematische Schnittdarstellungen eines Spiegels der Projektionsbelichtungsanlage von Fig. 1 mit einer Hohlstruktur, die eine Mehrzahl von Temperierkanälen in Form von Kühlkanälen aufweist, deren Endabschnitte über abgerundete Abschnitte in Verteilerkanäle bzw. in Sammlerkanäle übergehen,
- Fig. 9a-d: schematische Darstellungen eines abgerundeten Abschnitts zwischen einem Verteilerkanal und einem Endabschnitt eines Kühlkanals mit jeweils identischem Strömungs-Durchmesser bei vier unterschiedlichen Krümmungsradien,
- Fig. 10a-d: schematische Darstellungen eines abgerundeten Abschnitts zwischen einem Sammlerkanal und einem Endabschnitt eines Kühlkanals mit jeweils identischem Strömungs-Durchmesser bei vier unterschiedlichen Krümmungsradien,
- Fig. 11a: eine perspektivische Darstellung eines Substrats für einen EUV-Spiegel mit einer Hohlstruktur analog zu Fig. 8a,b, bei dem die Endabschnitte der Kühlkanäle unter einem stumpfen Winkel zu den Verteilerkanälen bzw. zu den Sammlerkanälen ausgerichtet sind,
- Fig. 11b: eine schematische Darstellung eines abgerundeten Abschnitts am Übergang zwischen einem Endabschnitt eines Kühlkanals und einem Verteilerkanal,
- Fig. 12a-d: Darstellungen eines Substrats für einen EUV-Spiegel mit einer Hohlstruktur analog zu Fig. 8a,b, bei dem die Verteilerkanäle bzw. die Sammlerkanäle unter einem stumpfen Winkel zu einem Einlasskanal bzw. zu einem Auslasskanal ausgerichtet sind und an einem abgerundeten Abschnitt in den Einlasskanal bzw. in den Auslasskanal münden,
- Fig. 13a,b: schematische Schnittdarstellungen eines Spiegels der Projektionsbelichtungsanlage von Fig. 1 mit einer Hohlstruktur, die eine Mehrzahl von Kühlkanälen aufweist,
- Fig. 13c: eine schematische Darstellung des Spiegels von Fig. 13a,b bei der Herstellung der Hohlstruktur unter Verwendung einer Fluidzuführungsvorrichtung mit zwei unterschiedlichen Einlegebauteilen,
- Fig. 14a-c: schematische Darstellungen eines ersten Beispiels der Fluidzuführungsvorrichtung mit einem Einlegebauteil mit mehreren Führungskanälen in Form von gebogenen Rohren zur Führung von flexiblen Fluidleitungen, sowie
- Fig. 15a,b: schematische Darstellungen eines zweiten Beispiels der Fluidzuführungseinrichtung, bei der das Einlegebauteil durch additive Fertigung hergestellt wurde.

In der folgenden Beschreibung der Zeichnungen werden für gleiche bzw. funktionsgleiche Bauteile identische Bezugszeichen verwendet.

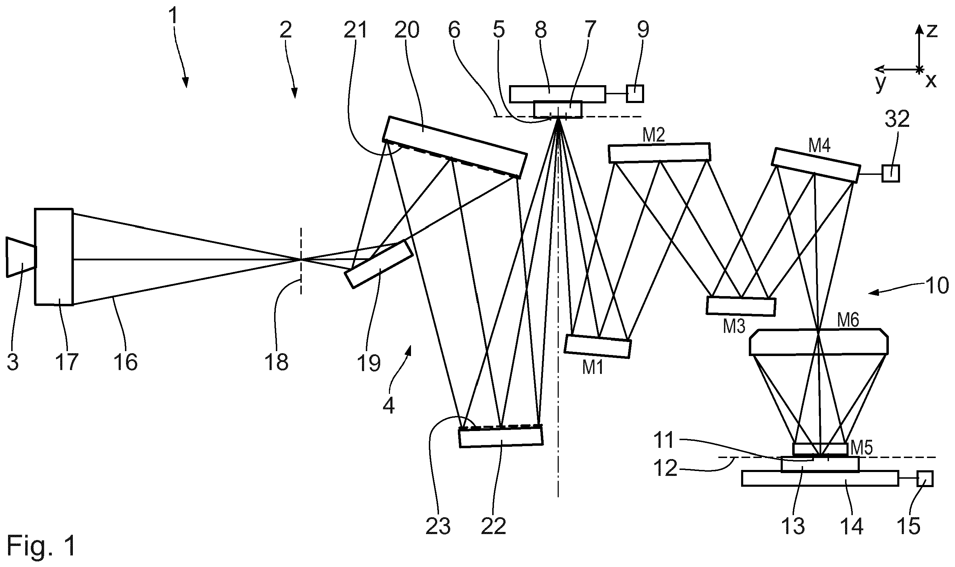

Im Folgenden werden unter Bezugnahme auf Fig. 1 exemplarisch die wesentlichen Bestandteile einer optischen Anordnung für die EUV-Lithographie in Form einer Projektionsbelichtungsanlage 1 für die Mikrolithographie beschrieben. Die Beschreibung des grundsätzlichen Aufbaus der Projektionsbelichtungsanlage 1 sowie von deren Bestandteilen ist hierbei nicht einschränkend zu verstehen.

Eine Ausführung eines Beleuchtungssystem 2 der Projektionsbelichtungsanlage 1 hat neben einer Licht- bzw. Strahlungsquelle 3 eine Beleuchtungsoptik 4 zur Beleuchtung eines Objektfeldes 5 in einer Objektebene 6. Bei einer alternativen Ausführung kann die Lichtquelle 3 auch als ein zum sonstigen Beleuchtungssystem separates Modul bereitgestellt sein. In diesem Fall umfasst das Beleuchtungssystem die Lichtquelle 3 nicht.

Beleuchtet wird ein im Objektfeld 5 angeordnetes Retikel 7. Das Retikel 7 ist von einem Retikelhalter 8 gehalten. Der Retikelhalter 8 ist über einen Retikelverlagerungsantrieb 9 insbesondere in einer Scanrichtung verlagerbar.

In Fig. 1 ist zur Erläuterung ein kartesisches xyz-Koordinatensystem eingezeichnet. Die x-Richtung verläuft senkrecht zur Zeichenebene hinein. Die y-Richtung verläuft horizontal und die z-Richtung verläuft vertikal. Die Scanrichtung verläuft in der Fig. 1 längs der y-Richtung. Die z-Richtung verläuft senkrecht zur Objektebene 6.

Die Projektionsbelichtungsanlage 1 umfasst ein Projektionssystem 10. Das Projektionssystem 10 dient zur Abbildung des Objektfeldes 5 in ein Bildfeld 11 in einer Bildebene 12. Abgebildet wird eine Struktur auf dem Retikel 7 auf eine lichtempfindliche Schicht eines im Bereich des Bildfeldes 11 in der Bildebene 12 angeordneten Wafers 13. Der Wafer 13 wird von einem Waferhalter 14 gehalten. Der Waferhalter 14 ist über einen Waferverlagerungsantrieb 15 insbesondere längs der y-Richtung verlagerbar. Die Verlagerung einerseits des Retikels 7 über den Retikelverlagerungsantrieb 9 und andererseits des Wafers 13 über den Waferverlagerungsantrieb 15 kann synchronisiert zueinander erfolgen.

Bei der Strahlungsquelle 3 handelt es sich um eine EUV-Strahlungsquelle. Die Strahlungsquelle 3 emittiert insbesondere EUV-Strahlung 16, welche im Folgenden auch als Nutzstrahlung, Beleuchtungsstrahlung oder Beleuchtungslicht bezeichnet wird. Die Nutzstrahlung hat insbesondere eine Wellenlänge im Bereich zwischen 5 nm und 30 nm. Bei der Strahlungsquelle 3 kann es sich um eine Plasmaquelle handeln, zum Beispiel um eine LPP-Quelle, d.h. eine Laser-Produced-Plasma-Quelle, oder um eine DPP-Quelle, d.h. eine Gas-Discharged-Produced-Plasma Quelle. Es kann sich auch um eine synchrotronbasierte Strahlungsquelle handeln. Bei der Strahlungsquelle 3 kann es sich um einen Freie-Elektronen-Laser handeln, der auch als Free-Electron-Laser, FEL, bezeichnet wird.

Die Beleuchtungsstrahlung 16, die von der Strahlungsquelle 3 ausgeht, wird von einem Kollektorspiegel 17 gebündelt. Bei dem Kollektorspiegel 17 kann es sich um einen Kollektorspiegel mit einer oder mit mehreren ellipsoidalen und/oder hyperboloiden Reflexionsflächen handeln. Die mindestens eine Reflexionsfläche des Kollektorspiegels 17 kann im streifenden Einfall, auch als Grazing Incidence, GI, bezeichnet, also mit Einfallswinkeln größer als 45°, oder im normalen Einfall, auch als Normal Incidence, NI, bezeichnet, also mit Einfallwinkeln kleiner als 45°, mit der Beleuchtungsstrahlung 16 beaufschlagt werden. Der Kollektorspiegel 17 kann einerseits zur Optimierung seiner Reflektivität für die Nutzstrahlung und andererseits zur Unterdrückung von Falschlicht strukturiert und/oder beschichtet sein.

Nach dem Kollektorspiegel 17 propagiert die Beleuchtungsstrahlung 16 durch einen Zwischenfokus in einer Zwischenfokusebene 18. Die

Zwischenfokusebene 18 kann eine Trennung zwischen einem Strahlungsquellenmodul, aufweisend die Strahlungsquelle 3 und den Kollektorspiegel 17, und der Beleuchtungsoptik 4 darstellen.

Die Beleuchtungsoptik 4 umfasst einen Umlenkspiegel 19 und diesem im Strahlengang nachgeordnet einen ersten Facettenspiegel 20. Bei dem Umlenkspiegel 19 kann es sich um einen planen Umlenkspiegel oder alternativ um einen Spiegel mit einer über die reine Umlenkungswirkung hinaus bündelbeeinflussenden Wirkung handeln. Alternativ oder zusätzlich kann der Umlenkspiegel 19 als Spektralfilter ausgeführt sein, der eine Nutzlichtwellenlänge der Beleuchtungsstrahlung 16 von Falschlicht einer hiervon abweichenden Wellenlänge trennt. Der erste Facettenspiegel 20 umfasst eine Vielzahl von einzelnen ersten Facetten 21, welche im Folgenden auch als Feldfacetten bezeichnet werden. Von diesen Facetten 21 sind in der Fig. 1 nur beispielhaft einige dargestellt. Im Strahlengang der Beleuchtungsoptik 4 ist dem ersten Facettenspiegel 20 nachgeordnet ein zweiter Facettenspiegel 22. Der zweite Facettenspiegel 22 umfasst eine Mehrzahl von zweiten Facetten 23.

Die Beleuchtungsoptik 4 bildet somit ein doppelt facettiertes System. Dieses grundlegende Prinzip wird auch als Wabenkondensor oder Fly's Eye Integrator bezeichnet. Mit Hilfe des zweiten Facettenspiegels 22 werden die einzelnen ersten Facetten 21 in das Objektfeld 5 abgebildet. Der zweite Facettenspiegel 22 ist der letzte bündelformende oder auch tatsächlich der letzte Spiegel für die Beleuchtungsstrahlung 16 im Strahlengang vor dem Objektfeld 5.

Das Projektionssystem 10 umfasst eine Mehrzahl von Spiegeln Mi, welche gemäß ihrer Anordnung im Strahlengang der Projektionsbelichtungsanlage 1 durchnummeriert sind.

Bei dem in der Fig. 1 dargestellten Beispiel umfasst das Projektionssystem 10 sechs Spiegel M1 bis M6. Alternativen mit vier, acht, zehn, zwölf oder einer anderen Anzahl an Spiegeln Mi sind ebenso möglich. Der vorletzte Spiegel M5 und der letzte Spiegel M6 haben jeweils eine Durchtrittsöffnung für die Beleuchtungsstrahlung 16. Bei dem Projektionssystem 10 handelt es sich um eine doppelt obskurierte Optik. Die Projektionsoptik 10 hat eine bildseitige numerische Apertur, die größer ist als 0,4 oder 0,5 und die auch größer sein kann als 0,6 und die beispielsweise 0,7 oder 0,75 betragen kann.

Die Spiegel Mi können, genauso wie die Spiegel der Beleuchtungsoptik 4, eine hoch reflektierende Beschichtung für die Beleuchtungsstrahlung 16 aufweisen.

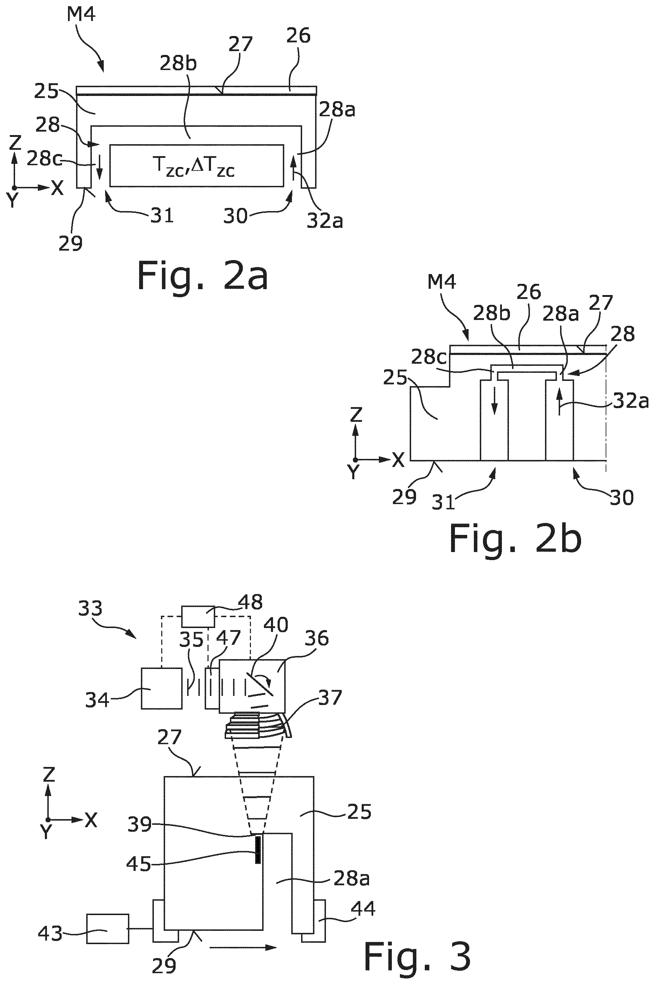

Fig. 2a,b zeigen beispielhaft einen Spiegel M4 des Projektionssystems 10, der ein Substrat 25 aufweist, das eine Oberfläche 27 aufweist, auf die eine reflektierende Beschichtung 26 aufgebracht ist. Im gezeigten Beispiel handelt es sich bei dem Material des Substrats 25 um titandotiertes Quarzglas mit einem sehr geringen Wärmeausdehnungskoeffizienten. Das Substrat 25 kann auch aus einem anderen Material gebildet sein, das einen möglichst niedrigen thermischen Ausdehnungskoeffizienten aufweist, beispielsweise aus einer Glaskeramik. Bei diesen Materialien handelt es sich um Nullausdehnungsmaterialien, die Komponenten bzw. Phasen mit positivem und negativem Wärmeausdehnungskoeffizienten gegeneinander ausspielen. Bei diesen Materialien gibt es genau einen Temperaturwert, bei dem die Wärmeausdehnung verschwindet bzw. am unempfindlichsten gegen Temperaturänderungen ist, und zwar die sogenannte Nulldurchgangstemperatur T_{ZC}, die auch als "zero crossing temperature", ZCT, bezeichnet wird. Im hier beschriebenen Beispiel weist das Material des Substrats 25, bei dem es sich um titandotiertes Quarzglas mit einem sehr geringen Wärmeausdehnungskoeffizienten handelt, eine Nulldurchgangstemperatur T_{ZC} auf, die zwischen 0°C und 100°C, typischerweise zwischen 19°C und 40°C, insbesondere zwischen 19°C und 32°C, liegt. Die Nulldurchgangstemperatur T_{ZC} ist im Volumen des Substrats 25 im Wesentlichen konstant und weist eine räumliche Variation auf, die bei weniger als 3 K, bei weniger als 2 K, bei weniger als 1 K, oder bei weniger als 0,1 K liegt, wobei die räumliche Variation die Differenz zwischen maximaler und minimaler Nulldurchgangstemperatur T_{ZC} bezeichnet.

Das Substrat 25 ist im gezeigten Beispiel monolithisch ausgebildet. Die reflektierende Beschichtung 26 weist im gezeigten Beispiel eine Mehrzahl von Schichtpaaren aus Materialien mit jeweils unterschiedlichem Realteil des Brechungsindexes auf, die bei einer Wellenlänge der EUV-Strahlung 16 von 13,5 nm beispielsweise aus Si und Mo gebildet sein können. Die Oberfläche 27 des Substrats 25 ist in Fig. 2a,b als plane Fläche dargestellt, diese kann aber auch eine Krümmung aufweisen.

Bei dem in Fig. 2a,b gezeigten Beispiel weist das Substrat 25 eine durchgehende Hohlstruktur 28 in Form eines Kanals auf, der mit einem in durch einen Pfeil angedeuteten Kühlmittel in Form eines Temperierfluids, im vorliegenden Fall eines Kühlfluids 32a, durchströmbar ist, bei dem es sich im hier beschriebenen Beispiel um Wasser handelt. Die Hohlstruktur 28 wird daher nachfolgend auch gelegentlich als Kühlkanal bezeichnet. Es versteht sich, dass die Hohlstruktur 28 auch mit einem Heizfluid durchströmbar ist, um das Substrat 25 zu erwärmen. Der Kühlkanal 28 weist einen ersten Abschnitt 28a auf, der sich ausgehend von einem Kühlmitteleinlass 30, der an einer Rückseite 29 des Substrats 25 gebildet ist, in vertikaler Richtung, d.h. in Z-Richtung eines XYZ-Koordinatensystems, erstreckt. Die vertikale Richtung Z entspricht der Dickenrichtung Z des Substrats 25. Die Oberseite 27 und die Unterseite 29 des Substrats 25 sind im hier beschriebenen Beispiel jeweils senkrecht zur Dickenrichtung Z ausgerichtet.

An den ersten, vertikalen Abschnitt 28a des Kühlkanals 28 schließt sich ein horizontal, d.h. in X-Richtung, verlaufender Abschnitt 28b an, durch den das Kühlmittel 33 in einen dritten, vertikal verlaufenden Abschnitt 28c des Kühlkanals 28 strömt, der in einem Kühlmittelauslass 31 an der Rückseite 29 des Substrats 25 mündet. Die in Fig. 2a gezeigte Hohlstruktur 28 in Form des Kühlkanals weist mit Ausnahme der beiden Übergänge zwischen dem jeweiligen vertikalen Abschnitt 28a, 28c und dem horizontalen Abschnitt 28b einen runden Querschnitt mit konstantem Durchmesser auf, der im gezeigten Beispiel in der Größenordnung von ca. 1-5 mm liegt. Der in Fig. 2b gezeigte durchgehende Kühlkanal 28 unterscheidet sich von dem in Fig. 2a gezeigten durchgehenden Kühlkanal 28 dadurch, dass jeweils ein Teil der vertikalen Abschnitte 28a,c, die von dem Kühlmitteleinlass 30 bzw. von dem Kühlmittelauslass 31 ausgehen, einen größeren Durchmesser aufweisen als der horizontale Abschnitt 28b und ein kurzer Teil der vertikalen Abschnitte 28a,c, die sich am Übergang zum horizontalen Abschnitt 28c des Kühlkanals 28 befinden.

Für die Zuführung des Kühlmittels 32a zu dem Kühlmitteleinlass 30 sowie für das Abführen des Kühlmittels 32a von dem Kühlmittelauslass 31 weist die Projektionsbelichtungsanlage 1 eine Kühleinrichtung 32 auf, die schematisch in Fig. 1 dargestellt ist. Die Kühleinrichtung 32 dient im gezeigten Beispiel zur Zuführung eines Kühlmittels 32a in Form von Kühlwasser zu den Kühlkanal 28 bzw. zu dem Spiegel M4 und weist zu diesem Zweck eine nicht bildlich dargestellte Zuführungsleitung auf, die mit dem Kühlmitteleinlass 30 fluiddicht verbunden ist. Die Kühleinrichtung 32 weist auch eine nicht bildlich dargestellte Abführungsleitung auf, um das Kühlwasser 32a von dem Kühlmittelauslass 31 abzuführen. Auch die anderen Spiegel M1-M3, M5, M6 des Projektionssystems 10 können eine Hohlstruktur 28 aufweisen, die zur Kühlung mit der Kühleinrichtung 32 oder ggf. mit weiteren zu diesem Zweck vorgesehenen Kühleinrichtungen verbunden werden. Es versteht sich, dass grundsätzlich beliebige Spiegel eine Hohlstruktur 28 aufweisen können, die mit einem Kühlmittel durchströmt werden kann. Beispielsweise kann es sich hierbei um Spiegel handeln, die zur Reflexion von Strahlung im DUV/VUV-Wellenlängenbereich, im sichtbaren Wellenlängenbereich und/oder im Infrarot-Wellenlängenbereich ausgebildet sind. Anstelle einer Kühleinrichtung 32 kann auch eine Temperiereinrichtung in der Projektionsbelichtungsanlage 1 vorgesehen sein, d.h. eine Einrichtung, die zum Kühlen und/oder zum Heizen der Spiegel M1-M6 verwendet wird. Für das Heizen kann ein geeignetes Temperierfluid 32a verwendet werden, beispielsweise Wasser, das auf eine gewünschte Temperatur erwärmt wird, bevor dieses der Hohlstruktur 28 zugeführt wird.

Zur Erzeugung des in Fig. 2a gezeigten Kühlkanals 28 dient eine Vorrichtung 33, die schematisch in Fig. 3 dargestellt ist. Die Vorrichtung 33 weist eine Laserquelle 34 auf, die zur Erzeugung von gepulster Laserstrahlung 35 dient, die in Fig. 3 in Form von Strichen dargestellt ist. Bei der Laserquelle 34 handelt es sich um eine Ultrakurzpuls-Laserquelle, die zur Erzeugung von Laserpulsen mit Pulsdauern im Pikosekunden-Bereich, z.B. von weniger als 10 ps, mit Spitzenpulsleistungen im MW-Bereich ausgebildet ist. Die Laserquelle 34 ist ausgebildet, die gepulste Laserstrahlung 35 bei einer Wellenlänge im nahen Infrarot-Wellenlängenbereich zu erzeugen, genauer gesagt bei 1030 nm. Es ist aber auch möglich, dass die Laserquelle 34 ausgebildet ist, die gepulste Laserstrahlung 35 bei einer Wellenlänge im sichtbaren Wellenlängenbereich oder bei einer anderen Wellenlänge im nahen Infrarot-Wellenlängenbereich zu erzeugen, für die das Material des Substrats 25 transparent ist.

Die Vorrichtung 33 weist auch eine Scanneroptik 36 und eine Fokussiereinrichtung 37 auf. Die Fokussiereinrichtung 37 ist im gezeigten Beispiel als F-Theta-Objektiv ausgebildet und dient zur Fokussierung der gepulsten Laserstrahlung in Form eines gepulsten Laserstrahls in einem Fokusbereich 39 innerhalb des Substrats 25. Die Scanneroptik 36 dient zur Einstrahlung der gepulsten Laserstrahlung 35 auf eine Strahleintrittsseite 27 des Substrats 25 in einer Einstrahlungsrichtung Z, die senkrecht zur Strahleintrittsseite 27 ausgerichtet ist, sowie zum Bewegen des Fokusbereichs 39 innerhalb des Substrats 25 und weist zu diesem Zweck einen in zwei Richtungen verkippbaren Galvanometer-Spiegel 40 auf. Anstelle eines Galvanometer-Spiegels 40 können auch zwei Galvanometer-Spiegel in der Scanneroptik 36 angeordnet sein, die jeweils in einer Richtung verkippbar sind. Auch die Verwendung von anderen Spiegeln als Galvanometer-Spiegeln, beispielsweise von piezoelektrischen Spiegeln, ist möglich.

Wie weiter oben beschrieben wurde, kann durch das Verkippen des Spiegels 40 der Fokusbereich 39 in dem Substrat 25 bewegt werden. Aufgrund des F-Theta-Objektivs 37, das eine Bildfeldwölbung bei unterschiedlichen Ausrichtungen des Galvanometer-Spiegels 40 korrigiert, wird der Fokusbereich 39 beim Verkippen des Spiegels 40 in einer XY-Ebene senkrecht zur Einstrahlungsrichtung Z bewegt. Die Einstrahlungsrichtung Z der gepulsten Laserstrahlung 35 auf das Substrat 25 stimmt daher im Wesentlichen mit der Dickenrichtung Z des Substrats 25 überein.

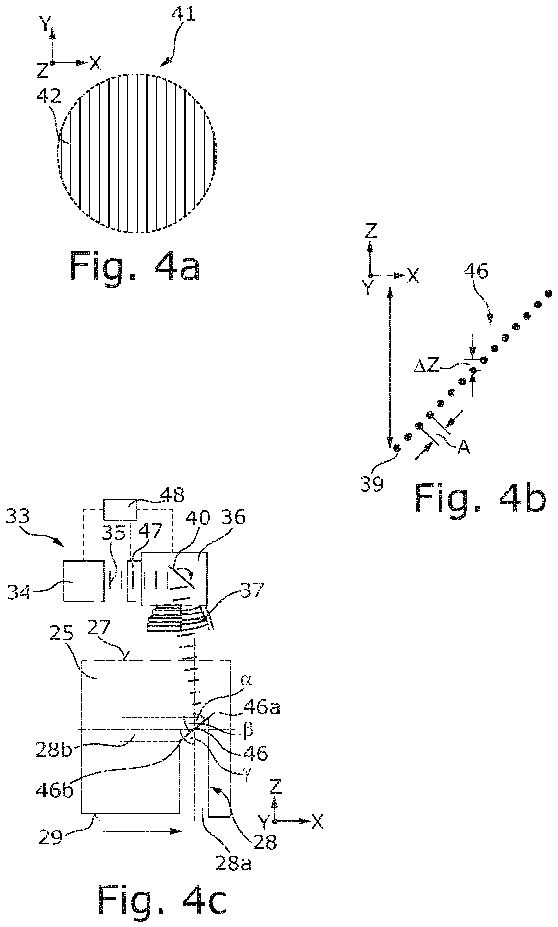

Mit Hilfe der Scanneroptik 36 wird der Fokusbereich 39 entlang eines Ablationsmusters 41 bewegt, das in Fig. 4a in einer Draufsicht gezeigt ist. Das Ablationsmuster 41 weist eine Mehrzahl von parallel ausgerichteten, geradlinigen Bewegungsbahnen 42 auf, die in Y-Richtung verlaufen und die im gezeigten Beispiel in X-Richtung in gleichen Abständen zueinander angeordnet sind. Es ist nicht zwingend erforderlich, dass die Bewegungsbahnen 42 in gleichen Abständen zueinander angeordnet sind, vielmehr können die Abstände zwischen benachbarten Bewegungsbahnen 42 innerhalb des Ablationsmusters 41 auch prozessabhängig variieren.

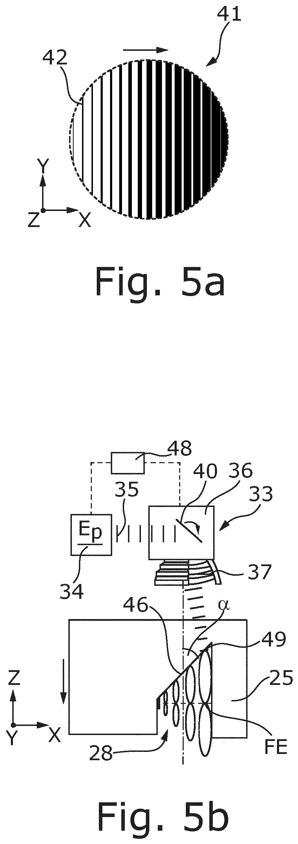

Zur Herstellung des vertikalen Abschnitts 28a des in Fig. 3 gezeigten Kühlkanals wird mit Hilfe der Scanneroptik 36 das in Fig. 4a gezeigte Ablationsmuster 41 in einer XY-Ebene an der Rückseite 29 des unbeschichteten Substrats 25 erzeugt. Mit Hilfe einer in Fig. 3 stark schematisch dargestellten Positioniereinrichtung 43, die auf eine Halterung 44 für das Substrat 25 einwirkt, wird das Substrat 25 in Einstrahlungsrichtung Z der gepulsten Laserstrahlung 35 auf die Strahleintrittsseite 27 des Substrats 25 nach unten verschoben, während die Scanneroptik 36 mehrfach das in Fig. 5a gezeigte Ablationsmuster 41 erzeugt. Ausgehend von der Rückseite 29 des Substrats 25 wird auf diese Weise der in Fig. 3 gezeigte vertikale Abschnitt 28a des Kühlkanals 28 gebildet.

Fig. 3 zeigt den Herstellungsprozess der Hohlstruktur 28 bei der Erzeugung eines Übergangs in Form einer Hinterschneidung mit einem Hinterschneidungswinkel von 90° zwischen dem vertikalen Abschnitt 28a des Kühlkanals 28 und dem horizontalen Abschnitt 28b des Kühlkanals 28. Wird hierbei die gepulste Laserstrahlung 35 am oberen Ende des vertikalen Abschnitts 28a des Kühlkanals seitlich entlanggeführt, wie dies in Fig. 3 angedeutet ist, um Material für die Erzeugung des horizontalen Abschnitts zu entfernen, so führt dies zu einer Wechselwirkung der gepulsten Laserstrahlung 35 mit dem darunterliegenden Material des Substrats 25, die Modifikationen und Verspannungen in dem Material des Substrats 25 induziert, wie dies in Fig. 3 durch eine durchgezogene vertikale Linie 45 angedeutet ist.

Dieses Problem wird dadurch behoben, dass eine Abtragsfront 43 erzeugt wird, die nicht senkrecht zur Einstrahlungsrichtung Z ausgerichtet ist, vgl. Fig. 4c. Bei dem in Fig. 4c gezeigten Beispiel weist die Abtragsfront 43 einen Winkel α von 45° zur Einstrahlungsrichtung Z auf. Der Winkel α zur Einstrahlungsrichtung Z kann aber auch größer oder kleiner sein und beispielsweise in einem Wertebereich zwischen 0° und 89°, 10° und 80°, 20° und 70° oderzwischen 30° und 60° zur Einstrahlungsrichtung Z ausgerichtet sein.

Die Abtragsfront 43 ist in Fig. 4c in Richtung zur Strahlungseintrittsseite 27 des Substrats 25 verkippt, um den horizontalen Abschnitt 28b des Kühlkanals 28 zu erzeugen, der in der Darstellung von Fig. 4c gestrichelt angedeutet ist, weil dieser noch nicht hergestellt worden ist. Wie in Fig. 4c durch einen Pfeil angedeutet ist, wird zur Erzeugung des horizontalen Abschnitts 28b des Kühlkanals 28 das Substrat 25 mit Hilfe der Positioniereinrichtung 43 in X-Richtung verschoben, um entlang der Abtragsfront 46 kontinuierlich Material abzutragen. Wie in Fig. 4c ebenfalls zu erkennen ist, ist die Abtragsfront 46 bei der Bewegung in horizontaler Richtung X an ihrem der Strahlungseintrittsseite 37 des Substrats 25 zugewandten, oberen Rand 46a unter einem Winkel β von 45° zur Bewegungsrichtung der Abtragsfront 46 innerhalb des Substrats 25 ausgerichtet, die der negativen X-Richtung entspricht. Ein der Strahlungseintrittsfläche 37 abgewandter, unterer Rand 46b der Abtragsfront 46 steht bei der Erzeugung des horizontalen Abschnitts 28b der Hohlstruktur 28 weiter in Bewegungsrichtung vor als der obere Rand 46a der Abtragsfront 46. Auf diese Weise grenzt lediglich der untere Rand 46b der Abtragsfront 46 an das Material des Substrats 25, sodass die Wechselwirkung der gepulsten Laserstrahlung 35 mit dem Material des Substrats 25 bei der Erzeugung des horizontalen Abschnitts 28b auf ein Minimum reduziert werden kann. Wie in Fig. 4c ebenfalls zu erkennen ist, tritt die gepulste Laserstrahlung 35 nach dem Eintritt an der Strahlungseintrittsfläche 27 im Bereich der Abtragsfront 46 erstmalig wieder aus dem Material des Werkstücks 25 aus.

Die verkippte Abtragsfront 46 wird bei dem in Fig. 4c gezeigten Beispiel dadurch erzeugt, dass der Fokusbereich 39 jeweils zwischen zwei benachbarten Bewegungsbahnen 42 in Einstrahlungsrichtung Z um einen im gezeigten Beispiel konstanten Betrag Δz versetzt wird, wie dies in Fig. 4b dargestellt ist. Ein Abstand A zwischen benachbarten Bewegungsbahnen 42 entlang der um 45° zur Einstrahlungsrichtung Z verkippten Abtragsfront 46 liegt im gezeigten Beispiel zwischen ca. 0,01 mm und 0,5 mm, beispielsweise bei ca. 0,03 mm. Um den Fokusbereich 39 zwischen dem Abfahren von benachbarten Bewegungsbahnen 42 schnell in Einstrahlungsrichtung Z versetzen zu können, weist die Vorrichtung 33 eine Fokusversatz-Einrichtung 47 auf, die in Form eines dynamischen Zoom-Objektivs ausgebildet ist. Zur Erzeugung des Versatzes in Einstrahlungsrichtung Z wird die Fokusversatz-Einrichtung 47 mittels einer Steuerungseinrichtung 48 angesteuert. Die Steuerungseinrichtung 48 dient auch zur Ansteuerung der Laserquelle 34 sowie der Scannereinrichtung 36, um den Versatz in Einstrahlungsrichtung Z mit der Bewegung des Fokusbereichs 39 entlang der jeweiligen Bewegungsbahn 42 zu synchronisieren. Der Durchmesser des im gezeigten Beispiel kreisförmigen Querschnitts des Kühlkanals 28 liegt im gezeigten Beispiel bei ca. 2 mm.

Fig. 5a,b zeigen eine weitere Möglichkeit zum Bilden einer schrägen Abtragsfront 46, die ebenfalls unter einem Winkel α von 45° zur Einstrahlungsrichtung Z ausgerichtet ist. Wie in Fig. 5b zu erkennen ist, weist die Vorrichtung 33 zur Erzeugung der Hohlstruktur 28 keine Fokusversatz-Einrichtung auf. Die gepulste Laserstrahlung 35 wird bei der in Fig. 5b gezeigten Vorrichtung 33 auf eine Fokusebene FE fokussiert, die senkrecht zur Einstrahlungsrichtung Z ausgerichtet ist. Wie in Fig. 5a zu erkennen ist, wird für das Bilden der Abtragsfront 46 die Pulsenergie E_{P} der gepulsten Laserstrahlung 35 schrittweise zwischen benachbarten Bewegungsbahnen 42 bzw. den entsprechenden Scanlinien in der Fokusebene FE erhöht, wie in Fig. 5a durch eine Vergrößerung der Strichstärke der Bewegungsbahnen 42 angedeutet ist.

Für die Erhöhung der Pulsenergie E_{P} wirkt die Steuerungseinrichtung 48 auf die Laserquelle 34 ein. Die Laserquelle 34 weist eine Einrichtung zur Einstellung der Pulsenergie E_{P} auf, die beispielsweise in Form eines akusto-optischen Modulators oder eines elektro-optischen Modulators ausgebildet sein kann. Derartige Modulatoren weisen Ansprechzeiten in der Größenordnung von Mikrosekunden oder weniger auf und ermöglichen eine schnelle Erhöhung der Pulsenergie E_{P} zwischen jeweils zwei benachbarten Bewegungsbahnen 42 des Ablationsmusters 41. Wie in Fig. 5b zu erkennen ist, ist der Einflussbereich der gepulsten Laserstrahlung 35 auf das Material des Substrats 25 neben anderen Parametern von der Pulsenergie E_{P} abhängig. In Abhängigkeit von vorgegebenen Parametern wie der Wellenlänge der gepulsten Laserstrahlung 35 und der Pulsdauer der gepulsten Laserstrahlung 35 wird eine bestimmte Schwell-Energiedichte bzw. Intensität benötigt, um das Material des Substrats 25 abzutragen. Je größer die Pulsenergie E_{P} ist, desto größer ist ausgehend von der Fokusebene FE die Ausdehnung des Bereichs, an dem ein Materialabtrag stattfinden kann.

Fig. 5b zeigt die Ausdehnung der Iso-Linien der Energiedichte innerhalb des Substrats 25 mit einer Grenze 49 in Einstrahlungsrichtung Z, an der noch ein Abtrag stattfinden kann. Durch die schrittweise Erhöhung der Pulsenergie E_{P} in X-Richtung, wie sie in Fig. 5a durch einen Pfeil angedeutet ist, kann die Grenze 49 in Einstrahlungsrichtung Z verschoben und die in Fig. 5b gezeigte Abtragsfront 49 gebildet werden, die unter dem Winkel von 45° zur Einstrahlungsrichtung Z ausgerichtet ist. Auf die in Zusammenhang mit Fig. 5a,b beschriebene Weise kann somit eine schräge Abtragsfront 46 gebildet werden, ohne dass zu diesem Zweck die Vorrichtung 33 zusätzliche bewegliche Elemente wie eine Fokusversatz-Einrichtung 47 aufweist. Wie in Zusammenhang mit Fig. 3 beschrieben wurde, kann auch in diesem Fall der vertikale Abschnitt 28a des Kanals 28 durch eine Abwärtsbewegung des Substrats 25 in Z-Richtung erzeugt werden, wie in Fig. 5b durch einen Pfeil angedeutet ist.

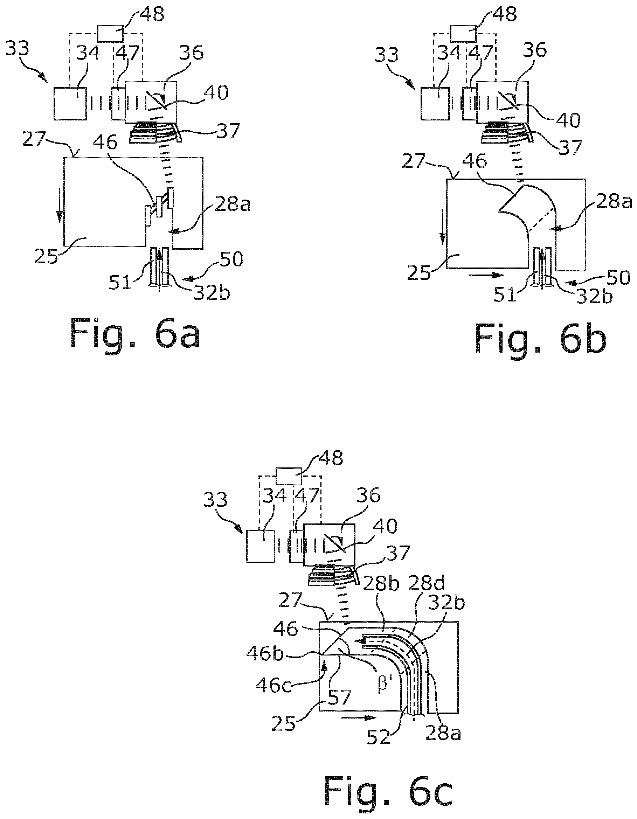

Fig. 6a-c zeigen drei Phasen des Erzeugens einer abgewinkelten Hohlstruktur 28, die einen vertikalen Abschnitt 28a und einen horizontalen Abschnitt 28b aufweist, die an einem abgerundeten Abschnitt 28d bzw. an einer Rundung ineinander übergehen. Die Vorrichtung 33 zum Erzeugen der Hohlstruktur 28 ist hierbei wie in Fig. 4a-c ausgebildet, d.h. diese weist eine Fokusversatz-Einrichtung 47 auf, um die schräge Abtragsfront 46 zu bilden. Wie in Fig. 6a zu erkennen ist, wird in einer ersten Phase der vertikale Kanalabschnitt 28a erzeugt, indem das Substrat 25 nach unten verschoben wird, wodurch die Abtragsfront 46 innerhalb des Substrats 25 bewegt und kontinuierlich Material des Substrats 25 abgetragen wird, während die Scanneroptik 36 ortsfest bleibt. Da es für den Materialabtrag lediglich auf die Relativbewegung zwischen der Abtragsfront 46 und dem Substrat 25 ankommt, kann zur Bewegung der Abtragsfront 46 innerhalb des Substrats 25 alternativ das Substrat 25 in Einstrahlungsrichtung Z ortsfest verbleiben und die Scanneroptik 36 nach oben bewegt werden. Auch eine überlagerte Bewegung des Substrats 25 und der Scanneroptik 36 in Z-Richtung ist grundsätzlich möglich.

Das abgetragene Material wird von der Abtragsfront 46 mit Hilfe einer Fluidzuführung 50 abgeführt. Die Fluidzuführung 50 weist im gezeigten Beispiel eine ortsfeste Düse 51 auf, aus der eine Flüssigkeit, im gezeigten Beispiel Wasser 32b, austritt, das in vertikaler Richtung ausströmt und der Abtragsfront 46 zugeführt wird. Die Ausrichtung der Düse 51 in vertikaler Richtung nach oben ermöglicht eine gezielte Entfernung der Abtragspartikel von der Abtragsfront 46, die aufgrund der Schwerkraftwirkung in dem Zwischenraum zwischen der Düse 51 und der Wandung des vertikalen Abschnitts 28a der Hohlstruktur 28 abgeführt werden. Auf diese Weise bleibt die Abtragsfront 26 im Wesentlichen frei von Ablagerungen und der Abtrag kann ohne Unterbrechung erfolgen. Gleichzeitig ermöglicht die Zufuhr der Flüssigkeit 32b eine aktive Kühlung der Abtragsfront 46 bzw. der Bearbeitungszone, wodurch die Restwärme im Substrat 25 reduziert wird. Alternativ zur Zuführung einer Flüssigkeit 32b kann mit Hilfe der Fluidzuführung 50 der Abtragsfront 26 auch ein Gas, beispielsweise Druckluft, zugeführt werden.

Fig. 6b zeigt eine Phase der Erzeugung der Hohlstruktur 28, bei welcher der abgerundete Abschnitt 28d der Hohlstruktur 28 gebildet wird, der einen 90°-Übergang zwischen dem vertikalen Abschnitt 28a und dem horizontalen Abschnitt 28b der Hohlstruktur 28 bildet. Bei der Bildung des abgerundeten Abschnitts 28d wird das Substrat 25 zusätzlich zur Verschiebung in Z-Richtung auch in X-Richtung verschoben, wie durch einen Pfeil angedeutet ist, während die unter 45° geneigte Abtragsfront 46 weiterhin auf die weiter oben beschriebene Weise gebildet wird.

Der abgerundete Abschnitt 28d ermöglicht das Einführen eines flexiblen Schlauchs 52 in die Hohlstruktur 28, welcher der Abtragsfront 46 bei der Erzeugung des horizontalen Abschnitts 28b der Hohlstruktur 28 nachgeführt wird, wie dies in Fig. 6c dargestellt ist. Auf diese Weise können auch bei der Erzeugung des horizontalen Abschnitts 28b die Abtragsprodukte effektiv von der Abtragsfront 46 abgeführt werden. Durch ein kontinuierliches Nachführen des Schlauchs 52 ist die erreichbare Länge der Hohlstruktur 28 nur durch die Größe des Substrats 25 und durch die Länge des Schlauchs 52 begrenzt.

Es ist nicht zwingend erforderlich, dass beim Erzeugen einer Hohlstruktur, z.B. in Form eines geradlinigen Kanals, durch materialabtragende Bearbeitung mittels gepulster Laserstrahlung 35 zwingend die weiter oben beschriebene Verkippung der Abtragsfront 46 vorgenommen wird. Auch für den Fall, dass eine geradlinig verlaufende Hohlstruktur in Form eines Kanals 28 erzeugt werden soll, der eine vergleichsweise große Länge aufweist, ist es erforderlich, die Fluidzuführung 50 bzw. einen Teil der Fluidzuführung 50 zumindest teilweise in den Kanal 28 einzuführen, um der Abtragsfront 46 das Spül-Fluid 32b zuzuführen. Die Fluidzuführung 50 kann zu diesem Zweck beispielsweise ein starres Rohr oder dergleichen aufweisen, das zumindest teilweise in den Kanal 28 eingeführt wird. Insbesondere für den Fall, dass ein gekrümmter Kanal 28 gebildet werden soll, kann die Fluidzuführung 50 ein flexibles Element, beispielsweise in Form eine flexiblen Schlauchs 52, aufweisen, der zumindest teilweise in den Kanal 28 eingeführt wird, um dessen freies Ende der Abtragsfront 46 nachzuführen. Am freien Ende des Schlauchs 52 kann eine Düse angebracht sein, dies ist aber nicht zwingend erforderlich.

Wie in Fig. 6c ebenfalls zu erkennen ist, grenzt bei der Erzeugung des horizontalen Abschnitts 28b der Hohlstruktur 28 Material des Substrats 25 an einer der Strahlungseintrittsseite 27 des Werkstücks 25 abgewandten Seite 46c des der Strahlungseintrittsseite 27 des Substrats 25 abgewandten Randes 46b der Abtragsfront 46 an, d.h. es befindet sich Material des Substrats 25 unterhalb des in Fig. 6c unteren Randes 46b der Abtragsfront 46. Auch tritt bei der Erzeugung des horizontalen Abschnitts 28b der Hohlstruktur 28 ein Teil der aus dem Bereich der Abtragsfront 46 bzw. an der Abtragsfront 46 in die Hohlstruktur 28 austretenden Laserstrahlung 35 erneut in das Material des Substrats 25 ein, und zwar am in Fig. 6c unteren Rand der Mantelfläche der Hohlstruktur in Form des Kanals 28.

Wie in Fig. 6c ebenfalls zu erkennen ist, schließt die Abtragsfront 48 mit einer im gezeigten Beispiel zylindrischen Mantelfläche 57 des Kanals 28 einen Winkel β' ein, der im Folgenden auch als Abtragsfront-Winkel bezeichnet wird. Der Abtragsfront-Winkel β' ist bei der Herstellung des Kanals 28 typischerweise wenigstens zeitweise größer als ein Abtragsfront-Mindestwinkel von 1°, von 5°, von 10°, von 20° oder von 30° und wenigstens zeitweise kleiner als ein Abtragsfront-Maximalwinkel von 89°, von 85°, von 80°, von 70° oder von 60°. Der Abtragsfront-Winkel β' beim Erzeugen des Kanals 28 kann permanent größer als der Abtragsfront-Mindestwinkel und/oder permanent kleiner als der Abtragsfront-Maximalwinkel sein, dies ist aber nicht zwingend erforderlich.

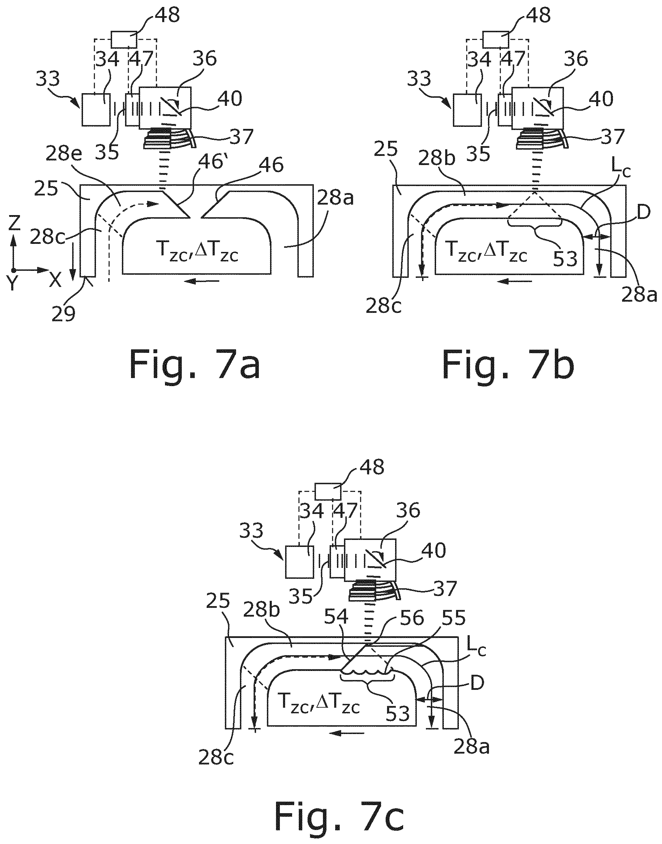

Fig. 7a,b zeigen zwei weitere Phasen bzw. Schritte der Erzeugung der Hohlstruktur 28, die sich an die in Zusammenhang mit Fig. 6a-c beschriebenen Phasen anschließen. Wie in Fig. 7a zu erkennen ist, wird entsprechend zu der in Fig. 6a gezeigten Phase ausgehend von der Rückseite 29 des Substrats 25 ein weiterer vertikaler Abschnitt 28c der Hohlstruktur 28 erzeugt, an den sich ein weiterer abgerundeter Abschnitt 28e anschließt. Bei der in Fig. 7a gezeigten Phase der Erzeugung der Hohlstruktur 28 wird im Vergleich zu Fig. 6a die die Ausrichtung der Abtragsfront 46 gespiegelt und das Substrat wir in negativer X-Richtung verschoben, um den horizontalen Abschnitt 28b zu bilden. Wie in Fig. 7b zu erkennen ist, wird durch die fortlaufende Prozessierung die gespiegelte Abtragsfront 46' in horizontaler Richtung verschoben, bis diese den bereits prozessierten Teil des horizontalen Abschnitts 28b der Hohlstruktur 28 erreicht, so dass ein durchgängiger horizontaler Abschnitt 28b erzeugt wird und die Hohlstruktur 28 in Form des Kanals durchgängig geöffnet wird.

Beim durchgängigen Öffnen des Kanals 28 entsteht ein Nahtbereich 53, der in Fig. 7b in Bereich der beiden aneinander angrenzenden gestrichelten Linien verläuft, welche der jeweils letzten Abtragsfront 46, 46' entsprechen, die beim Herstellen eines jeweiligen Teils des Kanals 28 gebildet wurde. Die Beschaffenheit des Kanals 28, genauer gesagt die Beschaffenheit der Wand des Kanals 28, in dem Nahtbereich 53 unterscheidet sich von Beschaffenheit der Wand des Kanals 28 außerhalb des Nahtbereichs in mindestens einer Eigenschaft bzw. der Nahtbereich 53 weist gegenüber dem restlichen Kanal 28 mindestens eine strukturelle Veränderung auf

In Fig. 7c sind drei Beispiele für derartige strukturelle Veränderungen gezeigt: Bei dem in Fig. 7c gezeigten Beispiel unterscheidet sich eine Oberflächenstruktur der Wand des Kanals 28 in dem Nahtbereich 53 von einer Oberflächenstruktur der Wand des Kanals 28 außerhalb des Nahtbereichs 53 zunächst dadurch, dass an der Oberflächenstruktur in dem Nahtbereich 53 im gezeigten Beispiel die Randkontur 54 einer Abtragsfront 46 erkennbar ist. Auch die Randkontur der anderen Abtragsfront 46' ist in dem Nahtbereich 53 teilweise in die Oberflächenstruktur des Kanals 28 eingeschrieben, was in Fig. 7c nicht bildlich dargestellt ist. Die Randkontur 54 der Abtragsfront 46 verläuft im gezeigten Beispiel ellipsenförmig und ist unter einem Winkel von ca. 45° zur Mantelfläche des Kanals 28 ausgerichtet, d.h. unter demselben Winkel wie die Abtragsfront 46 selbst (vgl. Fig. 6c).

Bei dem in Fig. 7c gezeigten Beispiel sind in dem Nahtbereich 53 zudem vier Ausstülpungen 55 an der Wand des Kanals 28 gebildet, die den Querschnitt des Kanals 28 jeweils lokal vergrößern. Ausstülpungen, die den Querschnitt des Kanals 28 verringern, sind ebenfalls möglich. Auch weist die Wand des Kanals 28 in dem Nahtbereich 53 einen geringfügigen seitlichen Versatz 56 in der Art einer Stufe auf, die auf eine geringfügig unterschiedliche Querschnittsfläche der beiden Teile des Kanals 28 zurückzuführen ist. Ein lateraler Versatz kann auch durch eine geringfügig abweichende Positionierung der beiden Teile des Kanals 28 bei der Erzeugung der durchgängigen Öffnung auftreten. Es versteht sich, dass sowohl die Auswölbungen 55 als auch der seitliche Versatz 56 zur Veranschaulichung übertrieben groß dargestellt sind.

Durch die materialabtragende Bearbeitung mittels der gepulsten Laserstrahlung 35 kann in dem Substrat 25 eine Hohlstruktur in Form eines gekrümmten Kanals 28 erzeugt werden, die einen Durchmesser D zwischen 1 mm und 20 mm, insbesondere zwischen 1 mm und 5 mm, und/oder eine Länge L_{C} von mindestens 10 cm, von mindestens 15 cm, von mindestens 20 cm oder von mindestens 70 cm aufweist. Der in Fig. 7b dargestellte Kanal 28 weist eine Länge L_{C} von mehr als 20 cm und einen Durchmesser D von 5 mm auf. Die Nulldurchgangstemperatur T_{ZC} des Substrats 25 liegt im oben angegebenen Wertebereich und ist im Volumen des monolithischen Substrats 25 praktisch konstant, d.h. die Variation der Nulldurchgangstemperatur ΔT_{ZC}, d.h. die Differenz zwischen der maximalen Nulldurchgangstemperatur und der minimalen Nulldurchgangstemperatur im Volumen des Substrats 25, liegt ebenfalls im oben angegebenen Wertebereich.

Auf die weiter oben beschriebene Weise wird eine Hohlstruktur 28 erzeugt, die wie in Zusammenhang mit Fig. 2a,b beschrieben zur Durchströmung mit einer Kühlflüssigkeit verwendet werden kann. Anders als weiter oben beschrieben, kann der rückseitige Abtrag nicht von der Rückseite 29 des Substrats 25 ausgehen, sondern auch von einer der Strahleintrittsseite 27 gegenüberliegenden Seite des Substrats 25, die innerhalb des Substrats 25 angeordnet ist. Beispielsweise kann es sich hierbei um das obere Ende der in Fig. 2b dargestellten vertikalen Bohrungen handeln, von denen ausgehend die beiden vertikalen Abschnitte 28a,c der Hohlstruktur 28 erzeugt werden. In diesem Fall wird die Hohlstruktur 28 durch ein hybrides Herstellungsverfahren erzeugt, bei dem eine mechanische Bearbeitung des Substrats 25 mit der materialabtragenden Bearbeitung mittels gepulster Laserstrahlung 35 kombiniert wird. Es versteht sich, dass an Stelle von vertikalen Bohrungen auch anders ausgerichtete Bohrungen bzw. Hohlräume als Ausgangspunkt für das weiter oben beschriebene Erzeugen einer Hohlstruktur 28 mit Hilfe von gepulster Laserstrahlung 35 dienen können.

Zusammenfassend können auf die weiter oben beschriebene Weise hochaspektierte vertikale und horizontale, makroskopische Hohlstrukturen in ein Substrat 25 eines EUV-Spiegels eingebracht werden. Es versteht sich, dass auf diese Weise auch Hohlstrukturen bzw. Abschnitte von Hohlstrukturen erzeugt werden können, die von einer horizontalen bzw. vertikalen Ausrichtung abweichen. Es versteht sich, dass nicht nur einer der Spiegel M1-M6 des Projektionssystems 10, sondern auch beliebige andere Spiegel, insbesondere EUV-Spiegel, auf die weiter oben beschriebene Weise bearbeitet werden können, um Hohlstrukturen zu erzeugen. Mittels des weiter oben beschriebenen Verfahrens können auch komplexere Hohlstrukturen als ein einzelner durchgehender Kühlkanal 28 erzeugt werden, beispielsweise Hohlstrukturen, die Y-Verzweigungen oder T-Verzweigungen aufweisen. Auch Hohlstrukturen, die Verzweigungen aufweisen, können auf die weiter oben beschriebene Weise erzeugt werden, ohne dass es zu einer Schädigung bzw. zum Auftreten von Verspannungen im Material des Substrats kommt.

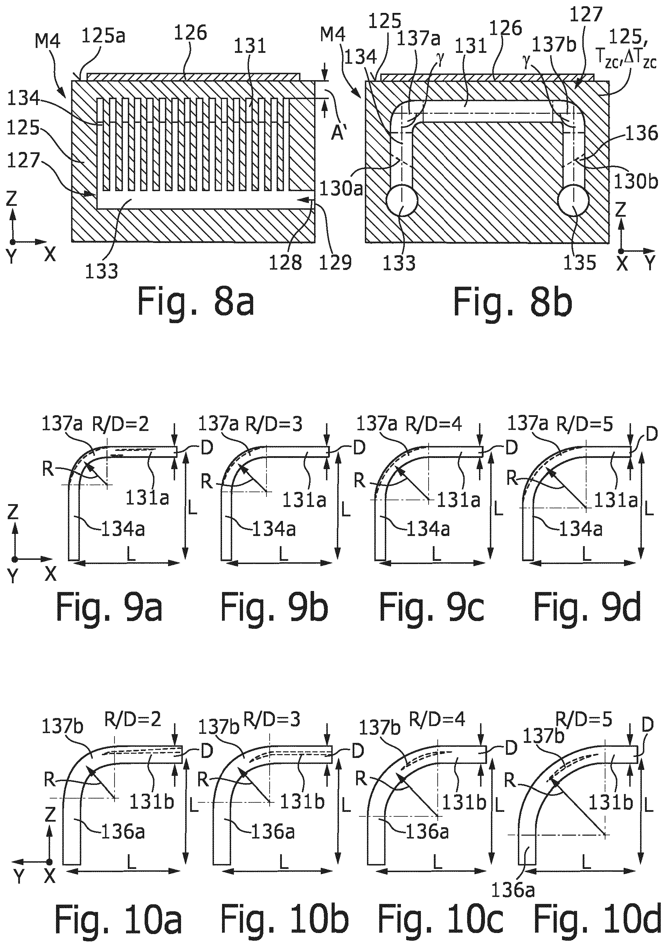

Fig. 8a,b zeigen ein weiteres Beispiel für eine Ausgestaltung des Spiegels M4 des Projektionssystems 10, der ein monolithisches Substrat 125 aufweist. Im gezeigten Beispiel handelt es sich bei dem Material des Substrats 125 um titandotiertes Quarzglas mit einem sehr geringen Wärmeausdehnungskoeffizienten. Das Substrat 125 kann auch aus einem anderen Material gebildet sein, das einen möglichst niedrigen thermischen Ausdehnungskoeffizienten aufweist, beispielsweis aus einer Glaskeramik. Die Nulldurchgangstemperatur T_{ZC} des Substrats 125 liegt im oben angegebenen Wertebereich und ist im Volumen des monolithischen Substrats 125 praktisch konstant, d.h. die Variation der Nulldurchgangstemperatur ΔT_{ZC}, d.h. die Differenz zwischen der maximalen Nulldurchgangstemperatur und der minimalen Nulldurchgangstemperatur im Volumen des Substrats 125, liegt ebenfalls im oben angegebenen Wertebereich.

An einer Oberfläche 125a des Substrats 125 ist eine reflektierende Beschichtung 126 zur Reflexion von EUV-Strahlung 16 aufgebracht. Ein Teilbereich der Oberfläche 125a, der sich innerhalb der reflektierenden Beschichtung 126 befindet, wird von der EUV-Strahlung 116 des Projektionssystems 10 getroffen und bildet einen nicht bildlich dargestellten optisch genutzten Teilbereich der reflektierenden Beschichtung 126. Die reflektierende Beschichtung 126 kann zur Reflexion der EUV-Strahlung 16 beispielsweise eine Mehrzahl von Schichtpaaren aus Materialien mit jeweils unterschiedlichem Realteil des Brechungsindexes aufweisen, die bei einer Wellenlänge der EUV-Strahlung 16 von 13,5 nm beispielsweise aus Si und Mo gebildet sein können.

Das Substrat 125 weist eine Hohlstruktur 127 auf, die mit einem Fluid 128 durchströmt werden kann, bei dem es sich im gezeigten Beispiel um Wasser handelt. Das in Fig. 8a durch einen Pfeil angedeutete Fluid 128 tritt über eine Eintrittsöffnung 129 an einer Seitenfläche in das Substrat 125 ein, um eine Mehrzahl von Kühlkanälen 131 zu durchströmen, die einen Teil der Hohlstruktur 127 bilden, um auf diese Weise insbesondere die Oberfläche 125a des Substrats 125 zu kühlen, auf welche die reflektierende Beschichtung 126 aufgebracht ist.

Für die Zuführung des Fluids 128 zu der Einlassöffnung 129 sowie für das Abführen des Fluids 128 von einer in Fig. 8a,b nicht bildlich dargestellten Auslassöffnung weist die Projektionsbelichtungsanlage 1 die weiter oben beschriebene Temperiereinrichtung 32 auf, die in Form einer Kühleinrichtung ausgebildet ist. Die Kühleinrichtung 32 dient im gezeigten Beispiel zur Zuführung des Fluids 128 in Form von Kühlwasser zu der Hohlstruktur 127 bzw. zu dem Spiegel M4 und weist zu diesem Zweck eine nicht bildlich dargestellte Zuführungsleitung auf, die mit der Einlassöffnung 129 fluiddicht verbunden ist. Die Kühleinrichtung 132 weist auch eine nicht bildlich dargestellte Abführungsleitung auf, um das Kühlwasser über die Auslassöffnung des Substrats 125 bzw. von der Hohlstruktur 127 abzuführen.

Wie in Fig. 8a zu erkennen ist, tritt das Fluid 128 über die Einlassöffnung 129 in einen Einlasskanal 133 der Hohlstruktur 127 ein, der einen Fluidverteiler bildet und von dem eine Mehrzahl von Verteilerkanälen 134 abzweigen, die jeweils mit einem der Mehrzahl von Temperierkanälen verbunden sind, die nachfolgend als Kühlkanäle 131 bezeichnet werden. Die Kühlkanäle 131 sind in einem Abstand A' von ca. 5 mm von der im gezeigten Beispiel planen Oberfläche 125a des Substrats 125 beabstandet angeordnet und erstrecken sich parallel zur Oberfläche 125a, d.h. parallel zu einer XY-Ebene eines XYZ-Koordinatensystems. Die Kühlkanäle 131 verlaufen geradlinig, sind parallel ausgerichtet und erstrecken sich in Längsrichtung, die der Y-Richtung entspricht, über annähernd den gesamten von der Beschichtung 126 überdeckten Teilbereich der Oberfläche 125a des Substrats 125, vgl. Fig. 8b. Aus den Kühlkanälen 131 strömt das Fluid 128 über eine Mehrzahl von Sammlerkanälen 136 zu einem Fluidsammler, der bei dem in Fig. 8b gezeigten Beispiel als Auslasskanal 135 ausgebildet ist. Der Auslasskanal 135 weist die weiter oben beschriebene, in Fig. 8a,b nicht bildlich dargestellte Auslassöffnung auf, über die das Fluid 128 aus der Hohlstruktur 127 des Substrats 125 austritt.

Wie in Fig. 8b zu erkennen ist, weist die Hohlstruktur 127 einen ersten abgerundeten Abschnitt 137a auf, an dem ein jeweiliger Verteilerkanal 134 in einen Kühlkanal 131 übergeht. Entsprechend weist die Hohlstruktur 127 auch einen zweiten abgerundeten Abschnitt 137b auf, an dem ein jeweiliger Kühlkanal 131 in einen Sammlerkanal 136 übergeht. Im gezeigten Beispiel verlaufen die Kühlkanäle 131 geradlinig in horizontaler Richtung, die der Y-Richtung entspricht, und die Verteilerkanäle 134 sowie die Sammlerkanäle 136 verlaufen geradlinig in vertikaler Richtung, die der Z-Richtung entspricht. Entsprechend sind die Längsachsen der Kühlkanäle 131 unter einem Winkel γ von 90° zu den Verteilerkanälen 134 bzw. zu den Sammlerkanälen 136 ausgerichtet. Der abgerundete Abschnitt 137a,b dient dazu, eine möglichst stromlinienförmige Strömungsführung zu erzeugen und auf diese Weise das Auftreten von Turbulenzen zu vermeiden oder zumindest deutlich zu reduzieren, wie sie bei einer nicht abgerundeten, "eckigen" 90°-Abbiegung auftreten würden. Die Verringerung von Turbulenzen hat einer Verringerung der strömungsinduzierten Vibrationen des reflektierenden optischen Elements M4 zur Folge.

Für eine optimierte Strömungsführung an der 90°-Abbiegung ist es vorteilhaft, wenn der abgerundete Abschnitt 137a,b einen konstanten Krümmungsradius R aufweist, wie dies in Fig. 9a-d bzw. in Fig. 10a-d dargestellt ist. Einen wesentlichen Parameter für eine optimale Strömungsführung stellt das Verhältnis zwischen dem Krümmungsradius R des abgerundeten Abschnitts 137a, 137b und dem Strömungs-Durchmesser D dar.

Fig. 9a-d zeigen den ersten abgerundeten Abschnitt 137a, an dem ein Endabschnitt 131a eines jeweiligen Kühlkanals 131 und ein an den Endabschnitt 131a angrenzender Verteilerkanalabschnitt 134a aneinander angrenzen, bei vier unterschiedlichen Verhältnissen zwischen dem Krümmungsradius R des abgerundeten Abschnitts 137a und dem Durchmesser D des abgerundeten Abschnitts 137a. Der Krümmungsradius R wird hierbei in der Mitte des abgerundeten Abschnitts 137a gemessen, wie dies in Fig. 9a-d dargestellt ist. Bei allen vier gezeigten Beispielen liegt der Durchmesser D des abgerundeten Abschnitts 137a bei 5 mm. Der Durchmesser D des abgerundeten Abschnitts 137a entspricht hierbei dem Durchmesser D des Verteilerkanals 134 und dem Durchmesser D des Kühlkanals 131. Die Länge L beträgt in den Darstellungen von Fig. 9a-d ca. 50 mm. Wie in Fig. 9a-d zu erkennen ist, liegt das Verhältnis R / D in den vier gezeigten Beispielen bei R / D = 2, R / D = 3, R / D = 4 bzw. R / D = 5.

Fig. 10a-d zeigen analog zu Fig. 9a-d den zweiten abgerundeten Abschnitt 137b, an dem ein Endabschnitt 131b eines jeweiligen Kühlkanals 131 und ein an den Endabschnitt 131b angrenzender Sammlerkanalabschnitt 136a ineinander übergehen. Der Durchmesser D des abgerundeten Abschnitts 137b liegt in Fig. 10a-d bei 10 mm. Die Länge L beträgt in den Darstellungen von Fig. 10a-d ca.60 mm. Auch bei der Darstellung von Fig. 10a-d liegt das Verhältnis R / D in den vier gezeigten Beispielen bei R / D = 2, R / D = 3, R / D = 4 bzw. R / D = 5. Der Durchmesser D eines jeweiligen abgerundeten Abschnitts 137a, 137b liegt typischerweise zwischen 2 mm und 20 mm, idealerweise zwischen 2 mm und 12 mm.

Wie weiter oben beschrieben wurde, existiert ein optimales Verhältnis zwischen dem Krümmungsradius R und dem Durchmesser D des jeweiligen abgerundeten Abschnitts 137a, 137b, bei dem die Zentrifugalkraft derart wirkt, dass der Druck des strömenden Fluids 128 auf der Außenseite des abgerundeten Abschnitts 137a, 137b im Vergleich zur Innenseite des abgerundeten Abschnitts 137a,b nur minimal ansteigt und auf diese Weise eine Reduktion der Grenzschichtablösung vor und nach dem abgerundeten Abschnitt 137a,b erreicht werden kann. In Fig. 9a-d und in Fig. 10a-d sind die Umrisse von Bereichen dargestellt, in denen die turbulente kinetische Energie des strömenden Fluids 128 einen vorgegebenen Wert überschreitet. Hierbei wurde davon ausgegangen, dass das Fluid 128 von dem Verteilerkanalabschnitt 134a bzw. von dem Sammlerkanalabschnitt 136a in den jeweiligen Endabschnitt 131a bzw. 131b des Kühlkanals 131 strömt.

Für diesen Zweck hat sich ein Verhältnis zwischen dem Krümmungsradius R des abgerundeten Abschnitts 137a, 137b und dem Durchmesser D des abgerundeten Abschnitts 137a, 137b als besonders vorteilhaft herausgestellt, das zwischen 2 und 6, besser zwischen 2,5 und 5, idealerweise zwischen 2,5 und 3,5 liegt. Bei einem Verhältnis R / D kleiner als 2 kann typischerweise keine signifikante Reduktion der Grenzschichtablösung erfolgen. Ein optimaler Wert für das Verhältnis R / D liegt typischerweise zwischen 2,5 und 3,5, der optimale Wert kann aber ggf. auch außerhalb dieses Wertebereichs liegen. Bei einem Verhältnis R / D von mehr als 6,0 verschlechtert sich das Strömungsverhalten typischerweise.

Wie weiter oben beschrieben wurde, lässt sich der abgerundete Abschnitt 137a,b in einem monolithischen Substrat 125 in der Praxis nicht mit Hilfe von herkömmlichen Bearbeitungsverfahren herstellen. Im gezeigten Beispiel werden lediglich der Einlasskanal 133 und der Auslasskanal 135 durch ein herkömmliches Bearbeitungsverfahren hergestellt, und zwar indem eine jeweilige Bohrung in das Substrat 125 eingebracht wird. Die Verteilerkanäle 134, die Kühlkanäle 131 und die Sammlerkanäle 136 werden hingegen durch eine Laserablation des Materials des Substrats 25 hergestellt, die nachfolgend beschrieben wird.

Für die Herstellung der Verteilerkanäle 134, der Kühlkanäle 131 und der Sammlerkanäle 136 der Hohlstruktur 127 wird vor dem Aufbringen der reflektierenden Beschichtung 126 ein gepulster Laserstrahl ausgehend von der Oberfläche 125a des Substrats 125 durch das Material des Substrats 125 hindurch auf die Oberseite des Einlasskanals 133 eingestrahlt und dort fokussiert, wobei ein Bewegungsmuster mit einer Mehrzahl von parallelen Ablationsbahnen erzeugt wird, die eine Abtragsfront 130a bilden, die unter einem Winkel von 45° zur Dickenrichtung Z des Substrats 25 ausgerichtet ist. Ausgehend von dieser Position wird die Abtragsfront 130a mehrmals in Dickenrichtung, die der Z-Richtung entspricht, relativ zu dem Substrat 125 verschoben, um das Material des Substrats 125 abzutragen und den Verteilerkanal 34 zu bilden. Bei der Verschiebung kann die Ablationsfont 130a ortsfest bleiben und das Substrat 125 wird in Z-Richtung nach oben verschoben, bis die Abtragsfront 130a sich knapp unterhalb des ersten abgerundeten Abschnitts 137a befindet.

Zur Erzeugung des ersten abgerundeten Abschnitts 137a wird die Abtragsfront 130a bzw. das Substrat 125 in einer überlagerten Bewegung sowohl in Z-Richtung als auch in Y-Richtung verschoben. Nach der Bildung des ersten abgerundeten Abschnitts 137a wird zur Bildung des Kühlkanals 131 bzw. des an den Verteilerkanal 134 angrenzenden Endabschnitts 131a des Kühlkanals 131 die unter 45° zur der Z-Richtung entsprechenden Dickenrichtung ausgerichtete Abtragsfront 130a nur noch in Längsrichtung des Kühlkanals 131 verschoben, die der Y-Richtung entspricht, bis diese sich in Längsrichtung in etwa in der Mitte des Kühlkanals 131 befindet.

Die Herstellung des Sammlerkanals 136, des zweiten abgerundeten Abschnitts 137b sowie der zweiten Hälfte des Kühlkanals 131 bzw. des Endabschnitts 131b, der sich an den zweiten abgerundeten Abschnitt 137b anschließt, erfolgt analog durch eine Laserablation ausgehend von dem Auslasskanal 135, auf dessen Oberseite die gepulste Laserstrahlung durch das Substrat 125 hindurch zunächst fokussiert wird. Die hierbei gebildete weitere Abtragsfront 30b ist ebenfalls unter 45° zur Dickenrichtung des Substrats 25 bzw. zur XY-Ebene ausgerichtet, aber gegenüber der weiter oben beschriebenen Abtragsfront 130a in Bezug auf die XZ-Ebene gespiegelt. Die Ausrichtung der Abtragsfront 130a, 130b unter einem Winkel zur Dickenrichtung bzw. zur Einstrahlungsrichtung Z des gepulsten Laserstrahls bzw. der gepulsten Laserstrahlung erfolgt typischerweise auf die weiter oben in Zusammenhang mit Fig. 4a-c bzw. Fig. 5a,b beschriebene Weise. Zur Abführung von ablatiertem Material von der jeweiligen Abtragsfront 130a, 130b bzw. zur Kühlung wird der jeweiligen Abtragsfront 130a, 130b ein Fluid zugeführt. Die Zuführung des Fluids erfolgt mittels einer Fluidzuführung, typischerweise auf die in Zusammenhang mit Fig. 6a-c beschriebene Weise, d.h. durch zumindest teilweises Einführen einer Fluidzuführung in die Hohlstruktur 127.

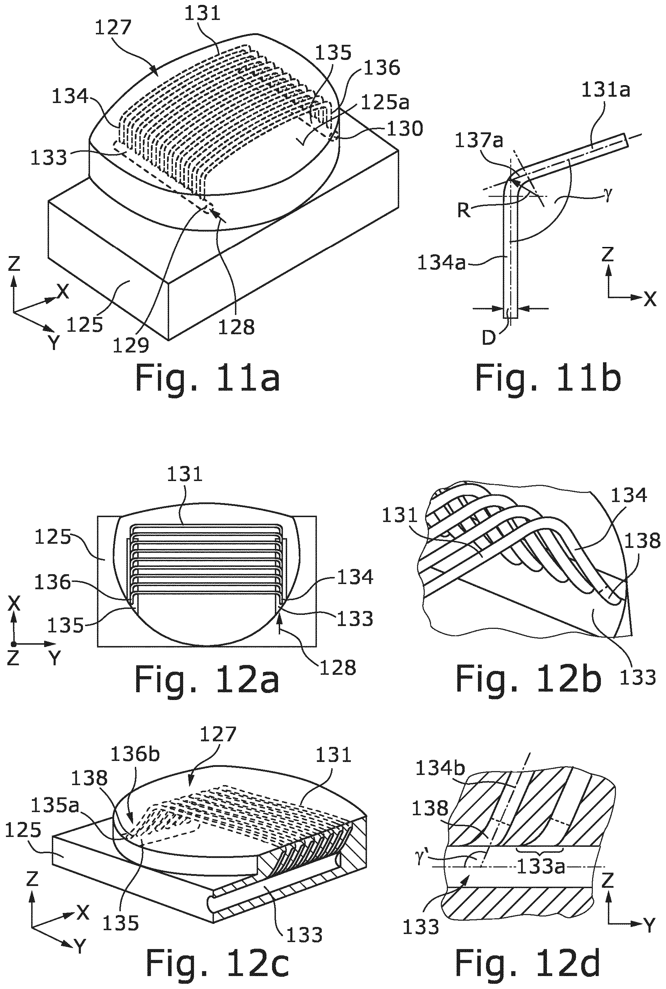

Bei der weiter oben beschriebenen Hohlstruktur 127 sind lediglich die beiden Abschnitte 137a, 137b abgerundet, während die Verteilerkanäle 134, die Sammlerkanäle 136 und die Kühlkanäle 131 geradlinig verlaufen. Mit Hilfe des weiter oben beschriebenen Laserablations-Verfahrens können aber auch komplexere Hohlstrukturen 127 hergestellt werden. Fig. 11a,b zeigen ein Beispiel für eine solche Hohlstruktur 127 in einem Substrat 125, die im Wesentlichen der in Fig. 8a,b dargestellten Hohlstruktur 127 entspricht. Die Hohlstruktur 127 unterscheidet sich von der Hohlstruktur 127 von Fig. 8a,b dadurch, dass die Kühlkanäle 131 eine geringfügige Krümmung aufweisen, die der Krümmung der im gezeigten Beispiel konvex gekrümmten Oberfläche 125a folgt. Ein dem Verteilerkanal 134 benachbarter Endabschnitt 131a eines jeweiligen Kühlkanals 131 ist bei dem in Fig. 11b gezeigten Beispiel unter einem Winkel γ von ca. 115° ausgerichtet. Trotz der Tatsache, dass der Kühlkanal 131 eine Krümmung aufweist, die in der ZX-Ebene verläuft, kann für den Endabschnitt 131a, der an den abgerundeten Abschnitt 131a angrenzt, eine Längsachse definiert werden, welche den Winkel γ definiert. Es versteht sich, dass der zweite, in Fig. 11a,b nicht bildlich dargestellte abgerundete Abschnitt 137b entsprechend zum ersten Abschnitt 137a ausgebildet ist. Das Verhältnis R / D zwischen dem Krümmungsradius R und dem Durchmesser D der jeweiligen abgerundeten Abschnitte 137a,b liegt typischerweise in dem weiter oben beschriebenen Wertebereich.

Bei dem in Fig. 12a-d gezeigten Substrat 125 ist die Hohlstruktur 127 im Wesentlichen wie die in Fig. 8a,b gezeigte Hohlstruktur 127 ausgebildet, unterscheidet sich von dieser aber dadurch, dass die Verteilerkanäle 134 und die Sammlerkanäle 136 nicht in vertikaler Richtung verlaufen, sondern unter einem Winkel von ca. 25° zur Dickenrichtung Z des Substrats 125 ausgerichtet sind. Die in Fig. 12a-d gezeigte Hohlstruktur 127 weist wie die in Fig. 8a,b gezeigte Hohlstruktur 127 zwei nicht bildlich dargestellte abgerundete Abschnitte 137a, 137b zwischen den jeweiligen Verteilerkanälen 134 bzw. Sammlerkanälen 136 und den Kühlkanälen 131 auf. Der Winkel γ zwischen den Verteilerkanälen 134 bzw. den Sammlerkanälen 136 und den Kühlkanälen 131 liegt auch in diesem Fall bei 90°, dieser verläuft aber in einer Ebene, die um ca. 25° zur Dickenrichtung Z geneigt ist, wie dies in Fig. 12d zu erkennen ist, die einen Winkel γ' von ca. 115° zwischen der Längsachse des Einlasskanals 133 und einem jeweiligen Verteilerkanal 134 zeigt.

Die in Fig. 12a-d gezeigte Hohlstruktur 127 weist abgerundete Abschnitte 138 auf, an denen ein Mündungsabschnitt 134b eines jeweiligen Verteilerkanals 134 in den Einasskanal 134, genauer gesagt in einen Verzweigungsabschnitt 134a des Einlasskanals 134 übergehen bzw. an denen ein Mündungsabschnitt 136b eines jeweiligen Sammlerkanals 136 in einen Verzweigungsabschnitt 135a des Auslasskanals 135 übergeht. Im gezeigten Beispiel weist der jeweilige abgerundete Abschnitt 138 keinen konstanten Durchmesser bzw. StrömungsQuerschnitt auf, vielmehr nimmt der Strömungsquerschnitt ausgehend von dem Verzweigungsabschnitt 134a ab. Der abgerundete Abschnitt 138 weist auch keinen konstanten Krümmungsradius R auf, wie dies bei den beiden gekrümmten Abschnitten 137a,b der Fall ist, die zwischen den jeweiligen Verteilerkanälen 134 bzw. Sammlerkanälen 136 und einem jeweiligen Kühlkanal 131 verlaufen. Entsprechend kann kein optimiertes Verhältnis von Krümmungsradius R zu Durchmesser D angegeben werden. Auch der abgerundete Abschnitt 138 kann mit Hilfe des weiter oben beschriebenen Laserablations-Verfahrens hergestellt werden.

Es versteht sich, dass die Hohlstruktur 127, die den mindestens einen abgerundeten Abschnitt 137a,b, 138 aufweist, nicht auf die weiter oben beschriebenen Beispiele beschränkt ist, sondern dass grundsätzlich auch andere, komplexere Hohlstrukturen 127 in dem Substrat 125 verlaufen können, die einen oder mehrere derartige Abschnitte aufweisen. Auch können nicht nur die Kühlkanäle 131 eine Krümmung aufweisen, wie dies in Zusammenhang mit Fig. 11a,b beschrieben wurde, sondern auch die Verteilerkanäle 134 bzw. die Sammlerkanäle 136 können gekrümmt verlaufen.

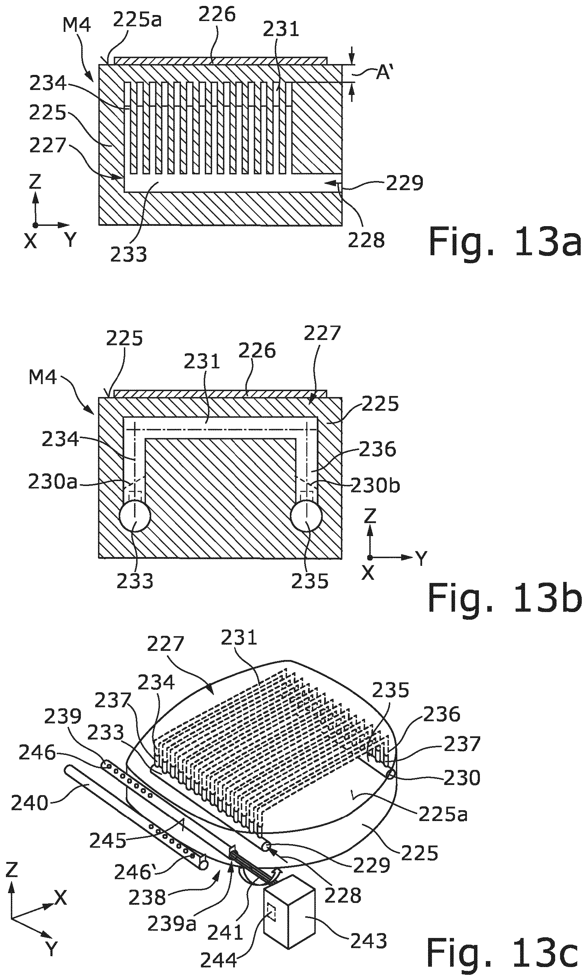

Fig. 13a,b zeigen ein weiteres Beispiel für einen Spiegel M4 des Projektionssystems 10, der im gezeigten Beispiel ein monolithisches Substrat 225 aufweist. Im gezeigten Beispiel handelt es sich bei dem Material des Substrats 225 um titandotiertes Quarzglas mit einem sehr geringen Wärmeausdehnungskoeffizienten. Das Substrat 225 kann auch aus einem anderen Material gebildet sein, das einen möglichst niedrigen thermischen Ausdehnungskoeffizienten aufweist, beispielsweis aus einer Glaskeramik.

An einer Oberfläche 225a des monolithischen Substrats 225 ist eine reflektierende Beschichtung 226 aufgebracht. Ein Teilbereich der Oberfläche 225a, der sich innerhalb der reflektierenden Beschichtung 226 befindet, wird von der EUV-Strahlung 16 des Projektionssystems 10 getroffen und bildet einen nicht bildlich dargestellten optisch genutzten Teilbereich der reflektierenden Beschichtung 226. Die reflektierende Beschichtung 226 kann zur Reflexion der EUV-Strahlung 16 beispielsweise eine Mehrzahl von Schichtpaaren aus Materialien mit jeweils unterschiedlichem Realteil des Brechungsindexes aufweisen, die bei einer Wellenlänge der EUV-Strahlung 16 von 13,5 nm beispielsweise aus Si und Mo gebildet sein können.

Das Substrat 225 weist eine Hohlstruktur 227 auf, die mit einem Fluid 228 durchströmt werden kann, bei dem es sich im gezeigten Beispiel um Wasser handelt. Das in Fig. 13a durch einen Pfeil angedeutete Fluid 228 tritt über eine Eintrittsöffnung 229 an einer Seitenfläche in das Substrat 225 ein, um eine Mehrzahl von Kühlkanälen 231 zu durchströmen, die einen Teil der Hohlstruktur 227 bilden, um auf diese Weise insbesondere die Oberfläche 225a des Substrats 225 zu kühlen, auf welche die reflektierende Beschichtung 226 aufgebracht ist.

Für die Zuführung des Fluids 228 zu der Einlassöffnung 229 sowie für das Abführen des Fluids 228 von einer in Fig. 13c dargestellten Auslassöffnung des Substrats 225 weist die Projektionsbelichtungsanlage 1 eine Temperiereinrichtung in Form einer Kühleinrichtung 32 auf, die stark schematisch in Fig. 1 dargestellt ist. Die Kühleinrichtung 32 dient im gezeigten Beispiel zur Zuführung des Fluids 228 in Form von Kühlwasser zu der Hohlstruktur 227 bzw. zu dem Spiegel M4 und weist zu diesem Zweck eine nicht bildlich dargestellte Zuführungsleitung auf, die mit der Einlassöffnung 229 fluiddicht verbunden ist. Die Kühleinrichtung 32 weist auch eine nicht bildlich dargestellte Abführungsleitung auf, um das Kühlwasser über die Auslassöffnung des Substrats 225 bzw. von der Hohlstruktur 227 abzuführen. Auch die anderen Spiegel M1-M3, M5, M6 des Projektionssystems 10 sowie die Spiegel des Beleuchtungssystems 2 können zur Kühlung mit der Kühleinrichtung 32 oder ggf. mit weiteren zu diesem Zweck vorgesehenen Temperier- bzw. Kühleinrichtungen verbunden werden.

Wie in Fig. 13a zu erkennen ist, tritt das Fluid 228 über die Einlassöffnung 229 in einen ersten Hohlraum 233 der Hohlstruktur 227 ein, der einen Fluidverteiler bildet und von dem eine Mehrzahl von Verteilerkanälen 234 abzweigen, die jeweils mit einem der Mehrzahl von Kühlkanälen 231 verbunden sind. Die Kühlkanäle 231 sind in einem Abstand A' von ca. 2 mm bis ca. 5 mm von der im gezeigten Beispiel planen Oberfläche 225a des Substrats 225 beabstandet angeordnet und erstrecken sich parallel zur Oberfläche 225a, d.h. parallel zu einer XY-Ebene eines XYZ-Koordinatensystems. Die Kühlkanäle 231 verlaufen geradlinig, sind parallel ausgerichtet und erstrecken sich in Längsrichtung, d.h. in Y-Richtung, über annähernd den gesamten von der Beschichtung 226 überdeckten Teilbereich der Oberfläche 225a des Substrats 225, vgl. Fig. 13b. Aus den Kühlkanälen 231 strömt das Fluid 228 über eine Mehrzahl von Sammlerkanälen 236 zu einem Fluidsammler, der bei dem in Fig. 13b gezeigten Beispiel als zweiter zylindrischer Hohlraum 235 ausgebildet ist. Über die Auslassöffnung 230 tritt das Fluid 228 aus der Hohlstruktur 227 des Substrats 225 aus. Im gezeigten Beispiel verlaufen die Kühlkanäle 231 geradlinig in horizontaler Richtung, die der X-Richtung entspricht, und die Verteilerkanäle 234 sowie die Sammlerkanäle 236 verlaufen geradlinig in vertikaler Richtung, die der Z-Richtung entspricht. Entsprechend sind die Längsachsen der Kühlkanäle 231 unter einem Winkel von 90° zu den Verteilerkanälen 234 bzw. zu den Sammlerkanälen 236 ausgerichtet. Eine solche Ausrichtung ist aber nicht zwingend erforderlich.

Für die Herstellung der in Fig. 13a-c gezeigten Hohlstruktur 227 wird wie folgt vorgegangen: Zunächst werden die beiden kreiszylindrischen Hohlräume 233, 235, die den Fluidverteiler und den Fluidsammler bilden, durch mechanisches Bearbeiten, z.B. durch Schleifen oder durch Ultraschallschleifen, in das Material des Substrats 225 eingebracht. Nachfolgend wird das Substrat 225 in ein Flüssigkeitsbad, genauer gesagt in ein Wasserbad, eingetaucht, wodurch ein Fluid 228 in Form von Wasser durch die Einlassöffnung 228 in den Hohlraum 233 des Fluidverteilers und durch die Auslassöffnung 230 in den Hohlraum 235 des Fluidsammlers eintritt und diese ausfüllt. Ausgehend von den jeweiligen mit dem Fluid 228 gefüllten Hohlräumen 233, 235 wird durch Multi-Photonen-Laserablation eine Mehrzahl von an die Hohlräume 233, 235 angrenzenden kurzen Kanalabschnitten 237 erzeugt, wie dies in Fig. 13c zu erkennen ist.

Für die Herstellung der Kanalabschnitte 237 wird eine Mehrzahl von gepulsten Laserstrahlen ausgehend von der Oberfläche 225a des Substrats 225 durch das Material des Substrats 225 hindurch auf die Oberseite des Hohlraums 233 eingestrahlt, der den Fluidverteiler bildet, und dort fokussiert. Die Oberseite des Hohlraums 233 bildet somit eine der Strahlungseintrittsseite in Form der Oberfläche 225a gegenüberliegende Seite des Substrats 225. Mit einem jeweiligen eingestrahlten gepulsten Laserstrahl wird der Fokusbereich in einem Bewegungsmuster mit einer Mehrzahl von parallelen, in Z-Richtung zueinander versetzten Ablationsbahnen bewegt, die eine Abtragsfront 230a bilden, die unter einem Winkel von ca. 45° zur Dickenrichtung Z des Substrats 225 ausgerichtet ist. Für den Versatz der Ablationsbahnen in Z-Richtung wird die Fokusposition des eingestrahlten Laserstrahls in Z-Richtung verändert.

Ausgehend von der Stelle an der Oberseite des Hohlraums 233, von welcher der Kanalabschnitt 237 ausgeht, wird die Abtragsfront 230a mehrmals in Dickenrichtung, d.h. in Z-Richtung, relativ zum Substrat 225 verschoben, um das Material des Substrats 225 abzutragen und den Kanalabschnitt 237 zu bilden. Bei der Verschiebung kann die Ablationsfont 230a ortsfest bleiben und das Substrat 225 wird in Z-Richtung nach unten verschoben, bis die Abtragsfront 230a einen Abstand von ca. 20-40 mm von der Oberseite des Hohlraums 233 aufweist. Für die Herstellung eines Kanalabschnitts 237 mit einer größeren Länge durch Multi-Photonen-Laserablation ist es erforderlich, dass die Abtragsfront 230a lokal mit einem Fluid 228 gespült wird, wie dies weiter unten näher beschrieben wird. Die Herstellung von Kanalabschnitten 237, die von dem Hohlraum 235 ausgehen, der den Fluidsammler bildet, erfolgt auf entsprechende Weise durch Multi-Photonen-Laserablation. Eine hierbei gebildete weitere Abtragsfront 230b ist ebenfalls unter ca. 45° zur Dickenrichtung des Substrats 225 bzw. zur XY-Ebene ausgerichtet, aber gegenüber der weiter oben beschriebenen Abtragsfront 230a in Bezug auf die XZ-Ebene gespiegelt.

Um die in Fig. 13a,b gezeigte Hohlstruktur 227 zu bilden, wird das Substrat 225 aus dem Flüssigkeitsbad entnommen und die Flüssigkeit 228 wird aus den Hohlräumen 233, 235 entfernt. Für die Herstellung der restlichen Hohlstruktur 227 wird eine Fluidzuführungsvorrichtung 238 zur Zuführung eine Fluids 228 in Form von Wasser zu der jeweiligen Abtragsfront 230a, 230b verwendet, die stark schematisch in Fig. 13c dargestellt ist. Die Fluidzuführungsvorrichtung 238 weist zwei Einlegebauteile 239, 240 sowie eine Mehrzahl von flexiblen Fluidleitungen 241 auf. Im gezeigten Beispiel weist die Fluidzuführungsvorrichtung 238 sieben Fluidleitungen 241 auf. Die Fluidleitungen 241 stehen mit einer Fluidbereitstellungseinrichtung 243 der Fluidzuführungsvorrichtung 238 in Verbindung, die eine Pumpe aufweist, um das Fluid 228 mit einem Druck, der in der Regel bei mehreren bar liegt, in die flexiblen Fluidleitungen 241 zu pumpen. Die Fluidbereitstellungseinrichtung 243 weist auch eine Nachführungseinrichtung 244 auf, die zum Nachführen, genauer gesagt zum Nachschieben der flexiblen Fluidleitungen 241 dient, wenn die Abtragsfronten 230a, 230b in dem Substrat 225 bewegt werden, um die Hohlstruktur 227 zu bilden. Die Nachführungseinrichtung 244 kann beispielsweise eine Spule oder dergleichen aufweisen, auf der ein Abschnitt einer jeweiligen flexiblen Fluidleitung 241 aufgewickelt ist. Für das Nachführen kann die Spule mit einer konstanten Winkelgeschwindigkeit gedreht werden, die der Geschwindigkeit der Bewegung der Abtragsfront entspricht. Es versteht sich, dass die Nachführungseinrichtung 244 auch auf andere Weise ausgebildet sein kann.

Für die Herstellung der Hohlstruktur 227 wird das erste stabförmige, zylindrische Einlegebauteil 239 durch die Einlassöffnung 229 in den ersten Hohlraum 233 eingeführt, bis dieses mit einer Stirnseite am Ende des ersten Hohlraums 233 anliegt, der eine Sackbohrung bildet. Das Einlegebauteil 239 wird in Umfangsrichtung so ausgerichtet, dass in einer Mantelfläche 245 des Einlegebauteils 239 gebildete Öffnungen 246 an denjenigen Stellen an der Wand des Hohlraums 233 positioniert werden, von denen eine der Anzahl der Öffnungen 246 entsprechende Anzahl von Kanalabschnitten 237 von dem Hohlraum 233 ausgehen bzw. abzweigen. Die Ausrichtung des Einlegebauteils 239 in Umfangsrichtung kann auch dadurch erfolgen, dass an der Stirnseite 239a des stabförmigen Einlegebauteils 239 ein seitlich überstehender Abschnitt vorgesehen ist, vgl. Fig. 13c, der als Feder dient und der in eine entsprechend geformte Nut an der Seitenfläche des Substrats 225 eingreift, wie in Fig. 13b gestrichelt dargestellt ist.

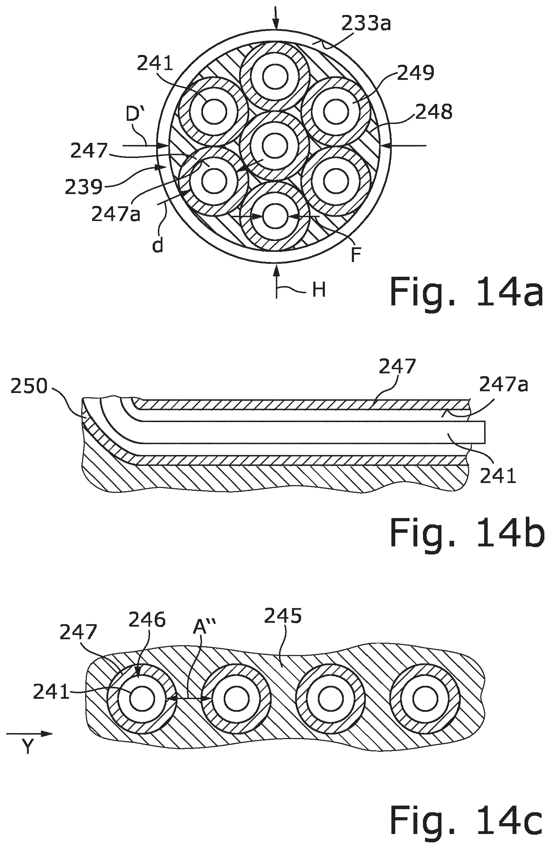

Um die flexiblen Fluidleitungen 241 in die Kanalabschnitte 237 einzuführen, weist das Einlegebauteil 239 im gezeigten Beispiel sieben Führungskanäle 247 auf, vgl. Fig. 14a-c. Es versteht sich, dass das Einlegebauteil 239 auch eine größere oder eine geringere Anzahl an Führungskanälen 247 aufweisen kann. Wie in Fig. 14a zu erkennen ist, die das Einlegebauteil 239 in einer Draufsicht auf seine in Fig. 13c dargestellte Stirnseite 239a zeigt, sind sechs der Führungskanäle 247 um einen zentralen Führungskanal 247 angeordnet. Bei den Führungskanälen 247 handelt es sich bei dem in Fig. 14a-c gezeigten Beispiel um Edelstahlrohre, die in ein festes Material 248 eingebettet bzw. eingegossen sind, welches den Durchmesser D' des Einlegebauteils 39 definiert, der im gezeigten Beispiel bei ca. 9 mm liegt. Der Durchmesser H des zylindrischen Hohlraums 233, genauer gesagt von dessen Innenwand 233a, ist etwas größer und liegt bei ca. 10 mm. Der Innendurchmesser d eines jeweiligen Führungskanals 247 liegt bei ca. 2 mm. Der Innen-Durchmesser F einer jeweiligen flexiblen Fluidleitung 241 liegt bei ca. 1 mm.

Wie in Fig. 14a gut zu erkennen ist, verläuft eine jeweilige Fluidleitung 241 in der Mitte eines jeweiligen Führungskanals 247. Zwischen der Fluidleitung 241 und einer Innenwand 247a eines jeweiligen Führungskanals 247 befindet sich ein Ringspalt 249. Der Ringspalt 249 dient zur Rückführung des Fluids 228, das durch die flexible Fluidleitung 241 einer jeweiligen Abtragsfront 230a, 230b zugeführt wird. Das rückgeführte Fluid 228 tritt an der Stirnseite 239a des Einlegebauteils 239 aus uns wird von dort abgeführt.

Wie in Fig. 14b zu erkennen ist, weist ein jeweiliger Führungskanal 247 des Einlegebauteils 239 einen abgerundeten Abschnitt 250 auf, um die Ausrichtung der flexiblen Fluidleitung 241 von einer Richtung parallel zur Längsrichtung, entsprechend der Y-Richtung, des Einlegebauteils 239 in eine dazu senkrechte Richtung zu ändern, damit die flexible Fluidleitung 241 an einer jeweiligen Öffnung 246 an der Mantelfläche 245 des stabförmigen Einlegebauteils 239 austreten kann. Der abgerundete Abschnitt 250 wird durch Biegen eines jeweiligen Edelstahlrohrs hergestellt, das den Führungskanal 247 bildet.

Wie in Fig. 13c und in Fig. 14c zu erkennen ist, sind die Öffnungen 246 in der Mantelfläche 245 des Einlegebauteils 239 entlang einer gemeinsamen Linie angeordnet, die der Längsrichtung, d.h. der Y-Richtung, des Einlegebauteils 239 entspricht. Dies ist typischerweise erforderlich, da die Kanalabschnitte 237 ebenfalls entlang einer gemeinsamen Linie verlaufen, die der Längsrichtung, d.h. der Y-Richtung, des Hohlraums 233 entspricht. Der Abstand A" zwischen benachbarten Öffnungen 246 an der Mantelfläche 245 entspricht dem Abstand zwischen benachbarten Kanalabschnitten 237 in dem Substrat 225. Es ist nicht zwingend erforderlich, dass die Kanalabschnitte 237 und die Öffnungen 246 in der Mantelfläche des Einlegebauteils 239 entlang einer gemeinsamen Linie verlaufen, vielmehr sind Abweichungen von einer solchen Anordnung entlang einer gemeinsamen Linie möglich.

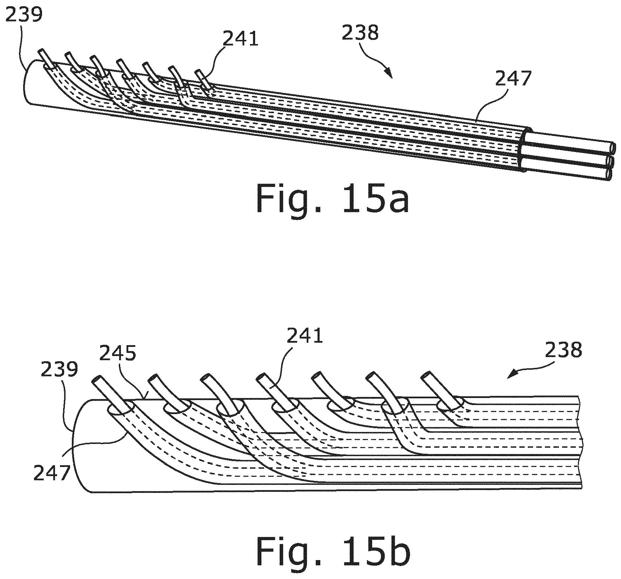

Um die Öffnungen 246 an der Mantelfläche 245 in Längsrichtung nebeneinander anzuordnen, ist es typischerweise erforderlich, die Führungskanäle 247 unterschiedlich lang auszubilden und die gekrümmten Abschnitte 250 gegeneinander zu verdrehen, wie dies in Fig. 15a,b gut zu erkennen ist, die ein Einlegebauteil 239 zeigt, das sich von dem in Fig. 14a-c gezeigten Einlegebauteil 239 dadurch unterscheidet, dass es durch ein additives Fertigungsverfahren hergestellt wurde. Das in Fig. 15a,b gezeigte Einlegebauteil 239 besteht aus einem zylindrischen Grundkörper, in dem die Führungskanäle 247 bei der additiven Fertigung gebildet wurden.

Die über die Mantelfläche 245 des Einlegebauteils 239 überstehenden freien Enden der Fluidleitungen 241, die in Fig. 15b dargestellt sind, ragen im Betrieb der Fluidzuführungsvorrichtung 238 in die Kanalabschnitte 237 hinein. Für die Herstellung des in Fig. 13c gestrichelt dargestellten Teils der Hohlstruktur 227 wird durch die Einstrahlung gepulster Laserstrahlung eine Abtragsfront 230a, 230b an den Stirnseiten der bereits gebildeten Kanalabschnitte 237 erzeugt. Die Stirnseiten der bereits gebildeten Kanalabschnitte 237 bilden eine der Strahlungseintrittsseite gegenüberliegende Seite des Substrats 225, von der ausgehend die Abtragsfront 230a, 230b relativ zu dem Substrat 225 bewegt wird, indem des Substrat 225 in Z-Richtung nach unten verschoben wird, bis die Abtragsfront 230a sich auf Höhe des horizontal verlaufenden Kühlkanals 231 befindet. Alternativ kann z.B. die Fokusposition der eingestrahlten gepulsten Laserstrahlung an allen Punkten entlang der Abtragsfront 230a um denselben Betrag nach oben versetzt werden, um die Abtragsfront 230a im Substrat 225 zu bewegen, während das Substrat 225 selbst ortsfest bleibt.

Zur Bildung des horizontalen Kühlkanals 231 wird die unter ca. 45° zur Dickenrichtung, d.h. zur Z-Richtung, des Substrats 225 bzw. zur Einstrahlungsrichtung des gepulsten Laserstrahls ausgerichtete Abtragsfront 230a in Längsrichtung, d.h. in X-Richtung, des Kühlkanals 231 verschoben, bis diese sich in etwa in der Mitte des Kühlkanals 231 befindet. Hierbei ruht typischerweise das Substrat 225 und die Optik zur Einstrahlung der Laserstrahlen auf das Substrat 225 wird geeignet verstellt oder bewegt, um die Abtragsfront 230a in horizontaler Richtung zu verschieben.

Unter Verwendung eines weiteren Einlegebauteils einer weiteren, nicht bildlich dargestellten Fluidzuführungseinrichtung wird typischerweise zeitparallel ausgehend von dem zweiten Hohlraum 235 eine Mehrzahl von sieben Sammlerkanälen 235 durch Multi-Photonen-Laserablation erzeugt, indem das Substrat 225 nach unten verschoben wird oder indem die Fokusposition der eingestrahlten gepulsten Laserstrahlung an jedem Punkt der Abtragsfront 230b um einen konstanten Betrag nach oben verschoben wird, wobei das Substrat 225 ortsfest bleibt. Die Abtragsfront 230b wird nachfolgend bei ruhendem Substrat 225 in Y-Richtung bewegt. Ungefähr in der Mitte eines jeweiligen Kühlkanals 231, der beispielsweise eine Länge von ca. 400 mm aufweisen kann, kommt es zu einer Überlappung der beiden Abtragsfronten 230a, 230b, wodurch ein durchgehender Kühlkanal 231 entsteht, der durch den Verteilerkanal 234 mit dem als Fluidverteiler dienenden ersten Hohlraum 233 und durch den Sammlerkanal 236 mit dem zweiten als Fluidsammler dienenden Hohlraum 235 verbunden ist.

Auf die weiter oben beschriebene Weise ist es möglich, sieben Verteilerkanäle 324, Kühlkanäle 231 und Sammlerkanäle 236 gleichzeitig herzustellen, wodurch die Zeitdauer bei der Herstellung der Hohlstruktur 227 deutlich reduziert werden kann. Um die übrigen sieben Verteilerkanäle 234, Kühlkanäle 231 und Sammlerkanäle 236 der in Fig. 13c dargestellten Hohlstruktur 27 herzustellen, kann das in Fig. 13c dargestellte Einlegebauteil 240 verwendet werden, bei dem die Öffnungen 246' für den Austritt der Fluidleitungen 241 in Bezug auf die Öffnungen 246 des ersten Einlegebauteils 239 versetzt sind. Die Herstellung der zweiten Gruppe von sieben Verteilerkanälen 234, Kühlkanälen 231 und Sammlerkanälen 236 erfolgt analog zur Herstellung der ersten Gruppe, indem das zweite Einlegebauteil 240 in den ersten Hohlraum 233 eingelegt wird.

Es versteht sich, dass anders als in Fig. 13c dargestellt ist das zweite Einlegebauteil 240 eine geringere Länge aufweisen kann als das erste Einlegebauteil 239. Ist dies der Fall, kann vor dem Einlegen des zweiten Einlegebauteils 240 ein Abstandshalter, beispielsweise in Form eines Vollzylinders, in den Hohlraum 233 eingeführt werden, an dessen Stirnseite das Einlegebauteil 240 beim Einschieben in Anlage gebracht wird. Alternativ können einer oder mehrere überstehende Abschnitte an der Stirnseite des Einlegebauteils 240 als Stopper bzw. als Anlageflächen dienen, um die Bewegung des zweiten Einlegebauteils 240 beim Einführen in den Hohlraum 233 zu begrenzen. Die Stopper, die an der Stirnseite des zweiten Einlegebauteils 240 angebracht sind, können auch als Federn dienen und in entsprechende Nuten an der Außenseite des Substrats 225 eingreifen, um wie weiter oben beschrieben das zweite Einlegebauteil 240 geeignet in Umfangsrichtung auszurichten.

Mit Hilfe der weiter oben beschriebenen Fluidzuführungsvorrichtung 238 kann bei der Herstellung komplexer Hohlstrukturen 227, wie sie in Fig. 13c dargestellt sind, eine automatisierte Nachführung der flexiblen Fluidleitungen 241 zu mehreren zeitgleich erzeugten Abtragsfronten 230a, 230b erfolgen. Auf diese Weise kann eine Mehrzahl von Strukturen, beispielsweise von Kühlkanälen 231, zeitparallel hergestellt werden, was eine signifikante Zeitersparnis bzw. Steigerung der Produktivität bei der Herstellung der komplexen Hohlstruktur 227 zur Folge hat.

Die weiter oben in Zusammenhang mit Fig. 6a-c beschriebene Fluidzuführung 50 kann beispielsweise wie die in Zusammenhang mit Fig. 13c, Fig. 14a-c und Fig. 15a,b beschriebene Fluidzuführungsvorrichtung 238 ausgebildet sein. Es ist aber auch möglich, dass die Fluidzuführung 50 nur einen Teil der Bestandteile der Fluidzuführungsvorrichtung 238 aufweist, beispielsweise die Fluidbereitstellungseinrichtung 243 und ggf. die Nachführungseinrichtung 244. Letztere kann beispielsweise zur automatisierten Nachführung mindestens einer flexiblen Fluidleitung 241 in Form des in Zusammenhang mit Fig. 6a-c beschriebenen flexiblen Schlauchs 52 verwendet werden.

Die vorliegende Erfindung weist auch die Aspekte auf, die in den nachfolgenden Klauseln definiert sind, welche einen Teil der Beschreibung bilden, bei denen es sich aber nicht um Ansprüche handelt.
1. Verfahren zum Erzeugen einer Hohlstruktur (28) in einem Werkstück (25), insbesondere in einem Substrat für einen EUV-Spiegel (M4), durch materialabtragende Bearbeitung mittels gepulster Laserstrahlung (35), umfassend:
   Einstrahlen der gepulsten Laserstrahlung (35) von einer
   Strahlungseintrittsseite (27) in das Werkstück (25), das aus einem für die gepulste Laserstrahlung (35) transparenten Material gebildet ist, Fokussieren der gepulsten Laserstrahlung (35) in einem Fokusbereich (39), Bilden einer Abtragsfront (46) zum flächigen Abtrag von Material des Werkstücks (25) durch Bewegen des Fokusbereichs (35) entlang von zueinander versetzten Bewegungsbahnen (42) eines Bewegungsmusters (41), sowie
   Erzeugen der Hohlstruktur (28) durch Bewegen der Abtragsfront (46) innerhalb des Werkstücks (25) ausgehend von einer der Strahlungseintrittsseite (27) gegenüberliegenden Seite (29) des Werkstücks (25),
   dadurch gekennzeichnet,
   dass beim Erzeugen der Hohlstruktur (28) zumindest zeitweise eine Abtragsfront (46) gebildet wird, die nicht senkrecht zu einer Einstrahlungsrichtung (Z) der gepulsten Laserstrahlung (35) auf die Strahlungseintrittsseite (27) des Werkstücks (25) ausgerichtet ist.
2. Verfahren nach Klausel 1, bei dem zumindest zeitweise eine Abtragsfront (46) gebildet wird, die unter einem Winkel (α) zwischen 20° und 70°, bevorzugt zwischen 30° und 60°zur Einstrahlungsrichtung (Z) der gepulsten Laserstrahlung (35) auf die Strahlungseintrittsseite (27) des Werkstücks (25) ausgerichtet ist.
3. Verfahren nach Klausel 1 oder 2, bei dem zum Bilden der nicht senkrecht zur Einstrahlungsrichtung (Z) ausgerichteten Abtragsfront (46) die Bewegungsbahnen (42) des Bewegungsmusters (41) in Einstrahlungsrichtung (Z) zueinander versetzt werden, indem der Fokusbereich (39) in Einstrahlungsrichtung (Z) versetzt wird.
4. Verfahren nach einer der vorhergehenden Klauseln, bei dem zum Bilden der nicht senkrecht zur Einstrahlungsrichtung (Z) ausgerichteten Abtragsfront (46) eine Pulsenergie (E_{P}) der gepulsten Laserstrahlung (35) der zueinander versetzten Bewegungsbahnen (42) des Bewegungsmusters (41) verändert wird, wobei bevorzugt der Fokusbereich (39) in einer Ebene (FE) senkrecht zur Einstrahlungsrichtung (Z) bewegt wird.
5. Verfahren nach einer der vorhergehenden Klauseln, bei dem beim Erzeugen der Hohlstruktur (28) die Abtragsfront (46) zumindest zeitweise in einer Bewegungsrichtung (-X) quer zur Einstrahlungsrichtung (Z) innerhalb des Werkstücks bewegt wird, um einen Abschnitt (28b) der Hohlstruktur (28) zu bilden, der bevorzugt im Wesentlichen parallel zur Strahleintrittsfläche (27) verläuft, wobei die Abtragsfront (46) bei der Bewegung quer zur Einstrahlungsrichtung (Z) bevorzugt an ihrem der Strahlungseintrittsseite (27) zugewandten Rand (46a) unter einem Winkel (β) von weniger als 90°, bevorzugt von weniger als 70°, zur Bewegungsrichtung (-X) ausgerichtet ist.
6. Verfahren nach einer der vorhergehenden Klauseln, bei dem die Abtragsfront (46) beim Erzeugen der Hohlstruktur (28) zumindest zeitweise im Wesentlichen parallel zur Einstrahlungsrichtung (Z) bewegt wird, um ausgehend von der der Strahlungseintrittsseite (27) gegenüberliegenden Seite (29) des Werkstücks (25) einen Abschnitt (28a) der Hohlstruktur (28) zu erzeugen, der im Wesentlichen parallel zur Einstrahlungsrichtung (Z) verläuft, sowie bevorzugt um einen weiteren Abschnitt (28c) der Hohlstruktur (28) zu erzeugen, der im Wesentlichen parallel zur Einstrahlungsrichtung (Z) verläuft.
7. Verfahren nach einer der vorhergehenden Klauseln, bei dem ein erster Abschnitt (28a, 28c) der Hohlstruktur (28) und ein zweiter, angrenzender Abschnitt (28b) der Hohlstruktur (28) erzeugt werden, deren Längsrichtungen (X, Z) unter einem Winkel (γ) zwischen 70° und 100°, bevorzugt unter einem Winkel (γ) von 90°, zueinander ausgerichtet sind.
8. Verfahren nach Klausel 7, bei dem beim Erzeugen der Hohlstruktur (28) ein abgerundeter Abschnitt (28d, 28e) gebildet wird, an dem der erste Abschnitt (28a, 28c) und der zweite Abschnitt (28b) ineinander übergehen.
9. Verfahren nach einer der vorhergehenden Klauseln, bei dem die Abtragsfront (46) beim Erzeugen der Hohlstruktur (28) in Kontakt mit einem Fluid (32b) gebracht wird, wobei bei der Bewegung der Abtragsfront (46) ausgehend von der der Strahlungseintrittsseite (27) abgewandten Seite (29) des Werkstücks (25) das Fluid (32b) der Abtragsfront (46) bevorzugt mittels eines flexiblen Schlauchs (52) nachgeführt wird.
10. Verfahren nach einer der vorhergehenden Klauseln, bei dem zum Bewegen der Abtragsfront (46) das Werkstück verschoben wird.
11. Verfahren nach einer der vorhergehenden Klauseln, bei dem zum Bilden der Abtragsfront (46) der Fokusbereich (39) mittels einer Scanneroptik (36) entlang der zueinander versetzten Bewegungsbahnen (42) des Bewegungsmusters (41) bewegt wird.
12. Verfahren nach einer der vorhergehenden Klauseln, bei dem das Substrat (25) monolithisch ist und aus titandotiertem Quarzglas oder aus einer Glaskeramik besteht.
13. EUV-Spiegel (M4), umfassend:
   ein Substrat (25),
   eine auf das Substrat (25) aufgebrachte Beschichtung (26) zur Reflexion von EUV-Strahlung (16),
   dadurch gekennzeichnet,
   dass das Substrat (25) mindestens eine mit dem Verfahren nach einem der vorhergehenden Ansprüche erzeugte Hohlstruktur (28) aufweist.
14. EUV-Lithographiesystem (1), umfassend: mindestens einen EUV-Spiegel (M4) nach Klausel 13, sowie eine Kühleinrichtung (32), die zum Durchströmen der mindestens einen Hohlstruktur (28) mit einem Kühlfluid (32a) ausgebildet ist.
15. Vorrichtung (33) zum Erzeugen mindestens einer Hohlstruktur (28) in einem Werkstück (25), insbesondere in einem Substrat für einen EUV-Spiegel (M4), umfassend:
   eine Laserquelle (34) zur Erzeugung von gepulster Laserstrahlung (35),
   eine Fokussiereinrichtung (37) zur Fokussierung der Laserstrahlung (35) in einem Fokusbereich (39),
   eine Halterung (44) zur Aufnahme des Werkstücks (25),
   eine Scanneroptik (36), die zur Einstrahlung der gepulsten Laserstrahlung (35) auf eine Strahleintrittsseite (27) des von der Halterung (44) aufgenommenen Werkstücks (25) und zum Bewegen des Fokusbereichs (39) entlang von zueinander versetzten Bewegungsbahnen (42) eines Bewegungsmusters (41) ausgebildet ist, um eine Abtragsfront (46) zum flächigen Abtrag von Material des Werkstücks (25) zu bilden, sowie eine Positioniereinrichtung (43) zum Bewegen der Abtragsfront (46) innerhalb des Werkstücks (25) ausgehend von einer der Strahlungseintrittsseite (27) gegenüberliegenden Seite (29) des Werkstücks (25) zum Erzeugen der Hohlstruktur (28),
   dadurch gekennzeichnet,
   dass die Vorrichtung (33) zum Bilden einer Abtragsfront (46) ausgebildet ist, die nicht senkrecht zu einer Einstrahlungsrichtung (Z) der gepulsten Laserstrahlung (35) auf das von der Halterung (44) aufgenommene Werkstück (25) ausgerichtet ist.
16. Vorrichtung nach Klausel 15, weiter umfassend: eine Fokusversatz-Einrichtung (47) zum Versetzen des Fokusbereichs (39) der gepulsten Laserstrahlung (35) in Einstrahlungsrichtung (Z), sowie eine Steuerungseinrichtung (48), die ausgebildet ist, die Fokusversatz-Einrichtung (47) anzusteuern, zur Bildung der nicht senkrecht zur Einstrahlungsrichtung (Z) ausgerichteten Abtragsfront (46) die Bewegungsbahnen (42) des Bewegungsmusters (41) in Einstrahlungsrichtung (Z) zueinander zu versetzen.
17. Vorrichtung nach Klausel 15 oder 16, weiter umfassend:
   eine Steuerungseinrichtung (48), die ausgebildet ist, die Laserquelle (34) anzusteuern, eine Pulsenergie (E_{P}) der gepulsten Laserstrahlung (35) der zueinander versetzten Bewegungsbahnen (42) des Bewegungsmusters (41) zu verändern, um die nicht senkrecht zur Einstrahlungsrichtung (Z) ausgerichtete Abtragsfront (46) zu bilden.
18. Vorrichtung nach einer der Klauseln 15 bis 17, bei der die Positioniereinrichtung (43) zur Verschiebung des Werkstücks (25) in Einstrahlungsrichtung (Z) und bevorzugt in mindestens einer Richtung (X, Y) quer zur Einstrahlungsrichtung (Z) ausgebildet ist.
19. Vorrichtung nach einer der Klauseln 15 bis 18, weiter umfassend:
   eine Fluidzuführung (50), die zur Zuführung eines Fluids (32b) zu der Abtragsfront (46) ausgebildet ist, wobei die Fluidzuführung (50) bevorzugt einen flexiblen Schlauch (52) zur Nachführen des Fluids (32b) beim Bewegen der Abtragsfront (46) ausgehend von der der Strahlungseintrittsseite (27) abgewandten Seite (29) des Werkstücks (25) aufweist.
20. Optisches Element (M4) zur Reflexion von Strahlung, insbesondere zur Reflexion von EUV-Strahlung (16), umfassend:
   ein monolithisches Substrat (25),
   eine reflektierende Beschichtung (26), die auf eine Oberfläche (25a) des monolithischen Substrats (25) aufgebracht ist, sowie
   mindestens eine Hohlstruktur (27), die in dem monolithischen Substrat (25) verläuft und die zur Durchströmung mit einem Fluid (28) ausgebildet ist, wobei die Hohlstruktur (27) einen ersten Abschnitt (31a, 31b; 34b, 36b) und einen zweiten, benachbarten Abschnitt (34a, 36a; 33a, 35a) aufweist, die unter einem Winkel (γ, γ') zwischen 60° und 120°, bevorzugt unter einem Winkel (γ, γ') zwischen 80° und 100°, insbesondere unter einem Winkel (γ, γ') von 90°, zueinander ausgerichtet sind,
   dadurch gekennzeichnet,
   dass die Hohlstruktur (27) einen abgerundeten Abschnitt (37a, 37b, 38) aufweist, an dem der erste Abschnitt (31a, 31b; 34b, 36b) und der zweite Abschnitt (34a; 36a; 33a, 35a) ineinander übergehen.
21.Optisches Element nach Klausel 20, bei dem ein Krümmungsradius R des abgerundeten Abschnitts (37a, 37b) und ein Durchmesser D des abgerundeten Abschnitts (37a, 37b) ein Verhältnis R / D aufweisen, das zwischen 2 und 6, bevorzugt zwischen 2,5 und 5, insbesondere zwischen 2,5 und 3,5 liegt.
22. Optisches Element nach Klausel 20 oder 21, bei dem der Durchmesser D des abgerundeten Abschnitts (37a, 37b) zwischen 2 mm und 20 mm, bevorzugt zwischen 2 mm und 12 mm, liegt.
23. Optisches Element nach einer der Klauseln 20 bis 22, bei dem die Hohlstruktur (27) eine Mehrzahl von Kühlkanälen (31) aufweist, die unterhalb der Oberfläche (25a) verlaufen, auf welche die reflektierende Beschichtung (26) aufgebracht ist, und bei dem die Hohlstruktur (27) einen über Verteilerkanäle (34) mit den Kühlkanälen (31) verbunden Fluidverteiler (33) sowie einen über Sammlerkanäle (36) mit den Kühlkanälen (31) verbundenen Fluidsammler (35) aufweist.
24. Optisches Element nach Klausel 23, bei dem der erste Abschnitt einen an einen Verteilerkanal (34) angrenzenden Endabschnitt (31a) des Kühlkanals (31) bildet und der zweite Abschnitt einen an den Endabschnitt (31a) angrenzenden Verteilerkanalabschnitt (34a) bildet und/oder bei dem der erste Abschnitt einen an einen Sammlerkanal (36) angrenzenden Endabschnitt (31b) des Kühlkanals (31) bildet und bei dem der zweite Abschnitt einen an den Endabschnitt (31b) angrenzenden Sammlerkanalabschnitt (36a) bildet.
25. Optisches Element nach Klausel 23 oder 24, bei dem Fluidverteiler einen Einlasskanal (33) bildet, von dem die Verteilerkanäle (34) abzweigen und/oder bei dem der Fluidsammler einen Auslasskanal (35) bildet, von dem die Sammlerkanäle (36) abzweigen.
26. Optisches Element nach Klausel 25, bei dem der erste Abschnitt einen dem Einlasskanal (33) benachbarten Mündungsabschnitt (34b) des Verteilerkanals (34) bildet und bei dem der zweite Abschnitt einen dem Mündungsabschnitt (34b) benachbarten Verzweigungsabschnitt (33a) des Einlasskanals (33) bildet und/oder bei dem der erste Abschnitt einen dem Auslasskanal (35) benachbarten Mündungsabschnitt (36b) des Sammlerkanals (36) bildet und bei dem der zweite Abschnitt einen dem Mündungsabschnitt (36b) des Sammlerkanals (36) benachbarten Verzweigungsabschnitt (35a) des Auslasskanals (35) bildet.
27. Optisches Element nach Klausel 26, bei dem der Winkel (γ') zwischen dem Verzweigungsabschnitt (33a) des Einlasskanals (33) und dem Mündungsabschnitt (34b) des Verteilerkanals (34) größer als 90°, bevorzugt größer als 100° ist und/oder bei dem der Winkel (γ') zwischen dem Verzweigungsabschnitt des Auslasskanals (35) und dem Mündungsabschnitt (36b) des Sammlerkanals (35) größer als 90°, bevorzugt größer als 100° ist.
28. Optisches Element nach einer der Klauseln 20 bis 27, bei dem das Material des Substrats (25) ausgewählt ist aus der Gruppe umfassend: Quarzglas, insbesondere titandotiertes Quarzglas, und Glaskeramik.
29. Optische Anordnung, insbesondere EUV-Lithographiesystem (1), umfassend:
   mindestens ein optisches Element (M4) nach einer der Klauseln 20 bis 28, sowie
   eine Temperier-Einrichtung, insbesondere eine Kühleinrichtung (32), die zum Durchströmen der mindestens einen Hohlstruktur (27) mit einem Fluid (28) ausgebildet ist.
30. Fluidzuführungsvorrichtung (38) zum Zuführen eines Fluids (28) zu mindestens einer Ablationsfront (30a, 30b) beim Abtragen von Material durch Multi-Photonen-Laserablation von einem Werkstück, bevorzugt von einem insbesondere monolithischen Substrat (25) für einen EUV-Spiegel (M4), umfassend:
   mindestens eine flexible Fluidleitung (41), bevorzugt eine Mehrzahl von flexiblen Fluidleitungen (41), zum Zuführen des Fluids (28) zu der mindestens einen Ablationsfront (30a, 30b), sowie
   mindestens ein Einlegebauteil (39, 40) zum Einlegen in einen Hohlraum (33, 35) des Werkstücks (25), wobei das Einlegebauteil (39, 40) mindestens einen Führungskanal (47) aufweist, in dem die mindestens eine flexible Fluidleitung (41) geführt ist, um das Fluid (28) der mindestens einen Ablationsfront (30a, 30b) zuzuführen.
31. Fluidzuführungsvorrichtung nach Klausel 30, bei der das Einlegebauteil (39, 40) eine Mehrzahl von Führungskanälen (47) aufweist, in denen jeweils eine flexible Fluidleitung (41) geführt ist.
32. Fluidzuführungsvorrichtung nach Klausel 30 oder 31, bei der zwischen der Fluidleitung (41) und einer Kanalwand (47a) des Führungskanals (47) ein durchströmbarer Spalt, insbesondere ein Ringspalt (49), zur Rückführung des Fluids (28) von der Ablationsfront (30a, 30b) gebildet ist.
33. Fluidzuführungsvorrichtung nach einer der Klauseln 30 bis 32, bei welcher der Führungskanal (47) mindestens einen abgerundeten Abschnitt (50) zur Richtungsänderung der flexiblen Fluidleitung (41) aufweist.
34. Fluidzuführungsvorrichtung nach einer der Klauseln 30 bis 33, bei der das Einlegebauteil (39, 40) stabförmig ist und der Führungskanal (47) sich von einer Stirnseite (48) des Einlegebauteils (39) zu einer Mantelfläche (45) des Einlegebauteils (39) erstreckt.
35. Fluidzuführungsvorrichtung nach Klausel 34, bei welcher die Führungskanäle (41) an der Mantelfläche (45) des Einlegebauteils (39) in Öffnungen (46) münden, die bevorzugt in Längsrichtung (Y) des Einlegebauteils (39) nebeneinander angeordnet sind und die insbesondere in Längsrichtung (Y) des Einlegebauteils (39) in gleichen Abständen (A) voneinander angeordnet sind.
36. Fluidzuführungsvorrichtung nach Klausel 34 oder 35, bei der das stabförmige Einlegebauteil (39) zylindrisch ausgebildet ist und bevorzugt einen Durchmesser (D) zwischen 5 mm und 10 mm aufweist.
37. Fluidzuführungsvorrichtung nach einer der Klauseln 30 bis 36, bei welcher der mindestens eine Führungskanal (47) einen Durchmesser (d) zwischen 1 mm und 4 mm aufweist.
38. Fluidzuführungsvorrichtung nach einer der Klauseln 30 bis 37, bei welcher die mindestens eine Fluidleitung (41) einen Außendurchmesser (F) von 1 mm oder weniger aufweist.
39. Fluidzuführungsvorrichtung nach einer der Klauseln 30 bis 38, weiter umfassend: eine Fluidbereitstellungseinrichtung (43) zur Zuführung des Fluids (28) zu der mindestens einen flexiblen Fluidleitung (41).
40. Fluidzuführungsvorrichtung nach einer der Klauseln 30 bis 39, weiter umfassend: mindestens eine Nachführungseinrichtung (44) zur automatisierten Nachführung der mindestens einen flexiblen Fluidleitung (41) bei einer Bewegung der Ablationsfront (30a, 30b) im Material des Werkstücks (25).
41. Verfahren zum Zuführen eines Fluids (28) zu mindestens einer Ablationsfront (30a, 30b) beim Abtragen von Material durch Multi-Photonen-Laserablation von einem Werkstück, insbesondere von einem bevorzugt monolithischen Substrat (25) für einen EUV-Spiegel (M4), mittels einer Fluidzuführungsvorrichtung (38) nach einer der Klauseln 30 bis 40, umfassend:
   Einlegen des Einlegebauteils (39, 40) in einen Hohlraum (33, 35) des Werkstücks (25), sowie
   Zuführen des Fluids (28) zu der mindestens einen Ablationsfront (30a, 30b) durch die mindestens eine flexible Fluidleitung (41), die in dem mindestens einen Führungskanal (47) des Einlegebauteils (39, 40) geführt ist.
42. Verfahren nach Klausel 41, bei dem vor dem Einlegen des Einlegebauteils (39, 40) der Hohlraum (33, 35) mit einem Fluid (28) gefüllt wird und ausgehend von dem mit dem Fluid (28) gefüllten Hohlraum (33, 35) durch Multi-Photonen-Laserablation eine Mehrzahl von an den Hohlraum (33, 35) angrenzenden Kanalabschnitten (37) gebildet wird.
43. Verfahren nach Klausel 42, bei dem nach dem Einlegen des Einlegebauteils (39, 40) in den Hohlraum (33, 35) ausgehend von den Kanalabschnitten (37) eine Mehrzahl von Ablationsfronten (30a, 30b) erzeugt und im Material des Werkstücks (25) bewegt werden, um eine Mehrzahl von Kanälen (31, 34, 35) zu bilden, wobei die Mehrzahl der flexiblen Fluidleitungen (41) bei der Bewegung der Ablationsfronten (30a, 30b) im Material des Werkstücks (25) nachgeführt werden.

Die vorliegende Erfindung zudem auch die Aspekte auf, die in den nachfolgenden Klauseln definiert sind, welche einen Teil der Beschreibung bilden, bei denen es sich aber nicht um Ansprüche handelt.
1. Verfahren zum Erzeugen einer Hohlstruktur (28) in einem Werkstück (25), in Form eines Substrats für einen Spiegel, insbesondere für einen EUV-Spiegel (M4), durch materialabtragende Bearbeitung mittels gepulster Laserstrahlung (35), umfassend:
   Einstrahlen der gepulsten Laserstrahlung (35) von einer Strahlungseintrittsseite (27) in das Werkstück (25), das aus einem für die gepulste Laserstrahlung (35) transparenten Material gebildet ist,
   Fokussieren der gepulsten Laserstrahlung (35) in einem Fokusbereich (39), Bilden einer Abtragsfront (46) zum flächigen Abtrag von Material des Werkstücks (25) durch Bewegen des Fokusbereichs (35) entlang eines Bewegungsmusters (41), sowie
   Erzeugen der Hohlstruktur (28) durch Bewegen der Abtragsfront (46) innerhalb des Werkstücks (25),
   dadurch gekennzeichnet,
   dass beim Erzeugen der Hohlstruktur (28) zumindest zeitweise eine Abtragsfront (46) gebildet wird, die nicht senkrecht zu einer Einstrahlungsrichtung (Z) der gepulsten Laserstrahlung (35) auf die
   Strahlungseintrittsseite (27) des Werkstücks (25) ausgerichtet ist und dass die Hohlstruktur (28) in Form eines mit einem Fluid (32a) durchströmbaren Kanals (28) erzeugt wird.
2. Verfahren nach Klausel 1, bei dem die Hohlstruktur in Form eines mit einem Fluid (32a) durchströmbaren gekrümmten Kanals (28) erzeugt wird.
3. Verfahren nach Klausel 1 oder 2, bei dem die gepulste Laserstrahlung (35) im Bereich der Abtragsfront (46) erstmalig aus dem Material des Werkstücks (25) austritt.
4. Verfahren nach Klausel 3, bei dem die gepulste Laserstrahlung (35) nach dem Austritt aus dem Material des Werkstücks (25) erneut in das Material des Werkstücks (25) eintritt.
5. Verfahren nach einer der vorhergehenden Klauseln, bei dem die Abtragsfront (46) innerhalb des Werkstücks (25) zumindest zeitweise in Richtung auf die Strahlungseintrittsseite (27) des Werkstücks (25) bewegt wird.
6. Verfahren nach einer der vorhergehenden Klauseln, bei dem beim Bewegen der Abtragsfront (46) innerhalb des Werkstücks (25) zumindest zeitweise an einer der Strahlungseintrittsseite (27) des Werkstücks (25) abgewandten Seite (46c) eines der Strahlungseintrittsseite (27) des Werkstücks (25) abgewandten Randes (46b) der Abtragsfront (46) Material des Werkstücks (25) angrenzt.
7. Verfahren nach einer der vorhergehenden Klauseln, bei dem die Abtragsfront (46) ausgehend von einer der Strahlungseintrittsseite (27) gegenüberliegenden Seite (29) des Werkstücks (25) bewegt wird.
8. Verfahren nach einer der vorhergehenden Klauseln, bei dem zumindest zeitweise eine Abtragsfront (46) gebildet wird, die unter einem Winkel (α) zwischen 20° und 70°, bevorzugt zwischen 30° und 60°zur Einstrahlungsrichtung (Z) ausgerichtet ist.
9. Verfahren nach einer der vorhergehenden Klauseln, bei dem das Bewegen des Fokusbereichs (35) entlang von zueinander versetzten Bewegungsbahnen (42) des Bewegungsmusters (41) erfolgt.
10. Verfahren nachKlausel 9, bei dem zum Bilden der nicht senkrecht zur Einstrahlungsrichtung (Z) ausgerichteten Abtragsfront (46) die Bewegungsbahnen (42) des Bewegungsmusters (41) entlang der Einstrahlungsrichtung (Z) zueinander versetzt werden, indem der Fokusbereich (39) entlang der Einstrahlungsrichtung (Z) versetzt wird.
11. Verfahren nach Klausel 9 oder 10, bei dem zum Bilden der nicht senkrecht zur Einstrahlungsrichtung (Z) ausgerichteten Abtragsfront (46) eine Pulsenergie (E_{P}) der gepulsten Laserstrahlung (35) der zueinander versetzten Bewegungsbahnen (42) des Bewegungsmusters (41) verändert wird, wobei bevorzugt der Fokusbereich (39) in einer Ebene (FE) senkrecht zur Einstrahlungsrichtung (Z) bewegt wird.
12. Verfahren nach einer der vorhergehenden Klauseln, bei dem beim Erzeugen der Hohlstruktur (28) die Abtragsfront (46) zumindest zeitweise in einer Bewegungsrichtung (-X) quer zur Einstrahlungsrichtung (Z) innerhalb des Werkstücks bewegt wird, um einen Abschnitt (28b) der Hohlstruktur (28) zu bilden, der bevorzugt im Wesentlichen parallel zur Strahlungseintrittsseite (27) verläuft, wobei die Abtragsfront (46) bei der Bewegung quer zur Einstrahlungsrichtung (Z) bevorzugt an ihrem der Strahlungseintrittsseite (27) zugewandten Rand (46a) unter einem Winkel (β) von weniger als 90°, bevorzugt von weniger als 70°, zur Bewegungsrichtung (-X) ausgerichtet ist.
13.Verfahren nach einer der vorhergehenden Klauseln, bei dem die Abtragsfront (46) beim Erzeugen der Hohlstruktur (28) zumindest zeitweise im Wesentlichen parallel zur Einstrahlungsrichtung (Z) bewegt wird, um ausgehend von der der Strahlungseintrittsseite (27) gegenüberliegenden Seite (29) des Werkstücks (25) einen Abschnitt (28a) der Hohlstruktur (28) zu erzeugen, der im Wesentlichen parallel zur Einstrahlungsrichtung (Z) verläuft, sowie bevorzugt um einen weiteren Abschnitt (28c) der Hohlstruktur (28) zu erzeugen, der im Wesentlichen parallel zur Einstrahlungsrichtung (Z) verläuft.
14. Verfahren nach einer der vorhergehenden Klauseln, bei dem ein erster Abschnitt (28a, 28c) der Hohlstruktur (28) und ein zweiter, angrenzender Abschnitt (28b) der Hohlstruktur (28) erzeugt werden, deren Längsrichtungen (X, Z) unter einem Winkel (γ) zwischen 70° und 100°, bevorzugt unter einem Winkel (γ) von 90°, zueinander ausgerichtet sind.
15. Verfahren nach Klausel 14, bei dem beim Erzeugen der Hohlstruktur (28) ein abgerundeter Abschnitt (28d, 28e) gebildet wird, an dem der erste Abschnitt (28a, 28c) und der zweite Abschnitt (28b) ineinander übergehen.
16. Verfahren nach einer der vorhergehenden Klauseln, bei dem die Abtragsfront (46) beim Erzeugen der Hohlstruktur (28) in Kontakt mit einem Fluid (32b) gebracht wird, wobei bei der Bewegung der Abtragsfront (46) das Fluid (32b) der Abtragsfront (46) mittels einer Fluidzuführung (50) nachgeführt wird, die zumindest teilweise in die Hohlstruktur (28) eingeführt wird.
17. Verfahren nach Klausel 16, bei dem die Fluidzuführung (50) mindestens einen flexiblen Schlauch (52) aufweist und das Fluid (32b) der Abtragsfront (46) mittels des mindestens einen flexiblen Schlauchs (52) insbesondere ausgehend von einer der Strahlungseintrittsseite (27) abgewandten Seite (29) des Werkstücks (25) nachgeführt wird.
18. Verfahren nach einer der vorhergehenden Klauseln, bei dem zum Bewegen der Abtragsfront (46) das Werkstück verschoben wird.
19. Verfahren nach einer der vorhergehenden Klauseln, bei dem zum Bilden der Abtragsfront (46) der Fokusbereich (39) mittels einer Scanneroptik (36) entlang von zueinander versetzten Bewegungsbahnen (42) des Bewegungsmusters (41) bewegt wird.
20.Verfahren nach einer der vorhergehenden Klauseln, bei dem die Hohlstruktur einen runden Querschnitt mit einem Durchmesser (D) zwischen 1 mm und 20 mm, bevorzugt zwischen 1 mm und 5 mm, aufweist.
21. Verfahren nach einer der vorhergehenden Klauseln, bei dem die Hohlstruktur eine Länge (L_{C}) von mindestens 10 cm, bevorzugt von mindestens 15 cm, besonders bevorzugt von mindestens 20 cm, insbesondere von mindestens 70 cm aufweist.
22. Verfahren nach dem Oberbegriff von Klausel 1, insbesondere nach einer der vorhergehenden Klauseln,
   dadurch gekennzeichnet,
   dass die Hohlstruktur (28) außerhalb der Abtragsfront (46) durch eine Mantelfläche (57) begrenzt wird, wobei die Abtragsfront (46) beim Erzeugen der Hohlstruktur (28) unter einem Abtragsfront-Winkel (β') zu einem an die Abtragsfront (46) angrenzenden Bereich der Mantelfläche (57) der Hohlstruktur (28) ausgerichtet ist, und wobei der Abtragsfront-Winkel (β') wenigstens zeitweise größer als ein Abtragsfront-Mindestwinkel von 1° und wenigstens zeitweise kleiner als ein Abtragsfront-Maximalwinkel von 89° ist.
23. Verfahren zum Erzeugen eines Kanals (28) in einem Werkstück (25) in Form eines Substrats (25) für einen Spiegel, insbesondere für einen EUV-Spiegel (M4), wobei der Kanal (28) durch materialabtragende Bearbeitung mittels gepulster Laserstrahlung (35) erzeugt wird und beim Erzeugen des Kanals (28) eine Fluidzuführung (50) zumindest teilweise in den Kanal (28) eingeführt wird.
24. Verfahren nach Klausel 23, bei dem einem Bereich, in dem die materialabtragende Bearbeitung durchgeführt wird, insbesondere einer beim materialabtragenden Bearbeiten gebildeten Abtragsfront (46), mit Hilfe der Fluidzuführung (50) ein Fluid (32b) zugeführt wird, wobei bevorzugt beim Bewegen der Abtragsfront (46) in dem Werkstück (25) die Fluidzuführung (50) der Abtragsfront (46) insbesondere automatisiert nachgeführt wird.
25. Verfahren nachKlausel 24 oder 25, bei dem die Fluidzuführung (50) ein flexibles Element aufweist, das zumindest teilweise in den bevorzugt gekrümmten Kanal (28) eingeführt wird, wobei das flexible Element bevorzugt einen flexiblen Schlauch (52) bildet.
26. Verfahren nach einer der Klauseln 24 bis 26, bei dem der Kanal (28) mit einer Länge (L_{C}) von mindestens 10 cm, bevorzugt von mindestens 15 cm, besonders bevorzugt von mindestens 20 cm, insbesondere von mindestens 70 cm erzeugt wird.
27. Verfahren nach einer der vorhergehenden Klauseln bei dem das Substrat (28) monolithisch ist.
28. Verfahren nach einer der vorhergehenden Klauseln, bei dem das Substrat (25) aus titandotiertem Quarzglas oder aus einer Glaskeramik besteht.
29.Verfahren nach einer der vorhergehenden Klauseln, bei dem das Material des Substrats (25) eine Nulldurchgangstemperatur (T_{ZC}) aufweist, die zwischen 0°C und 100°C, bevorzugt zwischen 19°C und 40°C, besonders bevorzugt zwischen 19°C und 32°C liegt.
30. Verfahren nach einer der vorhergehenden Klauseln, bei dem das Material des Substrats (25) eine räumliche Variation der Nulldurchgangstemperatur (ΔT_{ZC}) aufweist, die bei weniger als 3 K, bevorzugt bei weniger als 2 K, besonders bevorzugt bei weniger als 1 K, insbesondere bei weniger als 0,1 K liegt.
31.Spiegel, insbesondere EUV-Spiegel (M4), umfassend:
   ein Substrat (25),
   eine auf das Substrat (25) aufgebrachte Beschichtung (26) zur Reflexion von Strahlung, insbesondere von EUV-Strahlung (16),
   wobei das Substrat (25) mindestens einen mit dem Verfahren nach einem der vorhergehenden Klauseln erzeugten Kanal (28) aufweist.
32. Spiegel, insbesondere EUV-Spiegel (M4), umfassend:
   ein Substrat (25), das mindestens einen bevorzugt mit einem Fluid (32b) durchströmbaren Kanal (28) aufweist, der durch materialabtragende Bearbeitung mittels gepulster Laserstrahlung (35) ausgebildet ist, wobei der Kanal (28) gekrümmt ausgebildet ist,
   und wobei der Kanal (28) einen Durchmesser (D) zwischen 1 mm und 20 mm, bevorzugt zwischen 1 mm und 5 mm, und/oder eine Länge (L_{C}) von mindestens 10 cm, bevorzugt von mindestens 15 cm, insbesondere von mindestens 20 cm aufweist.
33. Spiegel nach Klausel 32, bei dem das Substrat (25) monolithisch ist.
34. Spiegel nach Klausel 32 oder 33, bei dem der Kanal (28) einen ersten Abschnitt (28a, 28c) und einen zweiten, angrenzenden Abschnitt (28b) aufweist, deren Längsrichtungen (X, Z) unter einem Winkel (γ) zwischen 70° und 100°, bevorzugt unter einem Winkel (γ) von 90°, zueinander ausgerichtet sind.
35. Spiegel nach Klausel 34, bei dem der erste Abschnitt (28a, 28c) und der zweite Abschnitt (28b) an einem abgerundeten Abschnitt (28d, 28e) ineinander übergehen.
36. Spiegel, insbesondere EUV-Spiegel (M4), umfassend:
   ein bevorzugt monolithisches Substrat (125),
   eine reflektierende Beschichtung (126) zur Reflexion von Strahlung, insbesondere von EUV-Strahlung (16), die auf eine Oberfläche (125a) des bevorzugt monolithischen Substrats (125) aufgebracht ist, sowie mindestens eine Hohlstruktur (127), die in dem bevorzugt monolithischen Substrat (125) verläuft und die zur Durchströmung mit einem Fluid (128) ausgebildet ist, wobei die Hohlstruktur (127) einen ersten Abschnitt (131a, 131b; 134b, 136b) und einen zweiten, benachbarten Abschnitt (134a, 136a; 133a, 135a) aufweist, die unter einem Winkel (γ, γ') zwischen 60° und 120°, bevorzugt unter einem Winkel (γ, γ') zwischen 80° und 100°, insbesondere unter einem Winkel (γ, γ') von 90°, zueinander ausgerichtet sind, und wobei die Hohlstruktur (127) einen abgerundeten Abschnitt (137a, 137b, 138) aufweist, an dem der erste Abschnitt (131a, 131b; 134b, 136b) und der zweite Abschnitt (134a; 136a; 133a, 135a) ineinander übergehen.
37. Spiegel nach Klausel 36, bei dem ein Krümmungsradius R des abgerundeten Abschnitts (137a, 137b) und ein Durchmesser D des abgerundeten Abschnitts (137a, 137b) ein Verhältnis R / D aufweisen, das zwischen 2 und 6, bevorzugt zwischen 2,5 und 5, insbesondere zwischen 2,5 und 3,5 liegt.
38. Spiegel nach Klausel 36 oder 37, bei dem der Durchmesser D des abgerundeten Abschnitts (137a, 137b) zwischen 2 mm und 20 mm, bevorzugt zwischen 2 mm und 12 mm, liegt.
39. Spiegel nach einer der Klauseln 36 bis 38, bei dem die Hohlstruktur (127) eine Mehrzahl von Temperierkanälen (131), insbesondere in Form von Kühlkanälen, aufweist, die unterhalb der Oberfläche (125a) verlaufen, auf welche die reflektierende Beschichtung (126) aufgebracht ist, und bei dem die Hohlstruktur (127) einen über Verteilerkanäle (134) mit den Temperierkanälen (131) verbunden Fluidverteiler (133) sowie einen über Sammlerkanäle (136) mit den Temperierkanälen (131) verbundenen Fluidsammler (135) aufweist.
40. Spiegel nach Klausel 39, bei dem der erste Abschnitt einen an einen Verteilerkanal (134) angrenzenden Endabschnitt (131a) des Temperierkanals (131) bildet und der zweite Abschnitt einen an den Endabschnitt (131a) angrenzenden Verteilerkanalabschnitt (134a) bildet und/oder bei dem der erste Abschnitt einen an einen Sammlerkanal (136) angrenzenden Endabschnitt (131b) des Temperierkanals (131) bildet und bei dem der zweite Abschnitt einen an den Endabschnitt (131b) angrenzenden Sammlerkanalabschnitt (136a) bildet.
41. Spiegel nach Klausel 39 oder 40, bei dem Fluidverteiler einen Einlasskanal (133) bildet, von dem die Verteilerkanäle (134) abzweigen und/oder bei dem der Fluidsammler einen Auslasskanal (135) bildet, von dem die Sammlerkanäle (136) abzweigen.
42. Spiegel nach Klausel 41, bei dem der erste Abschnitt einen dem Einlasskanal (133) benachbarten Mündungsabschnitt (134b) des Verteilerkanals (134) bildet und bei dem der zweite Abschnitt einen dem Mündungsabschnitt (134b) benachbarten Verzweigungsabschnitt (133a) des Einlasskanals (133) bildet und/oder bei dem der erste Abschnitt einen dem Auslasskanal (135) benachbarten Mündungsabschnitt (136b) des Sammlerkanals (136) bildet und bei dem der zweite Abschnitt einen dem Mündungsabschnitt (136b) des Sammlerkanals (136) benachbarten Verzweigungsabschnitt (135a) des Auslasskanals (135) bildet.
43. Spiegel nach Klausel 42, bei dem der Winkel (γ') zwischen dem Verzweigungsabschnitt (133a) des Einlasskanals (133) und dem Mündungsabschnitt (134b) des Verteilerkanals (134) größer als 90°, bevorzugt größer als 100° ist und/oder bei dem der Winkel (γ') zwischen dem Verzweigungsabschnitt des Auslasskanals (135) und dem Mündungsabschnitt (136b) des Sammlerkanals (135) größer als 90°, bevorzugt größer als 100° ist.
44. Spiegel nach einer der Klauseln 31 bis 43, bei dem das Material des Substrats (125) ausgewählt ist aus der Gruppe umfassend: Quarzglas, insbesondere titandotiertes Quarzglas, und Glaskeramik.
45. Spiegel nach einer der Klauseln 31 bis 44, bei dem das Material des Substrats (25, 125) eine Nulldurchgangstemperatur (T_{ZC}) aufweist, die zwischen 0°C und 100°C, bevorzugt zwischen 19°C und 40°C, besonders bevorzugt zwischen 19°C und 32°C liegt.
46. Spiegel nach einer der Klauseln 31 bis 45, bei dem das Material des Substrats (25, 125) eine räumliche Variation der Nulldurchgangstemperatur (ΔT_{ZC}) aufweist, die bei weniger als 3 K, bevorzugt bei weniger als 2 K, besonders bevorzugt bei weniger als 1 K, insbesondere bei weniger als 0,1 K liegt.
47. Spiegel nach einer der Klauseln 31 bis 46, bei dem die Hohlstruktur, insbesondere in Form des Kanals (28), einen Nahtbereich (53) aufweist.
48. Spiegel nach Klausel 47, bei dem die Hohlstruktur, insbesondere in Form des Kanals (28), in dem Nahtbereich (53) eine Randkontur (54) einer Abtragsfront (46), mindestens eine Ausstülpung (55), einen lateralen Versatz (56) oder eine andere strukturelle Veränderung aufweist.
49. Spiegel, insbesondere EUV-Spiegel (M4), umfassend:
   ein Substrat (25), das mindestens einen bevorzugt mit einem Fluid (32b) durchströmbaren, insbesondere gekrümmten Kanal (28) aufweist, der einen Nahtbereich (53) aufweist.
50. Spiegel nach Klausel 49, bei dem der Kanal (28) in dem Nahtbereich (53) eine Randkontur (54) einer Abtragsfront (46), mindestens eine Ausstülpung (55), einen lateralen Versatz (56) oder eine andere strukturelle Veränderung aufweist.
51. EUV-Lithographiesystem (1), umfassend: mindestens einen EUV-Spiegel (M4) nach einer der Klauseln 31 bis 50, sowie eine Temperiereinrichtung, insbesondere eine Kühleinrichtung (32), die zum Durchströmen der mindestens einen Hohlstruktur (127), insbesondere in Form eines Kanals (28), mit einem Temperierfluid, insbesondere mit einem Kühlfluid (32a, 128), ausgebildet ist.
52. Vorrichtung (33) zum Erzeugen mindestens eines Kanals (28) in einem Werkstück (25) in Form eines Substrats (25) für einen Spiegel, insbesondere für einen EUV-Spiegel (M4), umfassend:
   eine Laserquelle (34) zur Erzeugung von gepulster Laserstrahlung (35),
   eine Fokussiereinrichtung (37) zur Fokussierung der Laserstrahlung (35) in einem Fokusbereich (39),
   eine Halterung (44) zur Aufnahme des Werkstücks (25),
   eine Scanneroptik (36), die zur Einstrahlung der gepulsten Laserstrahlung (35) auf eine Strahlungseintrittsseite (27) des von der Halterung (44) aufgenommenen Werkstücks (25) und zum Bewegen des Fokusbereichs (39) ausgebildet ist, dadurch gekennzeichnet,
   dass die Vorrichtung (33) eine Fluidzuführung aufweist (50), die zumindest teilweise in den Kanal (28) einführbar ist.
53.Vorrichtung nach Klausel 52, bei der die Fluidzuführung (50) ausgebildet ist, einem Bereich, in dem die materialabtragende Bearbeitung durchgeführt wird, insbesondere einer beim materialabtragenden Bearbeiten gebildeten Abtragsfront (46), ein Fluid (32b) zuzuführen, wobei die Fluidzuführung (50) bevorzugt der Abtragsfront (46) bei der Bewegung in dem Werkstück (25) nachführbar ist.
54. Vorrichtung nach einer der Klauseln 52 oder 53, bei dem die Fluidzuführung (50) ausgebildet ist, ein flexibles Element, insbesondere einen flexiblen Schlauch (52), zumindest teilweise in den Kanal (28) einzuführen.
55. Vorrichtung nach einer der Klauseln 52 bis 54, bei der die Scanneroptik (36) zum Bewegen des Fokusbereichs (39) entlang eines Bewegungsmusters (41) ausgebildet ist, um eine Abtragsfront (46) zum flächigen Abtrag von Material des Werkstücks (25) zu bilden, wobei die Vorrichtung (33) zum Bilden einer Abtragsfront (46) ausgebildet ist, die nicht senkrecht zu einer Einstrahlungsrichtung (Z) der gepulsten Laserstrahlung (35) auf das von der Halterung (44) aufgenommene Werkstück (25) ausgerichtet ist.
56. Vorrichtung nach Klauseln 55, weiter umfassend: eine Fokusversatz-Einrichtung (47) zum Versetzen des Fokusbereichs (39) der gepulsten Laserstrahlung (35) entlang der Einstrahlungsrichtung (Z), sowie eine Steuerungseinrichtung (48), die ausgebildet ist, die Fokusversatz-Einrichtung (47) anzusteuern, zur Bildung der nicht senkrecht zur Einstrahlungsrichtung (Z) ausgerichteten Abtragsfront (46) Bewegungsbahnen (42) des Bewegungsmusters (41) entlang der Einstrahlungsrichtung (Z) zueinander zu versetzen.
57. Vorrichtung nach einer der Klauseln 55 oder 56, weiter umfassend: eine Steuerungseinrichtung (48), die ausgebildet ist, die Laserquelle (34) anzusteuern, eine Pulsenergie (E_{P}) der gepulsten Laserstrahlung (35) von zueinander versetzten Bewegungsbahnen (42) des Bewegungsmusters (41) zu verändern, um die nicht senkrecht zur Einstrahlungsrichtung (Z) ausgerichtete Abtragsfront (46) zu bilden.
58. Vorrichtung nach einer der Klauseln 52 bis 57, weiter umfassend: eine Positioniereinrichtung (43) zum Bewegen der Abtragsfront (46) innerhalb des Werkstücks (25), bevorzugt ausgehend von einer der Strahlungseintrittsseite (27) gegenüberliegenden Seite (29) des Werkstücks (25), zum Erzeugen des Kanals (28), wobei die Positioniereinrichtung (43) zur Verschiebung des Werkstücks (25) entlang der Einstrahlungsrichtung (Z) und bevorzugt entlang von mindestens einer Richtung (X, Y) quer zur Einstrahlungsrichtung (Z) ausgebildet ist.
59. Fluidzuführungsvorrichtung (238) zum Zuführen eines Fluids (228) zu mindestens einer Abtragsfront (230a, 230b) beim Abtragen von Material durch Laserablation von einem Werkstück, bevorzugt von einem insbesondere monolithischen Substrat (225) für einen EUV-Spiegel (M4), umfassend:
   mindestens eine flexible Fluidleitung (241), bevorzugt eine Mehrzahl von flexiblen Fluidleitungen (241), zum Zuführen des Fluids (228) zu der mindestens einen Abtragsfront (230a, 230b), sowie
   mindestens ein Einlegebauteil (239, 240) zum Einlegen in einen Hohlraum (233, 235) des Werkstücks (225), wobei das Einlegebauteil (239, 240) mindestens einen Führungskanal (247) aufweist, in dem die mindestens eine flexible Fluidleitung (241) geführt ist, um das Fluid (228) der mindestens einen Abtragsfront (230a, 230b) zuzuführen.
60. Fluidzuführungsvorrichtung nach Klausel 59, bei der das Einlegebauteil (239, 240) eine Mehrzahl von Führungskanälen (247) aufweist, in denen jeweils eine flexible Fluidleitung (241) geführt ist.
61. Fluidzuführungsvorrichtung nach Klausel 59 oder 60, bei dem zwischen der Fluidleitung (241) und einer Kanalwand (247a) des Führungskanals (247) ein durchströmbarer Spalt, insbesondere ein Ringspalt (249), zur Rückführung des Fluids (228) von der Abtragsfront (230a, 230b) gebildet ist.
62. Fluidzuführungsvorrichtung nach einer der Klauseln 59 bis 61, bei welcher der Führungskanal (247) mindestens einen abgerundeten Abschnitt (250) zur Richtungsänderung der flexiblen Fluidleitung (241) aufweist.
63. Fluidzuführungsvorrichtung nach einer der Klauseln 59 bis 62, bei der das Einlegebauteil (239, 240) stabförmig ist und der Führungskanal (247) sich von einer Stirnseite (248) des Einlegebauteils (239) zu einer Mantelfläche (245) des Einlegebauteils (239) erstreckt.
64. Fluidzuführungsvorrichtung nach Klauseln 63, bei welcher die Führungskanäle (241) an der Mantelfläche (245) des Einlegebauteils (239) in Öffnungen (246) münden, die bevorzugt in Längsrichtung (Y) des Einlegebauteils (239) nebeneinander angeordnet sind und die insbesondere in Längsrichtung (Y) des Einlegebauteils (239) in gleichen Abständen (A") voneinander angeordnet sind.
65. Fluidzuführungsvorrichtung nach Klausel 63 oder 64, bei der das stabförmige Einlegebauteil (239) zylindrisch ausgebildet ist und bevorzugt einen Durchmesser (D') zwischen 5 mm und 10 mm aufweist.
66. Fluidzuführungsvorrichtung nach einer der Klauseln 60 bis 65, bei welcher der Führungskanal (247) einen Durchmesser (d) zwischen 1 mm und 4 mm aufweist.
67. Fluidzuführungsvorrichtung nach einer der Klauseln 59 bis 66, bei welcher die mindestens eine Fluidleitung (241) einen Außendurchmesser (F) von 1 mm oder weniger aufweist.
68. Fluidzuführungsvorrichtung nach einer der Klauseln 59 bis 67, weiter umfassend: eine Fluidbereitstellungseinrichtung (243) zur Zuführung des Fluids (228) zu der mindestens einen flexiblen Fluidleitung (241).
69. Fluidzuführungsvorrichtung nach einer der Klauseln 59 bis 68, weiter umfassend: mindestens eine Nachführungseinrichtung (244) zur automatisierten Nachführung der mindestens einen flexiblen Fluidleitung (241) bei einer Bewegung der Abtragsfront (230a, 230b) im Material des Werkstücks (225).
70.Verfahren zum Zuführen eines Fluids (228) zu mindestens einer Abtragsfront (230a, 230b) beim Abtragen von Material durch Laserablation von einem Werkstück, insbesondere von einem bevorzugt monolithischen Substrat (225) für einen EUV-Spiegel (M4), mittels einer Fluidzuführungsvorrichtung (238) nach einer der Klauseln 54 bis 64, umfassend:
   Einlegen des Einlegebauteils (239, 240) in einen Hohlraum (233, 235) des Werkstücks (225), sowie
   Zuführen des Fluids (228) zu der mindestens einen Abtragsfront (230a, 230b) durch die mindestens eine flexible Fluidleitung (241), die in dem mindestens einen Führungskanal (247) des Einlegebauteils (239, 240) geführt ist.
71. Verfahren nach Klausel 70, bei dem vor dem Einlegen des Einlegebauteils (239, 240) der Hohlraum (233, 235) mit einem Fluid (228) gefüllt wird und ausgehend von dem mit dem Fluid (228) gefüllten Hohlraum (233, 235) durch Laserablation eine Mehrzahl von an den Hohlraum (233, 235) angrenzenden Kanalabschnitten (237) gebildet wird.
72. Verfahren nach Klausel 71, bei dem nach dem Einlegen des Einlegebauteils (239, 240) in den Hohlraum (233, 235) ausgehend von den Kanalabschnitten (237) eine Mehrzahl von Abtragsfronten (230a, 230b) erzeugt und im Material des Werkstücks (225) bewegt werden, um eine Mehrzahl von Kanälen (231, 234, 235) zu bilden, wobei die Mehrzahl der flexiblen Fluidleitungen (241) bei der Bewegung der Abtragsfronten (230a, 230b) im Material des Werkstücks (225) nachgeführt werden.

## Patentansprüche

1. Verfahren zum Erzeugen einer Hohlstruktur (28) in einem Werkstück (25), in Form eines Substrats für einen Spiegel, insbesondere für einen EUV-Spiegel (M4), durch materialabtragende Bearbeitung mittels gepulster Laserstrahlung (35), umfassend:
Einstrahlen der gepulsten Laserstrahlung (35) von einer Strahlungseintrittsseite (27) in das Werkstück (25), das aus einem für die gepulste Laserstrahlung (35) transparenten Material gebildet ist,
Fokussieren der gepulsten Laserstrahlung (35) in einem Fokusbereich (39), Bilden einer Abtragsfront (46) zum flächigen Abtrag von Material des Werkstücks (25) durch Bewegen des Fokusbereichs (35) entlang eines Bewegungsmusters (41), sowie
Erzeugen der Hohlstruktur (28) durch Bewegen der Abtragsfront (46) innerhalb des Werkstücks (25),
**dadurch gekennzeichnet,**
**dass** beim Erzeugen der Hohlstruktur (28) zumindest zeitweise eine Abtragsfront (46) gebildet wird, die nicht senkrecht zu einer Einstrahlungsrichtung (Z) der gepulsten Laserstrahlung (35) auf die Strahlungseintrittsseite (27) des Werkstücks (25) ausgerichtet ist und dass die Hohlstruktur (28) in Form eines mit einem Fluid (32a) durchströmbaren Kanals (28) erzeugt wird.

2. Verfahren nach Anspruch 1, bei dem die Hohlstruktur in Form eines mit einem Fluid (32a) durchströmbaren gekrümmten Kanals (28) erzeugt wird.

3. Verfahren nach Anspruch 1 oder 2, bei dem die gepulste Laserstrahlung (35) im Bereich der Abtragsfront (46) erstmalig aus dem Material des Werkstücks (25) austritt, wobei bevorzugt die gepulste Laserstrahlung (35) nach dem Austritt aus dem Material des Werkstücks (25) erneut in das Material des Werkstücks (25) eintritt.

4. Verfahren nach einem der vorhergehenden Ansprüche, bei dem die Abtragsfront (46) innerhalb des Werkstücks (25) zumindest zeitweise in Richtung auf die Strahlungseintrittsseite (27) des Werkstücks (25) bewegt wird.

5. Verfahren nach einem der vorhergehenden Ansprüche, bei dem beim Bewegen der Abtragsfront (46) innerhalb des Werkstücks (25) zumindest zeitweise an einer der Strahlungseintrittsseite (27) des Werkstücks (25) abgewandten Seite (46c) eines der Strahlungseintrittsseite (27) des Werkstücks (25) abgewandten Randes (46b) der Abtragsfront (46) Material des Werkstücks (25) angrenzt.

6. Verfahren nach einem der vorhergehenden Ansprüche, bei dem die Abtragsfront (46) ausgehend von einer der Strahlungseintrittsseite (27) gegenüberliegenden Seite (29) des Werkstücks (25) bewegt wird.

7. Verfahren nach einem der vorhergehenden Ansprüche, bei dem zumindest zeitweise eine Abtragsfront (46) gebildet wird, die unter einem Winkel (α) zwischen 20° und 70°, bevorzugt zwischen 30° und 60°zur Einstrahlungsrichtung (Z) ausgerichtet ist.

8. Verfahren nach einem der vorhergehenden Ansprüche, bei dem das Bewegen des Fokusbereichs (35) entlang von zueinander versetzten Bewegungsbahnen (42) des Bewegungsmusters (41) erfolgt.

9. Verfahren nach Anspruch 9, bei dem zum Bilden der nicht senkrecht zur Einstrahlungsrichtung (Z) ausgerichteten Abtragsfront (46) die Bewegungsbahnen (42) des Bewegungsmusters (41) entlang der Einstrahlungsrichtung (Z) zueinander versetzt werden, indem der Fokusbereich (39) entlang der Einstrahlungsrichtung (Z) versetzt wird.

10. Verfahren nach Anspruch 9 oder 10, bei dem zum Bilden der nicht senkrecht zur Einstrahlungsrichtung (Z) ausgerichteten Abtragsfront (46) eine Pulsenergie (E_{P}) der gepulsten Laserstrahlung (35) der zueinander versetzten Bewegungsbahnen (42) des Bewegungsmusters (41) verändert wird, wobei bevorzugt der Fokusbereich (39) in einer Ebene (FE) senkrecht zur Einstrahlungsrichtung (Z) bewegt wird.

11. Verfahren nach einem der vorhergehenden Ansprüche, bei dem beim Erzeugen der Hohlstruktur (28) die Abtragsfront (46) zumindest zeitweise in einer Bewegungsrichtung (-X) quer zur Einstrahlungsrichtung (Z) innerhalb des Werkstücks bewegt wird, um einen Abschnitt (28b) der Hohlstruktur (28) zu bilden, der bevorzugt im Wesentlichen parallel zur Strahlungseintrittsseite (27) verläuft, wobei die Abtragsfront (46) bei der Bewegung quer zur Einstrahlungsrichtung (Z) bevorzugt an ihrem der Strahlungseintrittsseite (27) zugewandten Rand (46a) unter einem Winkel (β) von weniger als 90°, bevorzugt von weniger als 70°, zur Bewegungsrichtung (-X) ausgerichtet ist.

12. Verfahren nach einem der vorhergehenden Ansprüche, bei dem die Abtragsfront (46) beim Erzeugen der Hohlstruktur (28) zumindest zeitweise im Wesentlichen parallel zur Einstrahlungsrichtung (Z) bewegt wird, um ausgehend von der der Strahlungseintrittsseite (27) gegenüberliegenden Seite (29) des Werkstücks (25) einen Abschnitt (28a) der Hohlstruktur (28) zu erzeugen, der im Wesentlichen parallel zur Einstrahlungsrichtung (Z) verläuft, sowie bevorzugt um einen weiteren Abschnitt (28c) der Hohlstruktur (28) zu erzeugen, der im Wesentlichen parallel zur Einstrahlungsrichtung (Z) verläuft.

13. Verfahren nach einem der vorhergehenden Ansprüche, bei dem ein erster Abschnitt (28a, 28c) der Hohlstruktur (28) und ein zweiter, angrenzender Abschnitt (28b) der Hohlstruktur (28) erzeugt werden, deren Längsrichtungen (X, Z) unter einem Winkel (γ) zwischen 70° und 100°, bevorzugt unter einem Winkel (γ) von 90°, zueinander ausgerichtet sind, wobei bevorzugt beim Erzeugen der Hohlstruktur (28) ein abgerundeter Abschnitt (28d, 28e) gebildet wird, an dem der erste Abschnitt (28a, 28c) und der zweite Abschnitt (28b) ineinander übergehen.

14. Verfahren nach einem der vorhergehenden Ansprüche, bei dem die Abtragsfront (46) beim Erzeugen der Hohlstruktur (28) in Kontakt mit einem Fluid (32b) gebracht wird, wobei bei der Bewegung der Abtragsfront (46) das Fluid (32b) der Abtragsfront (46) mittels einer Fluidzuführung (50) nachgeführt wird, die zumindest teilweise in die Hohlstruktur (28) eingeführt wird, wobei die Fluidzuführung (50) bevorzugt mindestens einen flexiblen Schlauch (52) aufweist und das Fluid (32b) der Abtragsfront (46) mittels des mindestens einen flexiblen Schlauchs (52) insbesondere ausgehend von einer der Strahlungseintrittsseite (27) abgewandten Seite (29) des Werkstücks (25) nachgeführt wird.

15. Verfahren nach einem der vorhergehenden Ansprüche, bei dem zum Bewegen der Abtragsfront (46) das Werkstück verschoben wird und/oder bei dem zum Bilden der Abtragsfront (46) der Fokusbereich (39) mittels einer Scanneroptik (36) entlang von zueinander versetzten Bewegungsbahnen (42) des Bewegungsmusters (41) bewegt wird.

16. Verfahren nach einem der vorhergehenden Ansprüche, bei dem die Hohlstruktur einen runden Querschnitt mit einem Durchmesser (D) zwischen 1 mm und 20 mm, bevorzugt zwischen 1 mm und 5 mm, aufweist und/oder bei dem die Hohlstruktur eine Länge (L_{C}) von mindestens 10 cm, bevorzugt von mindestens 15 cm, besonders bevorzugt von mindestens 20 cm, insbesondere von mindestens 70 cm aufweist.

17. Verfahren nach dem Oberbegriff von Anspruch 1, insbesondere nach einem der vorhergehenden Ansprüche,
**dadurch gekennzeichnet,**
**dass** die Hohlstruktur (28) außerhalb der Abtragsfront (46) durch eine Mantelfläche (57) begrenzt wird, wobei die Abtragsfront (46) beim Erzeugen der Hohlstruktur (28) unter einem Abtragsfront-Winkel (β') zu einem an die Abtragsfront (46) angrenzenden Bereich der Mantelfläche (57) der Hohlstruktur (28) ausgerichtet ist, und wobei der Abtragsfront-Winkel (β') wenigstens zeitweise größer als ein Abtragsfront-Mindestwinkel von 1° und wenigstens zeitweise kleiner als ein Abtragsfront-Maximalwinkel von 89° ist.

18. Verfahren nach einem der vorhergehenden Ansprüche, bei dem das Substrat (28) monolithisch ist und/oder bei dem das Substrat (25) aus titandotiertem Quarzglas oder aus einer Glaskeramik besteht.

19. Verfahren nach einem der vorhergehenden Ansprüche, bei dem das Material des Substrats (25) eine Nulldurchgangstemperatur (T_{ZC}) aufweist, die zwischen 0°C und 100°C, bevorzugt zwischen 19°C und 40°C, besonders bevorzugt zwischen 19°C und 32°C liegt und/oder bei dem das Material des Substrats (25) eine räumliche Variation der Nulldurchgangstemperatur (ΔT_{ZC}) aufweist, die bei weniger als 3 K, bevorzugt bei weniger als 2 K, besonders bevorzugt bei weniger als 1 K, insbesondere bei weniger als 0,1 K liegt.

20. Spiegel, insbesondere EUV-Spiegel (M4), umfassend:
ein Substrat (25),
eine auf das Substrat (25) aufgebrachte Beschichtung (26) zur Reflexion von Strahlung, insbesondere von EUV-Strahlung (16),
wobei das Substrat (25) mindestens einen mit dem Verfahren nach einem der vorhergehenden Ansprüche erzeugten Kanal (28) aufweist.

21. EUV-Lithographiesystem (1), umfassend: mindestens einen EUV-Spiegel (M4) nach Anspruch 20, sowie eine Temperiereinrichtung, insbesondere eine Kühleinrichtung (32), die zum Durchströmen der mindestens einen Hohlstruktur (127), insbesondere in Form eines Kanals (28), mit einem Temperierfluid, insbesondere mit einem Kühlfluid (32a, 128), ausgebildet ist.
